(19) Europäisches Patentamt / European Patent Office / Office européen des brevets

(11) **EP 1 626 309 B1**

(12) **EUROPEAN PATENT SPECIFICATION**

(45) Date of publication and mention of the grant of the patent:
**27.07.2011 Bulletin 2011/30**

(51) Int Cl.:
*G03F 7/00* (2006.01)

(21) Application number: **05251874.3**

(22) Date of filing: **24.03.2005**

(54) **Hologram recording material, hologram recording method and holographic optical element**

Hologrammaufzeichnungsmaterial, Hologrammaufzeichnungsverfahren und holographisches optisches Element

Matériau pour l'enregistrement de hologrammes, méthode pour l'enregistrement de hologrammes et élément optique holographique

(84) Designated Contracting States:
**DE FR GB**

(30) Priority: **25.03.2004 JP 2004088790**
**13.09.2004 JP 2004265371**

(43) Date of publication of application:
**15.02.2006 Bulletin 2006/07**

(73) Proprietor: **FUJIFILM Corporation**
**Minato-ku**
**Tokyo (JP)**

(72) Inventors:
- **Takizawa, Hiroo**
  **Minami-Ashigara-shi**
  **Kanagawa (JP)**
- **Inoue, Noriko**
  **Odawara-shi**
  **Kanagawa (JP)**

(74) Representative: **Matthews, Derek Peter**
**Dehns**
**St Bride's House**
**10 Salisbury Square**
**London**
**EC4Y 8JD (GB)**

(56) References cited:
**EP-A- 0 339 841** **EP-A- 1 350 814**
**US-A- 3 707 371** **US-A- 5 858 614**
**US-A1- 2003 083 395** **US-A1- 2003 152 842**
**US-A1- 2003 156 524**

- **YAO H ET AL: "Optimization of two-monomer-based photopolymer used for holographic recording" MATERIALS LETTERS, NORTH HOLLAND PUBLISHING COMPANY. AMSTERDAM, NL, vol. 56, no. 1-2, September 2002 (2002-09), pages 3-8, XP004382460 ISSN: 0167-577X**
- **CHAPUT F ET AL: "PHOTOCHROMIC SOL-GEL FILMS CONTAINING DITHIENYLETHENE AND AZOBENZENE DERIVATIVES: FROM THE DESIGN OF OPTICAL COMPONENTS TO THE OPTICAL DATA STORAGE" MOLECULAR CRYSTALS AND LIQUID CRYSTALS SCIENCE AND TECHNOLOGY. SECTION A. MOLECULAR CRYSTALS AND LIQUID CRYSTALS, GORDON AND BREACH PUBLISHERS, CH, CH, vol. 344, 14 November 1999 (1999-11-14), pages 77-82, XP008002411 ISSN: 1058-725X**
- **AKELLA A ET AL: "HOLOGRAPHIC RECORDING. SYNTHESIS AND CHARACTERIZATION OF PHOTOCHROMIC ORGANIC FILMS FOR" OPTICS LETTERS, OSA, OPTICAL SOCIETY OF AMERICA, WASHINGTON, DC, US, vol. 22, no. 12, 15 June 1997 (1997-06-15), pages 919-921, XP000658729 ISSN: 0146-9592**
- **DUBOIS: "Characterization of a Preliminary Narrow-Band Absorption Material for Holographic Data Storage", SPIE, PO BOX 10 BELLINGHAM WA 98227-0010 USA, vol. 5380, 2004, pages 589-596, XP040182987, DOI: 10.1117/12.556985**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 1 626 309 B1

## Description

## Background of the Invention

### 1. Field of the Invention

The present invention relates to a hologram recording material and hologram recording method which can be applied to high density optical recording medium, three-dimensional display, holographic optical element, etc.

### 2. Description of the Related Art

The general principle of preparation of hologram is described in some literatures and technical books, e.g., Junpei Tsujiuchi, "Holographic Display", Sangyo Tosho, Chapter 2. In accordance with these literatures and technical books, a recording object is irradiated with one of two fluxes of coherent laser beams and a photosensitive hologram recording material is disposed in a position such that all the light beams reflected by the recording object can be received. Besides the light beam reflected by the recording object, the other coherent light beam is incident on the hologram recording material without hitting the object. The light beam reflected by the object is called object light. The light beam with which the recording material is directly irradiated is called reference light. The band of interference of reference light with object light is then recorded as image data. Subsequently, when the hologram recording material thus processed is irradiated with the same light beam (reproducing light beam) as the reference light, the hologram performs diffraction in such a manner that the wave front of the first reflected light which has reached the recording material from the object during recording is reproduced. As a result, substantially the same object image as the real image of the object can be three-dimensionally observed.

The hologram formed by allowing reference light beam and object light beam to be incident on the hologram recording material in the same direction is called transmission hologram. The interference band is formed in the direction perpendicular or substantially perpendicular to the surface of the recording material at an interval of from about 1,000 to 3,000 lines per mm.

On the other hand, the hologram formed by allowing reference light beam and object light beam to be incident on the hologram recording material in opposite directions is normally called reflection hologram. The interference band is formed in the direction parallel to or substantially parallel to the surface of the recording material at an interval of from about 3,000 to 7,000 lines per mm.

The transmission hologram can be prepared by any known method as disclosed in JP-A-6-43634. The reflection hologram can be prepared by any known method as disclosed in JP-A-2-3082, JP-A-3-50588, etc.

On the other hand, the hologram having a sufficiently thick layer relative to the interval of interference band (normally five times or more the interval of interference band or about 1 $\mu$m or more) is called volume hologram.

On the contrary, the hologram having a layer thickness which is five times or less the interval of interference band or about 1 $\mu$m or less is called plane or surface hologram.

Further, the hologram involving the absorption by dye or silver causing the recording of an interference band is called amplified hologram. The hologram involving recording by surface relief or refractive index modulation is called phase hologram. The amplified hologram is subject to drastic drop of light diffraction efficiency or reflectance due to absorption of light and thus is disadvantageous in percent utilization of light. In general, the phase hologram is preferably used.

In accordance with the volume phase type hologram, many interference bands having different refractive indexes are formed in the hologram recording material without by making optical absorption, making it possible to modulate the phase of light without absorbing light.

In particular, the reflection volume phase type hologram is also called Lipman type hologram. In accordance with the reflection volume phase type hologram, wavelength-selective reflection involving Bragg diffraction allows the formation of full-color image, reproduction of white color and enhancement of resolution at a high diffraction efficiency, making it possible to provide a high resolution full-color three-dimensional display.

In recent years, hologram has been put into practical use in the art of holographic optical element (HOE) such as headup display (HUD) to be mounted on automobile, pickup lens for optical disc, head mount display, color filter for liquid crystal and reflection type liquid crystal reflector by making the use of its wavelength-selective reflectivity.

Studies have been made also on the practical use or application of hologram to lens, diffraction grating, interference filter, connector for optical fiber, light polarizer for facsimile, window glass for building, etc.

In the recent tend for highly informative society, networks such as internet and highvision TV have bee rapidly spread. Further, with the operation of HDTV (high definition television) close at hand, there has been a growing demand for high density recording medium for simply recording image data having a capacity of 100 GB or more at reduced cost also in consumers' use.

In the trend for enhancement of computer capacity, an ultrahigh density recording medium capable of recording data having a capacity of about 1 TB or more at a high rate and reduced cost has been desired also in business uses such as computer backup and broadcast backup.

Under these circumstances, replaceable and random-accessible small-sized inexpensive optical recording media have been noted more than ever relative to magnetic tapes, which are not random-accessible, and hard discs, which are not replaceable and are subject to failure. Speaking from the standpoint of physical principle, however, existing two-dimensional optical recording media such as DVD-R allow recording of 25 GB data at greatest per one side even if the wavelength of the recording light beam is reduced. Thus, these two-dimensional recording media cannot be expected to have a recording capacity great enough to meet the future demand.

Then, three-dimensional optical recording media which perform recording in the thickness direction have been recently noted as ultimate ultrahigh density recording media. Effective methods for this system include method involving the use of two-photon absorbing material and method involving the use of holography (interference). Therefore, volume phase type hologram recording materials have recently been suddenly noted as three-dimensional optical recording media (holographic memory).

In operation, the holographic memory comprising a volume phase type hologram recording material records many two-dimensional digital data (called signal light) using a spatial light modulation element (SLM) such as Digital Micromirror Device (DMD) and LCD instead of object light reflected by the three-dimensional object. Since the recording involves multiplexed recording such as angle-multiplexed recording, phase-multiplexed recording, wavelength- multiplexed recording and shift-multiplexed recording, a capacity as high as up to 1 TB can be attained. Further, reading is normally accomplished by the use of CCD, CMOS or the like. These elements allow parallel writing/reading, making it possible to raise the transfer rate up to 1 Gbps.

However, the hologram recording materials to be used in holographic memory have severer requirements than for the three-dimensional display and HOE as follows.

(1) To have a high sensitivity.
(2) To have a high resolution.
(3) To have a high hologram diffraction efficiency.
(4) To use a fast dry processing during recording.
(5) To allow multiplexed recording (broad dynamic range).
(6) To have a small shrinkage after recording.
(7) To have good hologram storage properties.

In particular, the requirements (1) (To have a high sensitivity), (3) (To have a high hologram diffraction efficiency), (4) (To use a fast dry processing during recording), (6) (To have a small shrinkage after recording) and (7) (To have good hologram storage properties) are chemically opposing properties. It is very difficult to meet these requirements at the same time.

Examples of known volume phase type hologram recording materials include write-once-read-many type hologram recording materials such as gelatin bichromate process hologram recording material, bleached silver halide process hologram recording material and photopolymer process hologram recording material and rewritable type hologram recording materials such as photorefractive process hologram recording material and photochromic polymer process hologram recording material.

However, none of these known volume phase type hologram recording materials cannot meet all these requirements particularly when used as high sensitivity optical recording medium. Thus, these known volume phase type hologram recording materials leave something to be desired.

In some detail, the gelatin bichromate process hologram recording material is advantageous in that it has a high diffraction efficiency and a low noise but is disadvantageous in that it has extremely poor storage properties, requires wet processing and exhibits a low sensitivity. Thus, the gelatin bichromate process hologram recording material is not suitable for holographic memory.

The bleached silver halide process hologram recording material is advantageous in that it has a high sensitivity but is disadvantageous in that it requires wet processing and troublesome bleaching process, causes great scattering and has a poor light-resistance. Thus, the bleached silver halide process hologram recording material, too, is not suitable for holographic memory.

The photorefractive hologram recording material is advantageous in that it is rewritable but is disadvantageous in that it requires the application of a high electric field during recording and has poor record storage properties.

The photochromic polymer process hologram recording material such as azobenzene polymer process hologram recording material is advantageous in that it is rewritable but is disadvantageous in that it has an extremely low sensitivity and poor record storage properties. For example, WO9744365A1 proposes a rewritable hologram recording material utilizing the refractive anisotropy and ortientation control of azobenzene polymer (photochromic polymer). However, this type of a rewritable hologram recording material is disadvantageous in that since the quantum yield of isomerization of azobenzene is low and this process involves orientation change, the sensitivity is extremely low. This type of a rewritable hologram recording material is also disadvantageous in that it has poor record storage properties, which are contrary to rewritability. Thus, this type of a rewritable hologram recording material cannot be put into practical use.

Under these circumstances, the dry-processed photopolymer process hologram recording material disclosed in the above cited JP-A-6-43634, JP-A-2-3082 and JP-A-3-50588 has the following arrangement. In other words, the dry-processed photopolymer process hologram recording material is essentially composed of a binder, a radical-polymerizable monomer and a photopolymerization initiator. In order to enhance refractive index modulation, one of the binder and the radical-polymerizable monomer comprises a compound having an aromatic ring, chlorine or bromine incorporated therein to make a difference in refractive index therebetween. In this arrangement, the hologram exposure causes the progress of polymerization with the monomer and the binder gathering at the bright area and the dark area of the interference band thus formed, making it possible to form a refractive index difference. Thus, it can be said that the dry-processed photopolymer process hologram recording material is a relatively practical hologram recording material which can attain a high diffraction efficiency and dry processing properties at the same time.

However, the dry-processed photopolymer process hologram recording material is disadvantageous in that it has a sensitivity of about one thousandth of that of the bleached silver halide process hologram recording material, requires a heat-fixing step for about 2 hours to enhance diffraction efficiency, requires radical polymerization causing the effect of polymerization inhibition by oxygen and is subject to shrinkage after exposure and fixing and hence change of diffraction wavelength and angle during reproduction. Further, the dry-processed photopolymer process hologram recording material is in the form of soft membrane and lacks storage properties. Accordingly, the dry-processed photopolymer process hologram recording material can be by no means used for holographic memory.

In general, as opposed to radical polymerization, cationic polymerization, particularly cationic polymerization involving the ring opening of an epoxy compound, etc., causes little shrinkage after polymerization and no polymerization inhibition by oxygen. As a result, a rigid membrane can be given. It is also pointed out that cationic polymerization is more suitable for holographic memory than radical polymerization.

For example, JP-A-5-107999 and JP-A-8-16078 disclose a hologram recording material comprising in combination a cationically-polymerizable compound (monomer or oligomer) instead of binder and a sensitizing dye, a radical polymerization initiator, a cationic polymerization initiator and a radical-polymerizable compound.

Further, JP-T-2001-523842 and JP-T-11-512847 disclose a hologram recording material comprising only a sensitizing dye, a cationic polymerization initiator, a cationically-polymerizable compound and a binder but free from radical polymerization.

The aforementioned cationic polymerization process hologram recording material shows some improvement in shrinkage resistance as compared with the radical polymerization process hologram recording material but has a lowered sensitivity as opposed to the improvement. It is thought that this disadvantage gives a great problem in transfer rate during practical use. Further, the cationic polymerization process hologram recording material exhibits a reduced diffraction efficiency that probably gives a great problem in S/N ratio and multiplexed recording properties.

As previously mentioned, the photopolymer process hologram recording method involves the movement of materials. This causes a dilemma. In some detail, when the hologram recording material to be applied to holographic memory is arranged to have better storage properties and shrinkage resistance, the resulting sensitivity is lowered (cationic polymerization process hologram recording material). On the contrary, when the hologram recording material is arranged to have an enhanced sensitivity, the resulting storage properties and shrinkage resistance are deteriorated (radical polymerization process hologram recording material). In order to enhance the recording density of holographic memory, it is essential that multiplexed recording involving more than 50 times, preferably 100 times or more recording jobs be effected. However, since the photopolymer process hologram recording material employs polymerization process involving the movement of materials to perform recording, the recording speed in the latter half of multiplexed recording process, in which most of the compound has been polymerized, is reduced as compared with that in the initial stage of multiplexed recording process. Accordingly, exposure must be adjusted and a broad dynamic range must be used to control the recording speed. This gives a practically great problem.

The dilemma caused by the requirements for higher sensitivity, better storage properties and dry processing properties and the problem of multiplexed recording properties cannot be avoided from the physical standpoint of view so far as the related art photopolymer process hologram recording material is used. It is also difficult for the silver halide process recording material in principle from the standpoint of dry processing properties to meet the requirements for holographic memory.

In order to apply a hologram recording material to holographic memory, it has been keenly desired to develop quite a new recording system which can give essential solution to these problems, particularly one which can attain higher sensitivity, lower shrinkage, better storage properties, dry processing properties and multiplexed recording properties at the same time.

## Summary of the Invention

It is thus an aim of the invention to provide a hologram recording material and hologram recording method which can be applied to high density optical recording medium, three-dimensional display, holographic optical element, etc. and-can attain a high sensitivity, high diffraction efficiency, good storage properties, low shrinkage factor, dry processing properties and multiplexed recording properties at the same time.

As a result of the inventors' extensive studies, the aim of the invention was accomplished by the following means.

(1) A hologram recording method using at least one discolorable dye, a sensitizing dye and a discoloring agent precursor in which, when subjected to hologram exposure, at least one of the sensitizing dye and the discolorable dye generates an excited state which then undergoes energy or electron transfer with the discoloring agent precursor to cause the discoloring agent precursor to generate a discoloring agent which discolors the discolorable dye, thereby forming an interference band due to refractive index modulation, characterised in that in a first step, the sensitizing dye absorbs light during hologram exposure to generate an excited state which then undergoes energy transfer or electron transfer with the discoloring agent precursor to cause the discoloring agent precursor to generate a discoloring agent which discolors the discolorable dye, whereby the discolored dye and the discolorable dye left undiscolored form a latent image, and in a second step, the discolorable dye left undiscolored is irradiated with light having a wavelength different from that used for hologram exposure to cause energy transfer or electron transfer by which a polymerization initiator is activated to cause a polymerization by which the interference band is recorded as a refractive index modulation.

(2) A hologram recording material for use in the hologram recording method as defined in clause 1.

(3) A hologram recording material for use in the hologram recording method as defined in clause 1 which comprises:

1) a sensitizing dye which absorbs light during hologram exposure in the first step to generate an excited state;

2) a discoloring agent precursor capable of performing electron transfer or energy transfer with the excited state of the sensitizing dye to generate a discoloring agent;

3) a discolorable dye having a molar absorptivity of 1,000 or less capable of undergoing discoloration by the discoloring agent;

4) a polymerization initiator capable of performing electron transfer or energy transfer with an excited state of the remaining discolorable dye to initiate the polymerization of a polymerizable compound in the second step;

5) a polymerizable compound; and

6) a binder.

(4) The hologram recording material as defined in clause 3, wherein the polymerizable compound and the binder have different refractive indexes and the photopolymerization makes the composition ratio of polymerizable compound and its polymerization product to binder different between bright interference areas and dark interference areas, allowing recording of the interference band by the refractive index modulation.

(5) The hologram recording material as defined in clause 2, wherein any multiplexed recording can be effected always at a constant exposure.

(6) An optical recording medium comprising a hologram recording material as defined in clause 2.

(7) An optical recording medium comprising a hologram recording material as defined in clause 2 stored in a light-screening cartridge during storage.

(8) A three-dimensional display hologram comprising a hologram recording material as defined in clause 2.

(9) A holographic optical element comprising a hologram recording material as defined in clause 2.

## Brief Description of the Drawings

Fig. 1 is a schematic diagram illustrating a two- flux optical system for hologram exposure.

## Detailed Description of the Invention

The hologram recording method and hologram recording material of the invention will be further described hereinafter.

In accordance with the hologram recording method of the invention, there is provided at least one discolorable dye and the discolorable dye is discolored upon hologram exposure to cause refractive index modulation by which an interference band is formed.

The term "discolorable dye" as used herein generically indicates a dye which has absorption in the ultraviolet range of from 200 to 2,000 nm, visible light range and infrared range and directly or indirectly causes any, preferably both of shifting of λmax to shorter wavelength and reduction of molar absorptivity when irradiated with light. The discoloration reaction occurs preferably in the wavelength range of from 200 to 1,000 nm, more preferably from 300 to 900 nm.

The refractive index of the dye rises in the range of from close to linear absorption maxima wavelength (λmas) to wavelength longer than linear absorption maxima wavelength (λmax), rises drastically in the range of from λmax to wavelength about 200 nm longer than λmax. In this wavelength range, some dyes show a refractive index of more than 1.8, as high as more than 2 in some cases. On the other hand, organic compounds which are not a dye, such as binder polymer, normally have a refractive index of from about 1.4 to 1.6.

Accordingly, when hologram exposure is effected to discolor the discolorable dye, the resulting difference in degree of discoloration between bright interference area and dark interference area allows great diffraction index difference modulation, making it possible to record it as an interference band.

The hologram recording method of the invention includes the method in which there are provided at least a sensitizing dye having absorption at hologram exposure wavelength and a discolorable dye having a molar absorptivity of 1,000 or less, preferably 100 or less at hologram reproducing light wavelength and the sensitizing dye absorbs light during hologram exposure to generate excitation energy by which electron or energy moves to discolor the discolorable dye, causing refractive index modulation by which an interference band is formed. The hologram recording material has at least a sensitizing dye and a discolorable dye.

The sensitizing dye and the discolorable dye which are preferably used in the invention will be further described later.

In the hologram recording method of the invention it is preferred that there is provided a discoloring agent precursor other than the discolorable dye and the sensitizing dye and when subjected to hologram exposure, the sensitizing dye or the discolorable dye generates excited state in which it then undergoes energy movement or electron movement with the discoloring agent precursor to cause the discoloring agent precursor to generate a discoloring agent which then discolors the discolorable dye, causing refractive index modulation by which an interference band is formed.

The discoloring agent is preferably any of radical, acid, base, nucleophilic agent, electrophilic agent and singlet oxygen, more preferably any of radical, acid and base. The discoloring agent precursor is preferably any of radical generator, acid generator, base generator, nucleophilic agent generator, electrophilic agent generator and triplet oxygen, more preferably any of radical generator, acid generator and base generator. The discoloring agent precursor will be further described hereinafter.

It is preferred that the hologram recording material of the invention be not subjected to wet process after hologram exposure.

The hologram recording material of the invention is preferably not of rewritable type. The term "not of rewritable type" as used herein is meant to indicate the type which causes irreversible reaction to perform recording. Once recorded, data can be stored without being rewritten even in an attempt to overwrite thereon. Thus, the hologram recording material of the invention is suitable for the storage of important data which are needed to be stored over an extended period of time. It goes without saying that data can be additionally recorded on unrecorded area. In this sense, this type of a recording material is called "recordable" or "write-once-read-many type" recording material.

The hologram recording material of the invention is preferably a recording material adapted to perform volume phase type hologram recording. The term "volume phase type hologram recording" as used herein is meant to indicate recording of many interference bands comprising from 1,000 to 100,000 lines per mm in the thickness direction as refractive index modulation in parallel or substantially parallel to the surface of the recording material (reflection type) or perpendicular or substantially perpendicular (transmission type) to the surface of the recording material as previously mentioned.

The light beam to be used in the hologram recording method of the invention is preferably any of ultraviolet ray, visible light and infrared ray having a wavelength of from 200 to 2,000 nm, more preferably ultraviolet ray or visible light having a wavelength of from 300 to 700 nm, even more preferably visible light having a wavelength of from 400 to

700 nm.

The chemically-acting radiation of the invention is preferably coherent laser beam (having uniform phase and wavelength). As the laser to be used herein there may be used any of solid laser, semiconductor laser, gas laser and liquid laser. Preferred examples of laser beam include YAG laser second harmonic having a wavelength of 532 nm, YAG laser third harmonic having a wavelength of 355 nm, GaN laser having a wavelength of from about 405 to 415 nm, Ar ion laser having a wavelength of from 488 nm or 515 nm, He-Ne laser having a wavelength of 632 nm to 633 nm, Kr ion laser having a wavelength of 647 nm, ruby laser having a wavelength of 694 nm, and He-Cd laser having a wavelength of 636 nm, 634 nm, 538 nm, 534 nm and 442 nm.

Further, pulse laser on the order of nanosecond or picosecond is preferably used.

In the case where the hologram recording material of the invention is used as an optical recording medium, YAG laser second harmonic having a wavelength of 532 nm or GaN laser having a wavelength of from about 405 to 415 nm is preferably used.

The wavelength of the light beam for use in hologram reproduction is preferably the same as or longer than, more preferably the same as that of the light beam for use in hologram exposure (recording).

The hologram recording material of the invention which has been subjected to hologram exposure may be subjected to fixing by either or both of light and heat.

In the case where the hologram recording material of the invention comprises an acid proliferator or base proliferator, it is particularly preferred that fixing be carried out by heating to cause the acid proliferator or base proliferator to act effectively.

In the case of light fixing, the hologram recording material is entirely irradiated with ultraviolet ray or visible light (non-interference exposure). Preferred examples of the light employable herein include visible light laser, ultraviolet laser, carbon arc, high voltage mercury vapor lamp, xenon lamp, metal halide lamp, fluorescent lamp, tungsten lamp, LED, and organic EL.

In the case of heat fixing, fixing is preferably effect at a temperature of from 40°C to 160°C, more preferably from 60°C to 130°C.

In the case where both light fixing and heat fixing are effect, light and heat may be applied at the same time or separately.

The refractive index modulation during recording of interference band is preferably from 0.00001 to 0.5, more preferably from 0.0001 to 0.3. It is preferred that the more the thickness of the hologram recording material is, the less is the refractive index modulation. It is preferred that the less the thickness of the hologram recording material is, the more is the refractive index modulation.

The (relative) diffraction efficiency $\eta$ of a hologram recording material is given by the following equation:

$$\eta = \mathrm{Idiff}/\mathrm{Io} \ \ldots \ (\text{equation } 1)$$

where Io is the intensity of transmitted light which is not diffracted; and Idiff is the intensity of light which is diffracted (transmitted type) or reflected (reflected type). The diffraction efficiency may range from 0% to 100%, preferably 30% or more, more preferably 60% or more, most preferably 80% or more.

The sensitivity of a hologram recording material is normally represented by exposure per unit area ($mJ/cm^2$). The less this value is, the higher is the sensitivity. The exposure at which the sensitivity is defined differs from literature or patent to literature or patent. In some cases, the exposure at which recording (refractive index modulation) begins is defined as sensitivity. In other cases, the exposure at which the maximum diffraction efficiency (refractive index modulation) is given is defined as sensitivity. In further cases, the exposure at which half the maximum diffraction efficiency is given is defined as sensitivity. In still further cases, the exposure at which the gradient of diffraction efficiency relative to exposure E becomes maximum is defined as sensitivity.

According to Kugelnick's theoretical equation, the refractive index modulation $\Delta n$ at which a certain diffraction efficiency is given is inversely proportional to the thickness d. In other words, the sensitivity at which a certain diffraction efficiency is given differs with thickness. Thus, the more the thickness d is, the less is the required refractive index modulation $\Delta n$. Accordingly, the sensitivity cannot be unequivocally compared unless the conditions such as thickness are uniform.

In the invention, sensitivity is defined by "exposure at which half the maximum diffraction efficiency is given ($mJ/cm^2$)". The sensitivity of the hologram recording material of the invention is preferably 2 $J/cm^2$ or less, more preferably 1 $J/cm^2$ or less, even more preferably 500 $mJ/cm^2$ or less, most preferably 200 $mJ/cm^2$ or less if the thickness is from about 10 $\mu$m to 200 $\mu$m.

In the case where the hologram recording material of the invention is used in holographic memory as an optical recording medium, it is preferred that many two-dimensional digital data (referred to as "signal light") be recorded using

a spatial light modulation element (SLM) such as Digital Micromirror Device (DMD) and LCD. Recording is preferably accomplished by multiplexed recording to raise the recording density. Examples of multiplexed recording methods include angular multiplexed, phase multiplexed, wavelength multiplexed and shift multiplexed recording methods. Preferred among these multiplexed recording methods are angular multiplexed recording and shift multiplexed recording. In order to read reproduced three-dimensional data, CCD or CMOS is preferably used.

In the case where the hologram recording material of the invention is used in holographic memory as an optical recording medium, it is essential that multiplexed recording be effected to enhance the capacity (recording density). In this case, multiplexed recording involving preferably 10 or more times, more preferably 50 times or more, most preferably 100 times or more of recording jobs is performed. More preferably, any multiplexed recording can be effected always at a constant exposure to simplify recording system and enhance S/N ratio.

In the case where the hologram recording material of the invention is used as an optical recording medium, the hologram recording material is preferably stored in a light-screening cartridge during storage. It is also preferred that the hologram recording material be provided with a light filter capable of cutting part of wavelength range of ultraviolet ray, visible light and infrared ray other than recording light and reproduced light on the surface or back surface or on the both surfaces thereof.

In the case where the hologram recording material of the invention is used as an optical recording medium, the optical recording medium may be in the form of disc, card or tape or in any other form.

The various hologram recording methods of the invention and various components of the hologram recording material allowing these recording methods will be further described hereinafter.

Firstly, the sensitizing dye of the invention which absorbs light during hologram exposure to generate excited state will be further described hereinafter.

The sensitizing dye of the invention preferably absorbs any of ultraviolet ray, visible light and infrared ray having a wavelength of from 200 nm to 2,000 nm, more preferably ultraviolet ray or visible light having a wavelength of from 300 to 700 nm, even more preferably visible light having a wavelength of from 400 to 700 nm to generate excited state.

Preferred examples of the sensitizing dye employable herein include cyanine dye, squarilium cyanine dye, styryl dye, pyrilium dye, melocyanine dye, arylidene dye, oxonol dye, azlenium dye, coumarine dye, ketocoumarine dye, styrylcoumarine dye, pyrane dye, xanthene dye, thioxanthene dye, phenothiazine dye, phenoxazine dye, phenazine dye, phthalocyanine dye, azaporphiline dye, porphiline dye, fused ring aromatic dye, perylene dye, azomethine dye, anthraquinone dye, metal complex dye, and metalocene dye. Even more desirable among these sensitizing dyes are cyanine dye, melocyanine dye, oxonol dye, metal complex dye, and metalocene dye. A particularly preferred example of the metal complex dye is Ru complex dye. A particularly preferred example of the metalocene dye is ferrocene.

In addition to these sensitizing dyes, dyes and dyestuffs disclosed in Sinya Ogawara, "Shikiso Handobukku (Handbook of Dyes)", Kodansha, 1986, Shinya Ogawara, "Kinosei Shikiso no Kagaku (Chemistry of Functional Dyes)", CMC, 1981, and Tadasaburo Ikemori, "Tokushu Kino Zairyo (Specially Functional Materials)", CMC, 1986 may be used as sensitizing dye of the invention. The sensitizing dye to be used in the invention is not limited to these examples. Any dye or dyestuff may be used so far as it absorbs light in the visible range. These sensitizing dyes may be selected such that they are adapted for the wavelength of radiation from the light source depending on the purpose. Two or more sensitizing dyes may be used in combination depending on the purpose.

Since the hologram recording material needs to be used in the form of thick layer and light needs to be transmitted by the layer, the molar absorptivity of the sensitizing dye at the wavelength of hologram exposure is preferably reduced to maximize the added amount of the sensitizing dye for the purpose of enhancing sensitivity. The molar absorptivity of the sensitizing dye at the wavelength of hologram exposure is preferably from not smaller than 1 to not greater than 10,000, more preferably from not smaller than 1 to not greater than 5,000, even more preferably from not smaller than 5 to not greater than 2,500, most preferably from not smaller than 10 to not greater than 1,000.

The transmittance of the hologram recording material at the recording wavelength is preferably from 10% to 99%, more preferably from 20% to 95%, even more preferably from 30% to 90%, particularly from 40% to 85% from the standpoint of diffraction efficiency, sensitivity and recording density (multiplexity). To this end, the molar absorptivity of the sensitizing dye at the recording wavelength and the molarity of the sensitizing dye to be added are preferably adjusted according to the thickness of the hologram recording material.

$\lambda$max of the sensitizing dye is preferably shorter than the wavelength of hologram recording, more preferably between the wavelength of hologram recording and the wavelength 100 nm shorter than the wavelength of hologram recording.

Further, the molar absorptivity of the sensitizing dye at the recording wavelength is preferably one fifth or less, more preferably one tenth or less of that at $\lambda$max. In particular, when the sensitizing dye is an organic dye such as cyanine dye and melocyanine dye, the molar absorptivity of the sensitizing dye at the recording wavelength is more preferably one twentieth or less, even more preferably one fiftieth or less, particularly one hundredth or less of that at $\lambda$max.

Specific examples of the sensitizing dye employable herein will be given below, but the invention is not limited thereto.

< Cyanine dye >

S-1

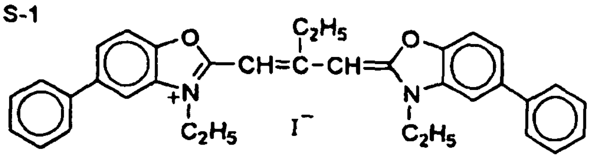

S-2

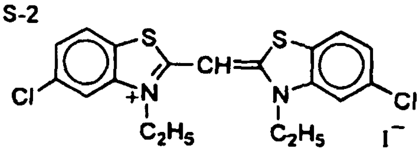

S-3

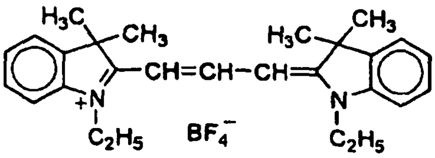

S-4

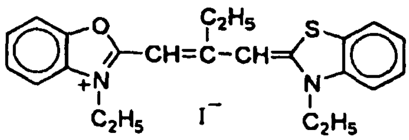

S-5

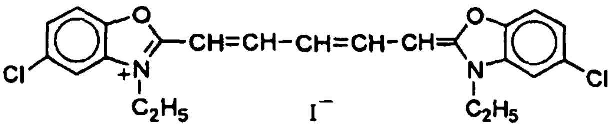

S-6

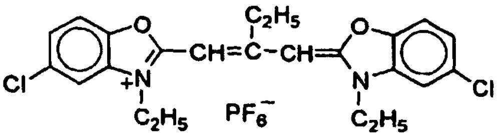

S-7

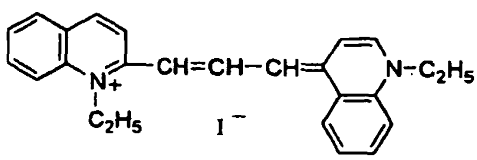

S-8

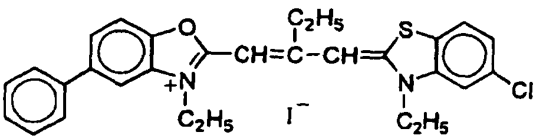

S-9

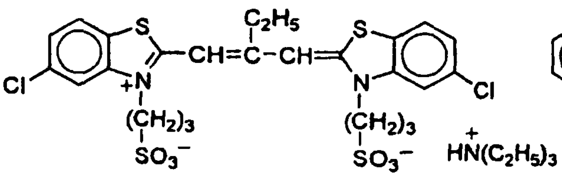

S-10

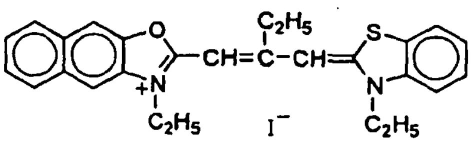

S-11

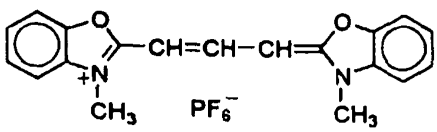

<Squarilium cyanine dye>

S-12

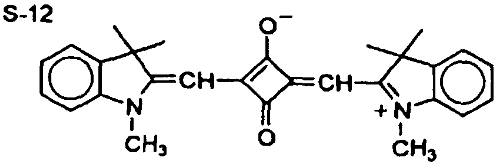

S-13

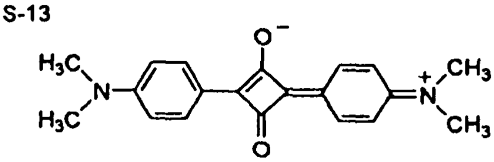

< Styryl dye >

S-14

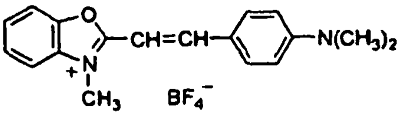

S-15

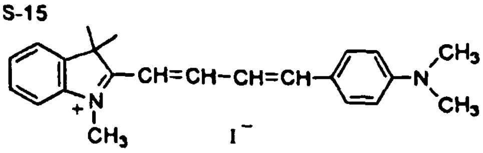

< Pyrilium dye >

S-16

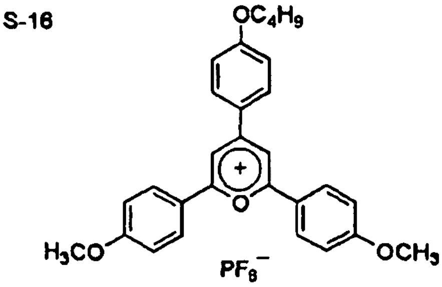

S-17

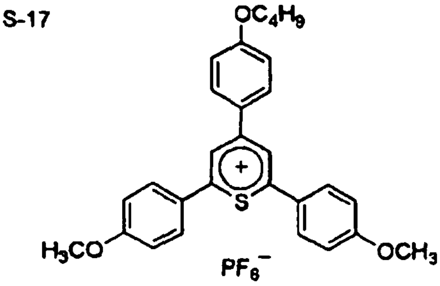

< Melocyanine dye >

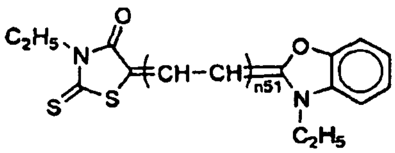

| | n51 |
|---|---|
| S-18 | 0 |
| S-19 | 1 |
| S-20 | 2 |

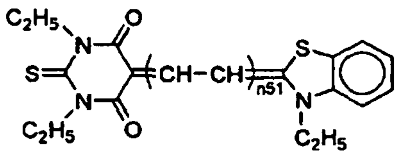

| | n51 |
|---|---|
| S-23 | 1 |
| S-24 | 2 |

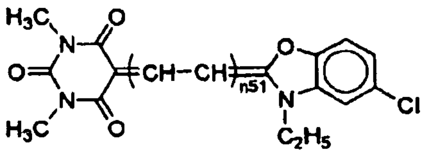

| | n51 |
|---|---|
| S-21 | 1 |
| S-22 | 2 |

$Q_{51}=CH-CH=Q_{52}$

| | $Q_{51}$ | $Q_{52}$ | | $Q_{51}$ | $Q_{52}$ |
|---|---|---|---|---|---|
| S-25 | 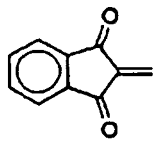 | 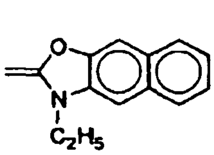 | S-26 | 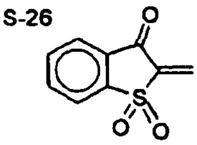 | 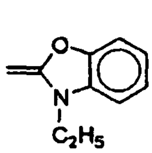 |
| S-27 | 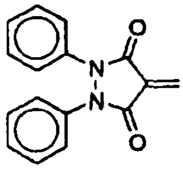 | 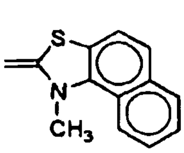 | S-28 | 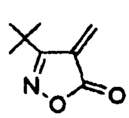 | 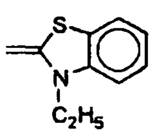 |
| S-29 | 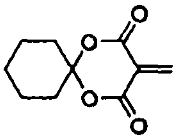 | 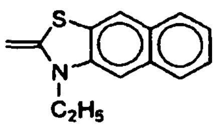 | | | |

<Melocyanine dye>

S-30

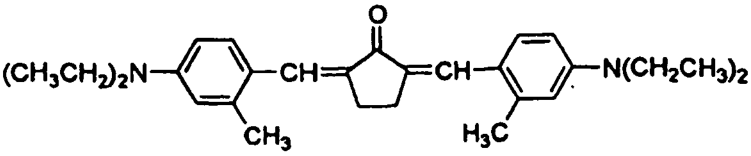

S-31

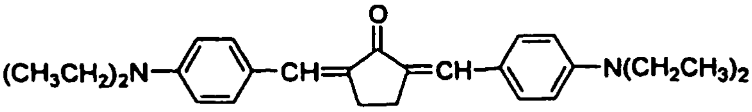

S-32

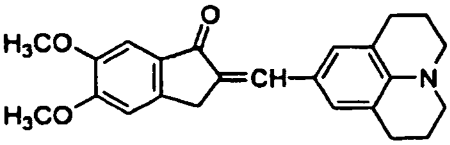

S-33

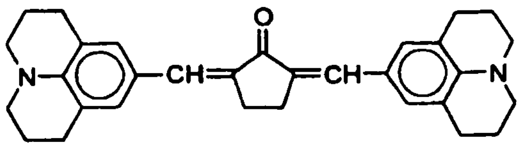

S-34

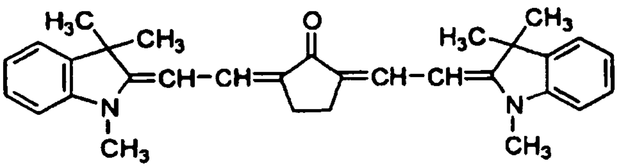

S-35

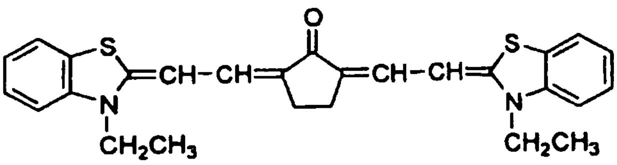

S-36

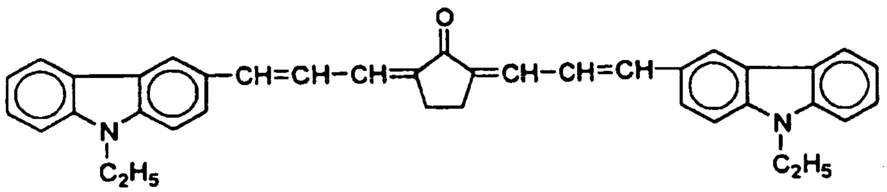

<Arylidene dye>

S-37

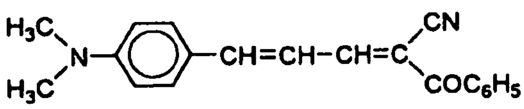

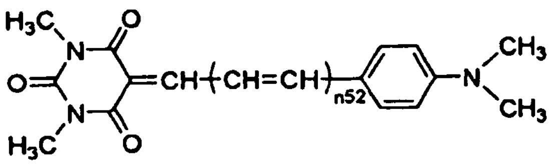

| | n52 |
|---|---|
| S-38 | 0 |
| S-39 | 1 |

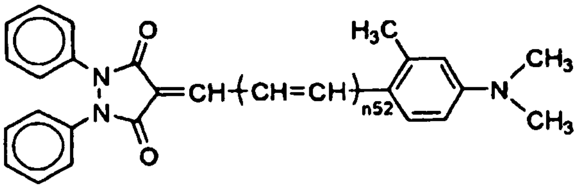

| | n52 |
|---|---|
| S-40 | 0 |
| S-41 | 1 |

<Oxonol dye>

$Q_{52}=CH\text{-}(CH=CH)_{n53}\text{-}Q_{53}$ Cl

| | $Q_{52}$ | $Q_{53}$ | $n_{53}$ | Cl |
|---|---|---|---|---|
| S-42 | 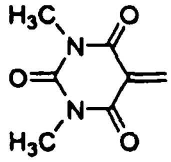 | 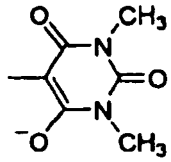 | 2 | $H^+$ |
| S-43 | 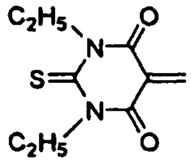 | 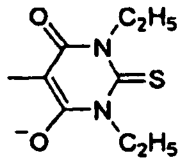 | 1 | 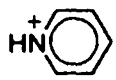 |
| S-44 | 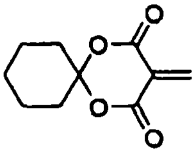 | 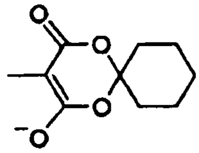 | 2 | $H^+$ |
| S-45 | 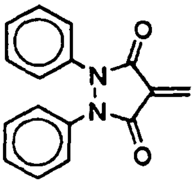 | 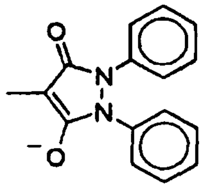 | 1 | $H^+$ |
| S-46 | 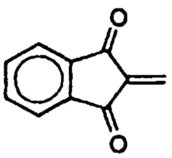 | 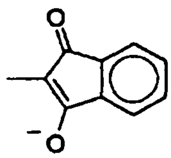 | 1 | $H\overset{+}{N}(C_2H_5)_3$ |

<Azlenium dye>

S-47

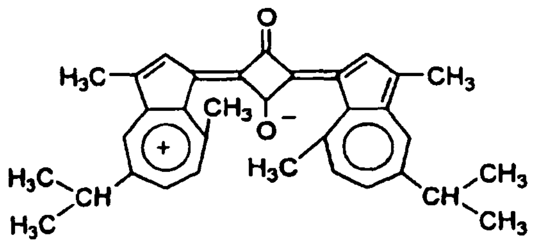

< Coumarine dye >

S-48

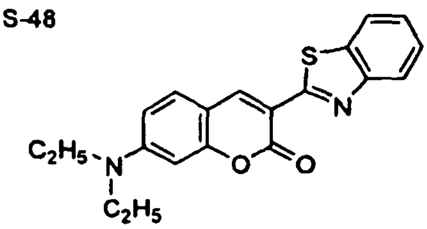

S-49

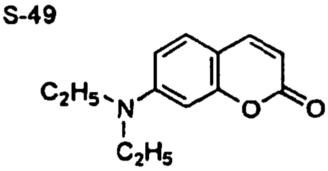

<Ketocoumarine dye>

S-50

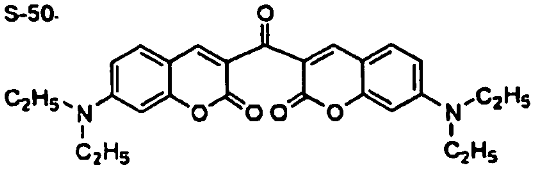

S-51

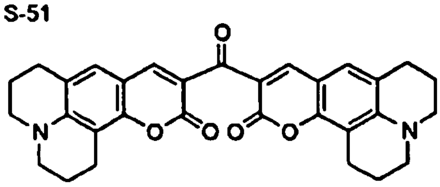

<Styrylcoumarine dye>

S-52

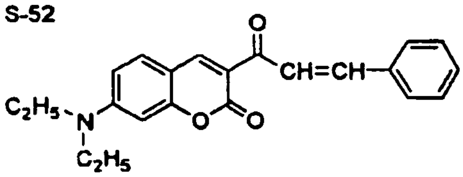

S-53

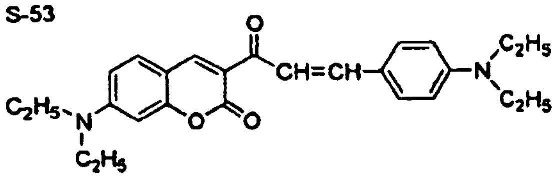

< Pyrane dye >

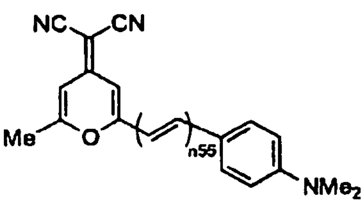

| | n55 |
|---|---|
| S-54 | 1 |
| S-55 | 2 |
| S-56 | 3 |

<Xanthene dye>

S-57

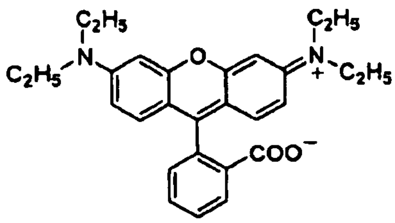

S-58

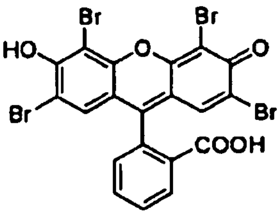

< Thioxanthene dye >

S-59

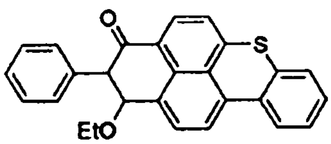

<Phenothiazine dye>

S-60

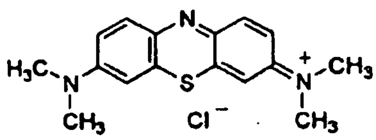

<Phenoxazine dye>

S-61

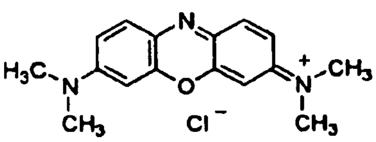

<Phenazine dye>

S-62

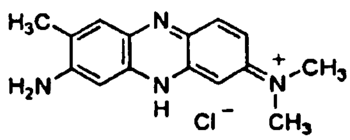

<Phthalocyanine dye>

S-63

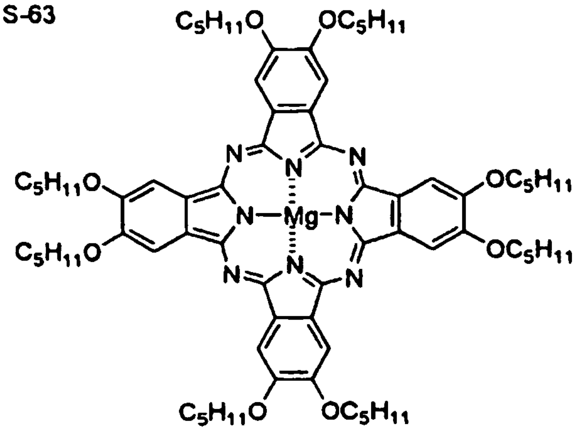

<Azaporphyrine dye>

S-64

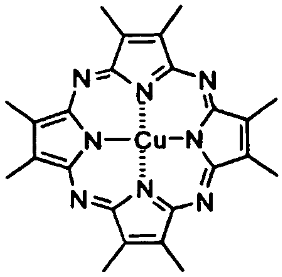

<Porphyrine dye>

S-65

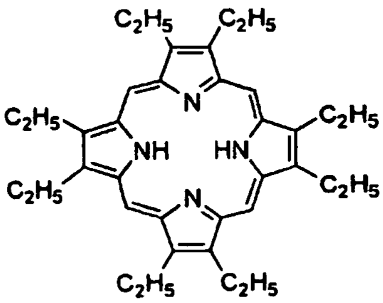

<Condensed aromatic dye>

S-66

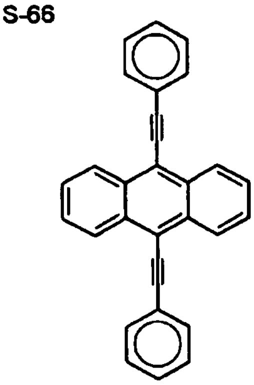

S-67

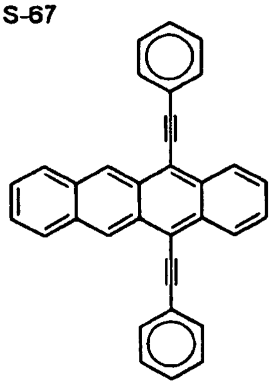

<Perylene dye>

S-68

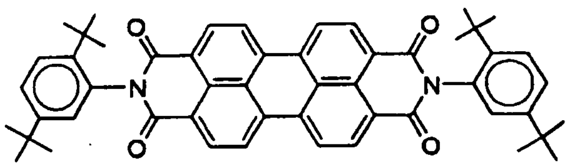

<Azomethine dye>

S-69

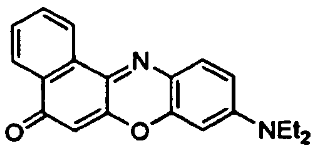

<Anthraquinone dye>

S-70

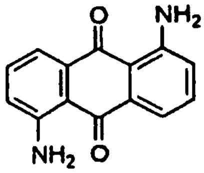

<Metal complex dye>

S-71

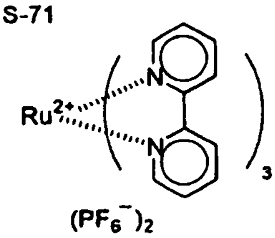

$(PF_6^-)_2$

S-72

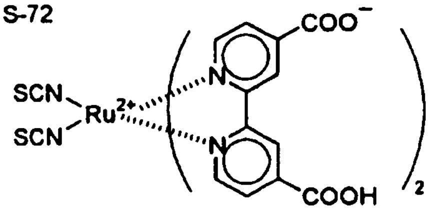

S-73

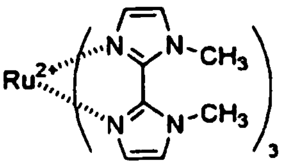

$(PF_6^-)_2$

S-74

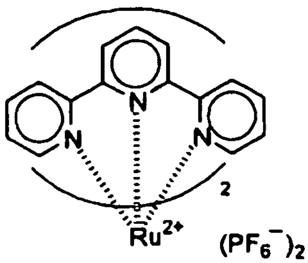

$(PF_6^-)_2$

S-75

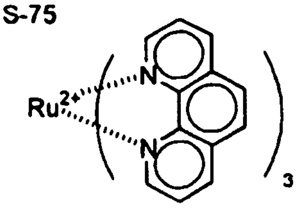

$(PF_6^-)_2$

S-76

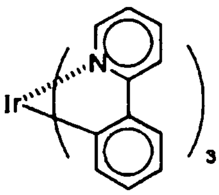

S-77

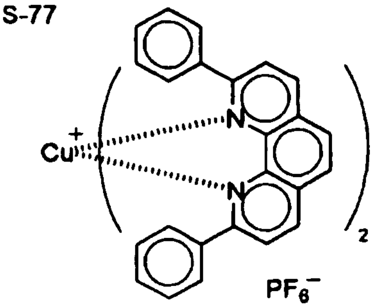

$PF_6^-$

S-78

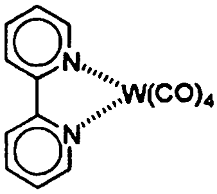

S-79

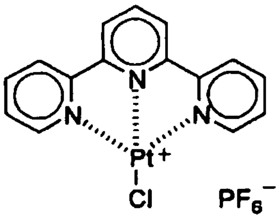

$PF_6^-$

S-80

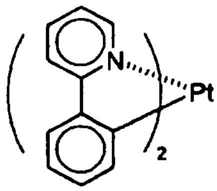

<Metalocene dye>

S-81

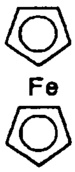

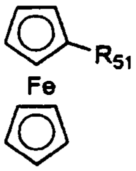

| | $R_{51}$ |
|---|---|
| S-82 | $-CHO$ |
| S-83 | $-CH_2CH_2COOH$ |
| S-84 | $-CH_2CH_2COOCH_3$ |
| S-85 | $-CH_2OH$ |
| S-86 | $-COOCH_3$ |

S-87

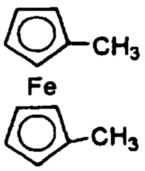

S-88

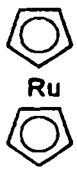

S-89

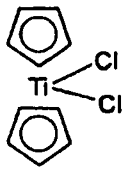

<Cyanine dye>

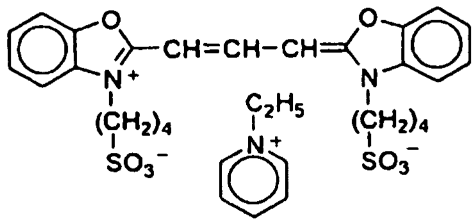

S-90

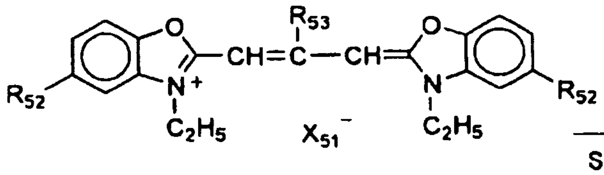

| | $R_{52}$ | $R_{53}$ | $X_{51}^-$ |
|---|---|---|---|
| S-91 | $-Cl$ | $-H$ | $I^-$ |
| S-92 | $-Cl$ | $-C_2H_5$ | $I^-$ |
| S-93 | $-Cl$ | $-H$ | $I^-$ |
| S-94 | $-Cl$ | $-H$ | $PF_6^-$ |
| S-95 | $-Br$ | $-H$ | $BF_4^-$ |
| S-96 | $-CH_3$ | $-H$ | $I^-$ |
| S-97 | $-OCH_3$ | $-C_2H_5$ | $PF_6^-$ |

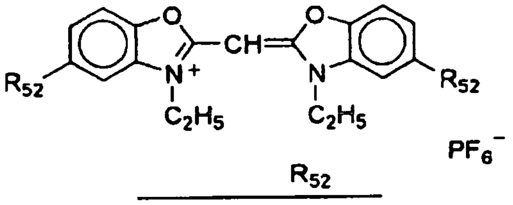

| | $R_{52}$ |
|---|---|
| S-98 | $-H$ |
| S-99 | $-Cl$ |
| S-100 | $-Ph$ |
| S-101 | $-CH_3$ |
| S-102 | $-OCH_3$ |

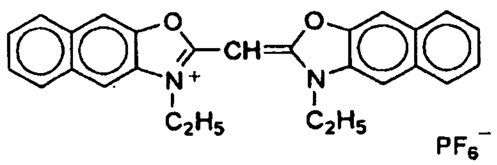

S-103

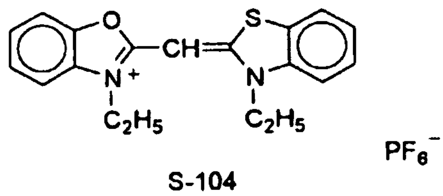

S-104

In the case where hologram recording is effected using frequency-doubled YAG laser beam of 532 nm, the sensitizing dye to be used is particularly preferably a trimethinecyanine dye having a benzoxazole ring, Ru complex dye or ferrocene. In the case hologram recording is effected using GaN laser beam of 405 to 415 nm, the sensitizing dye to be used is particularly preferably a monomethinecyanine dye having a benzoxazole ring, Ru complex dye or ferrocene.

Other preferred examples of the sensitizing dye of the invention are disclosed in Japanese Patent Application No. 2003-300059. The sensitizing dye of the invention is commercially available or can be synthesized by any known method.

The discolorable dye for making a difference in refractive index between bright interference area and dark interference area in the hologram recording material of the invention will be further described hereinafter.

In the invention a discolorable dye is used separately of the sensitizing dye. The molar absorptivity of the sensitizing dye at the wavelength of hologram recording is preferably 1,000 or less, more preferably 100 or less, most preferably 0. λmas of the discolorable dye is preferably in between the wavelength of hologram recording light and the wavelength 200 nm shorter than the wavelength of hologram recording light.

As the discolorable dye there may be used any of those exemplified with reference to the sensitizing dye. More

desirable among these dyes are cyanine dye, squarilium cyanine dye, styryl dye, pyrilium dye, melocyanine dye, arylidene dye, oxonol dye, coumarine dye, pyrane dye, xanthene dye, thioxanthene dye, phenothiazine dye, phenoxazine dye, phenazine dye, phthalocyanine dye, azaporphiline dye, porphiline dye, fused ring aromatic dye, perylene dye, azomethine dye, azo dye, anthraquinone dye, and metal complex dye. Even more desirable among these dyes are cyanine dye, styryl dye, melocyanine dye, arylidene dye, oxonol dye, coumarine dye, xanthene dye, azomethine dye, azo dye, and metal complex dye.

In particular, when the discoloring agent is an acid the discolorable dye is preferably a dissociation product of dissociative arylidene dye, dissociative oxonol dye, dissociative xanthene dye or dissociative azo dye, more preferably a dissociation product of dissociative arylidene dye, dissociative oxonol dye or dissociative azo dye. The term "dissociative dye" as used herein generically indicates a dye having an active hydrogen having pKa of from about 2 to 14 such as -OH group, -SH group, -COOH group, $-NHSO_2R$ group and $-CONHSO_2R$ group which undergoes deprotonation to have absorption in longer wavelength or with higher $\varepsilon$ (molar absorptivity). Accordingly, such a dissociative dye can be previously treated with a base to form a dissociated dye from which a dye having absorption in longer wavelength or with higher molar absorptivity can be prepared, making it possible to render the dye non-dissociative during photo-acid generation so that it is discolored (have absorption in lower wavelength or with lower molar absorptivity).

In particular, in the case where the discoloring agent is a base, when a product of color development of an acid-colorable dye such as triphenylmethane dye, xanthene dye and fluorane dye with an acid is used as a discolorable dye, it can be converted to unprotonated product and thus discolored (have absorption in lower wavelength or with lower molar absorptivity during photo-base generation.

Specific examples of the discolorable dye of the invention will be given below, but the invention is not limited thereto.

<Cyanine dye>

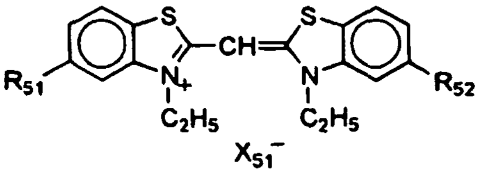

| | $R_{51}$ | $R_{52}$ | $X_{51}^-$ |
|---|---|---|---|
| G-1 | —H | —H | $I^-$ |
| G-2 | —Cl | —Cl | $PF_6^-$ |
| G-3 | 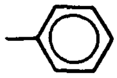 | —Cl | $I^-$ |
| G-4 | 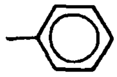 | 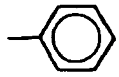 | $BF_4^-$ |
| G-5 | —Br | —$OCH_3$ | 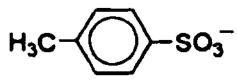 |

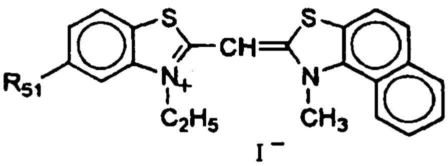

| | $R_{51}$ |
|---|---|
| G-6 | —H |
| G-7 | —Cl |
| G-8 | 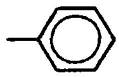 |

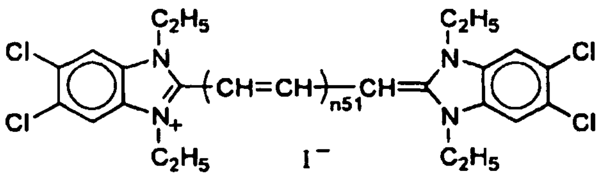

| | $n_{51}$ |
|---|---|
| G-9 | 0 |
| G-10 | 1 |

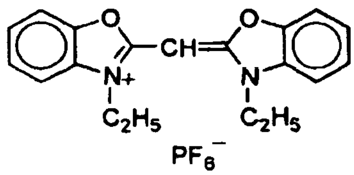

G-11

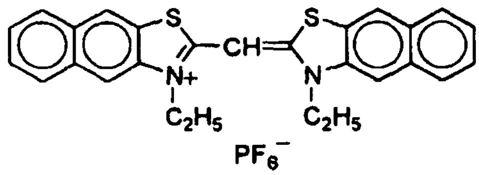

G-12

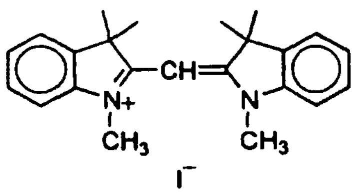

G-13

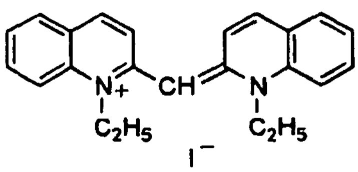

G-14

[Malocyanine dye>

<Melocyanine dye>

$Q_{51}=CH-CH=Q_{52}$

| | $Q_{51}$ | $Q_{52}$ |
|---|---|---|
| G-15 | 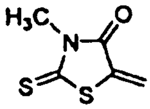 | 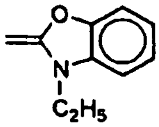 |
| G-16 | 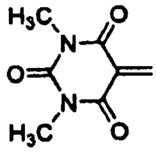 | 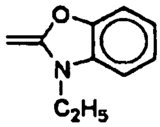 |
| G-17 | 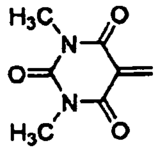 | 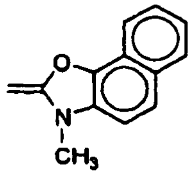 |
| G-18 | 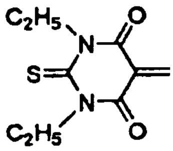 | 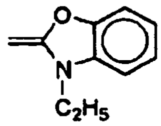 |
| G-19 | 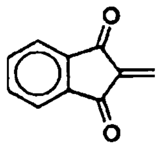 | 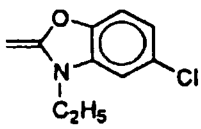 |
| G-20 | 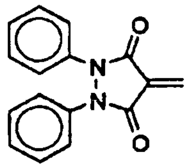 | 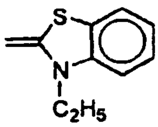 |
| G-21 | 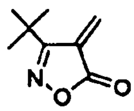 | 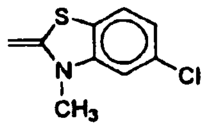 |
| G-22 | 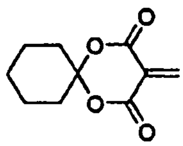 | 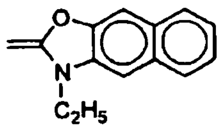 |
| G-23 | 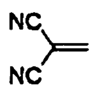 | 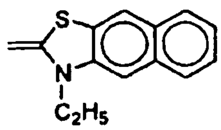 |
| G-24 | 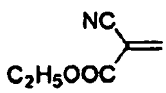 | 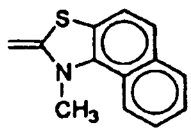 |

<Arylidene dye>

G-25

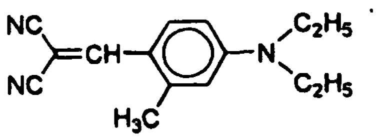

G-26

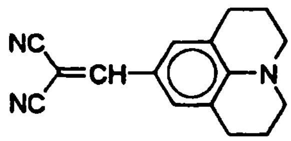

G-27

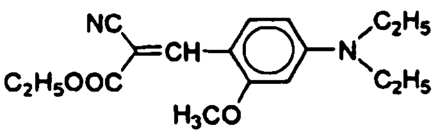

G-28

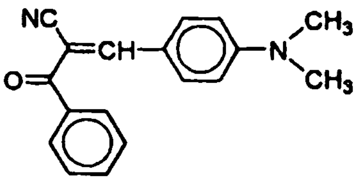

<Dissociation product of dissociative arylidene dye>

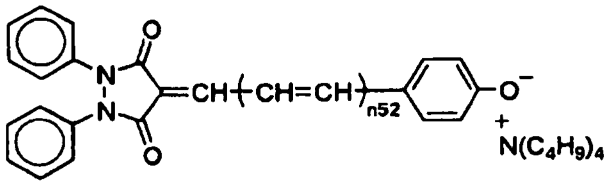

| | n52 |
|---|---|
| G-29 | 1 |
| G-30 | 2 |

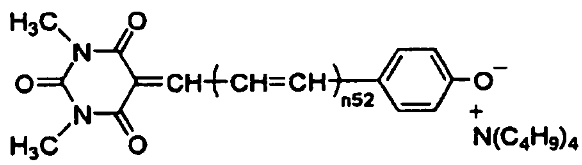

| | n52 |
|---|---|
| G-31 | 1 |
| G-32 | 2 |

G-33

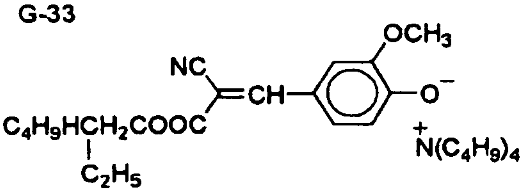

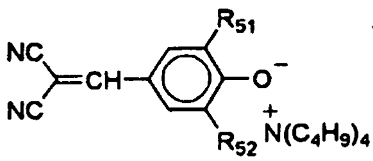

| | $R_{51}$ | $R_{52}$ |
|---|---|---|
| G-34 | H | H |
| G-35 | Cl | H |
| G-36 | Cl | Cl |

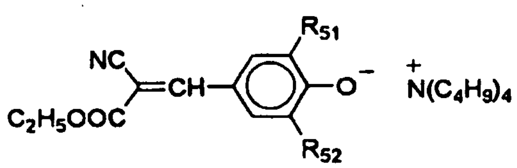

| | $R_{51}$ | $R_{52}$ |
|---|---|---|
| G-37 | H | H |
| G-38 | Cl | H |
| G-39 | Cl | Cl |

| | $R_{51}$ | $R_{52}$ |
|---|---|---|
| G-40 | $OCH_3$ | H |
| G-41 | $CH_3$ | $CH_3$ |
| G-42 | $C_3H_7$-i | $C_3H_7$-i |

G-43

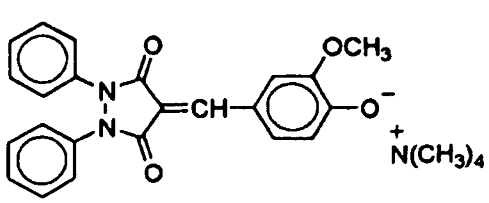

G-44

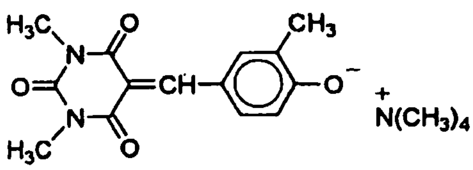

<Dissociation product of dissociative oxonol dye>

G-45

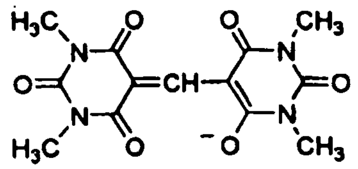

$^{+}N(C_4H_9)_4$

G-46

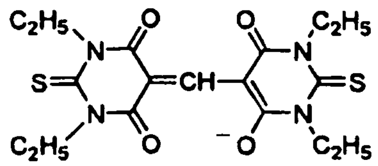

$^{+}N(C_2H_5)_4$

G-47

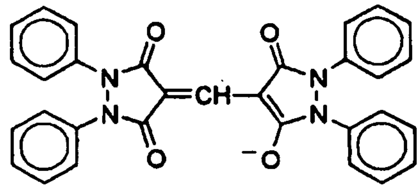

$^{+}N(CH_3)_4$

G-48

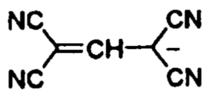

$^{+}N(C_4H_9)_4$

<Dissociation product of dissociative xanthene dye>

G-49

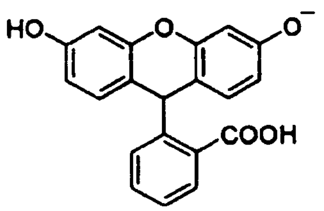

$^{+}N(C_4H_9)_4$

<Dissociation product of dissociative azo dye>

G-50

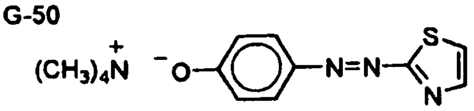

G-51

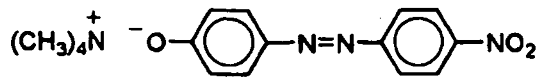

G-52

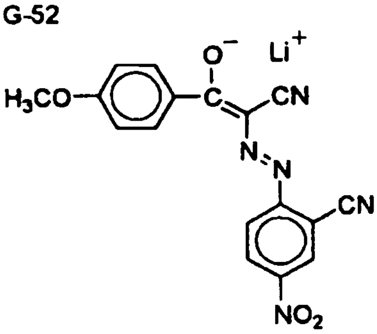

G-53

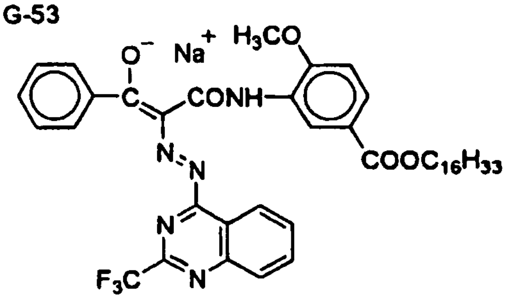

G-54

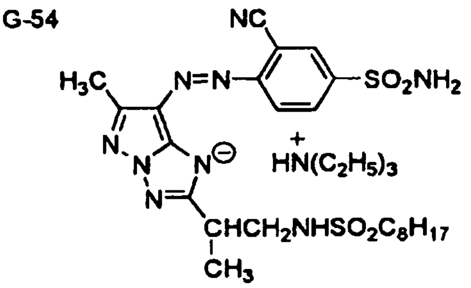

G-55

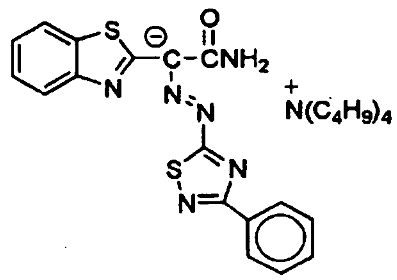

G-56

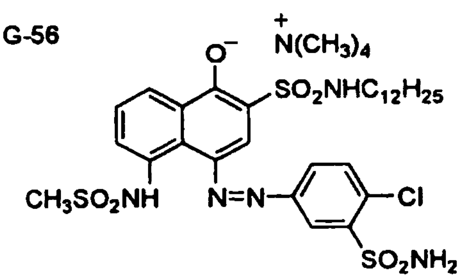

G-57

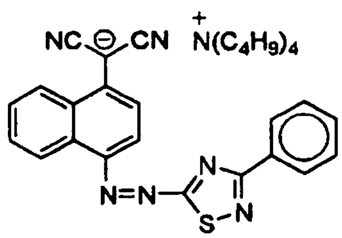

G-58

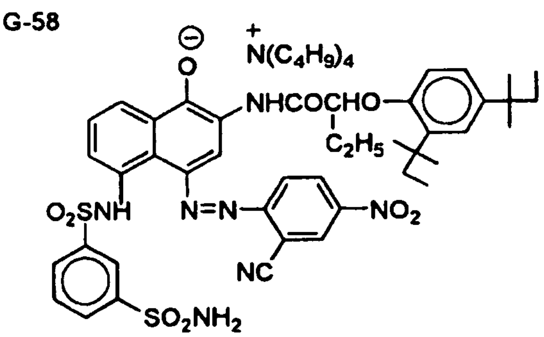

G-59

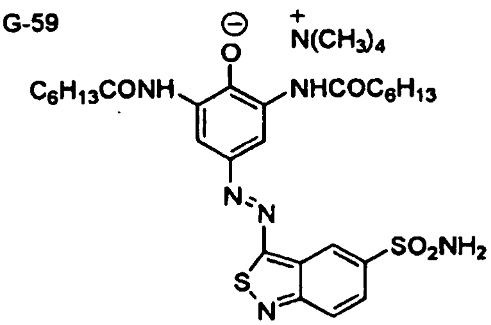

G-60

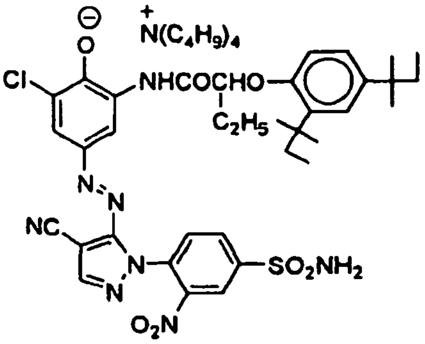

G-61

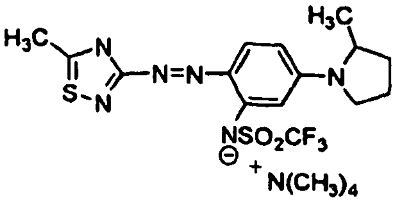

G-62

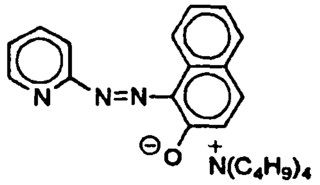

G-63

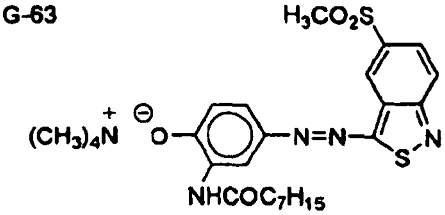

G-64

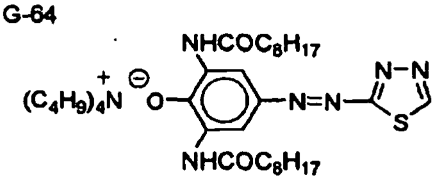

G-65

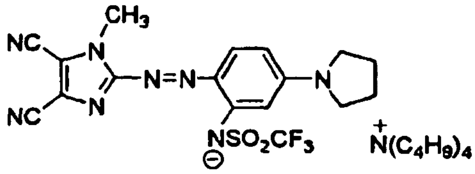

<Dissociation product of dissociative azomethine dye>

G-66

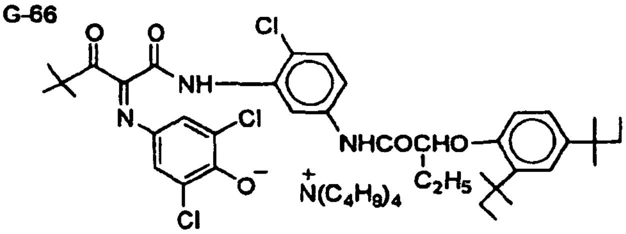

G-67

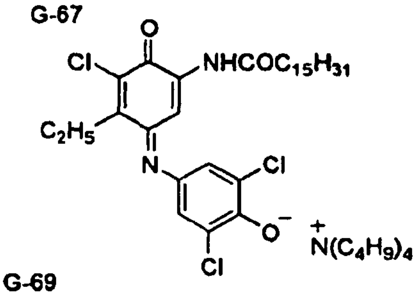

G-68

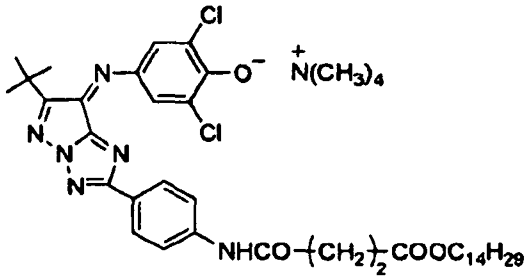

G-69

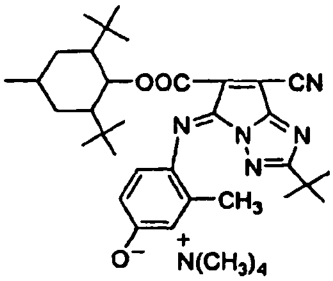

G-70

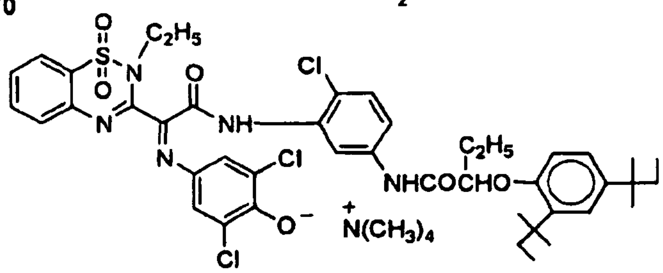

<Color development product of xanthene dye> $X51^-$ indicates an anion.

G-71

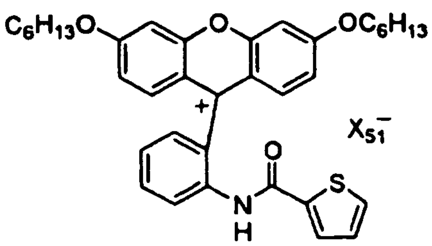

G-72

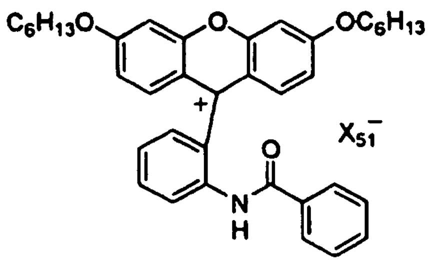

G-73

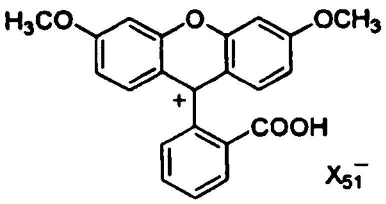

<Color development product of triphenylmethane dye>

G-74

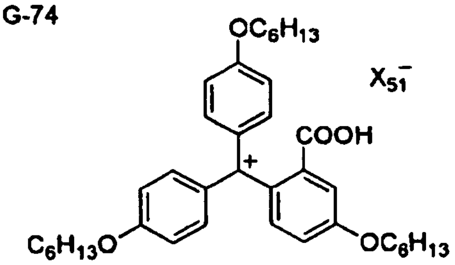

G-75

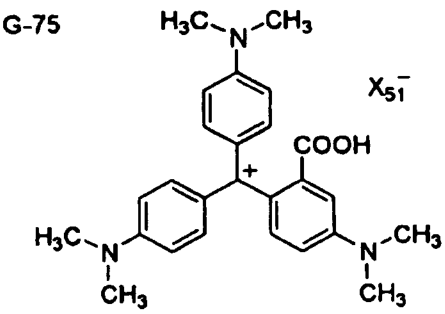

G-76

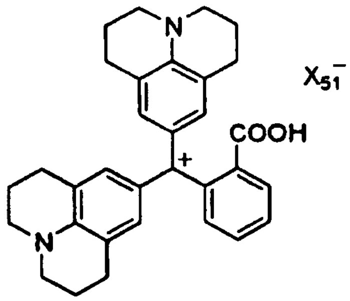

G-77

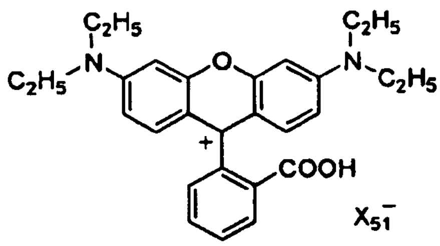

G-78

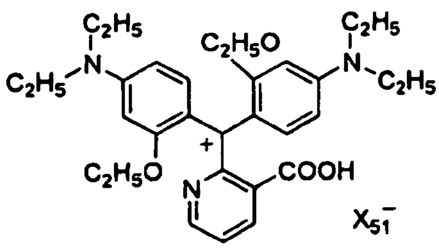

< Acid-color development product of cyanine base, mainly base-discolorable dye >

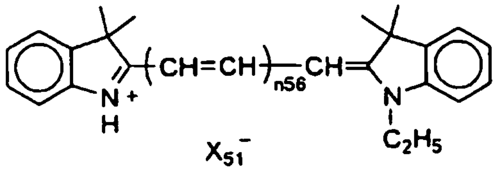

| | $n_{56}$ |
|---|---|
| G-79 | 0 |
| G-80 | 1 |
| G-81 | 2 |

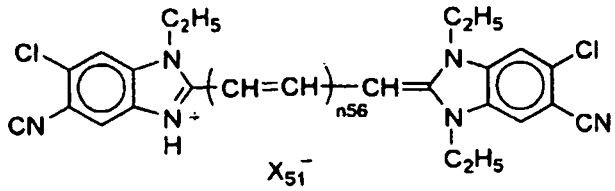

| | $n_{56}$ |
|---|---|
| G-82 | 0 |
| G-83 | 1 |

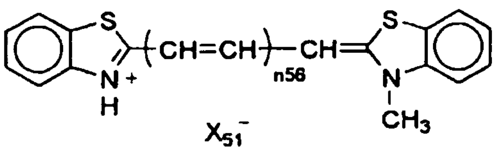

| | $n_{56}$ |
|---|---|
| G-84 | 0 |
| G-85 | 1 |

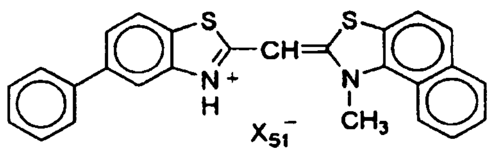

G-86

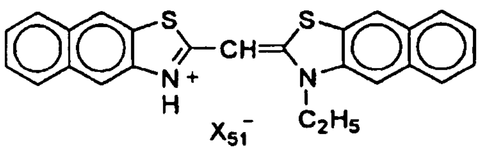

G-87

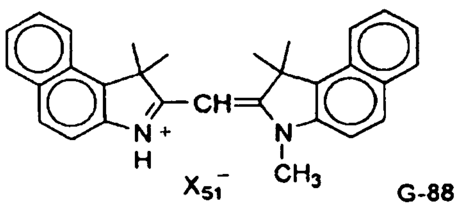

G-88

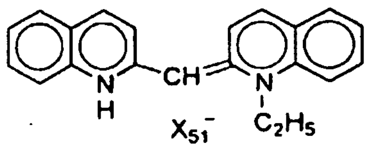

G-89

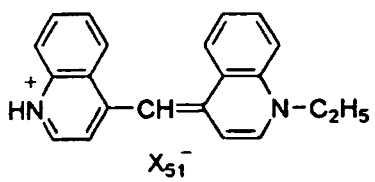

G-90

A preferred example of the discolorable dye of the invention is the following discolorable dye which is subjected to hologram exposure to generate excited state of sensitizing dye from which electron moves to severe the bond, resulting in the discoloration thereof.

Such a discolorable dye is orginally a cyanine dye. However, when the electron movement causes the bond to be severed, the discolorable dye is converted to a cyanine base (leucocyanine dye), causing the absorption to be eliminated or shifted to lower wavelength.

**< Discoloration by severation of bond by electron movement >**

<Discoloration by severation of bond by electron movement>

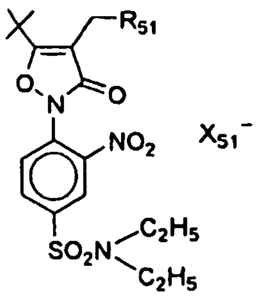

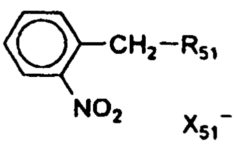

$X_{51}^-$ indicates an anion.

| | | |
|---|---|---|
| GD-1 | G-91 | G-98 |
| GD-2 | G-92 | G-99 |
| GD-3 | G-93 | G-100 |
| GD-4 | G-94 | G-101 |
| GD-5 | G-95 | G-102 |
| GD-6 | G-96 | G-103 |
| GD-7 | G-97 | G-104 |

Substitution at position *

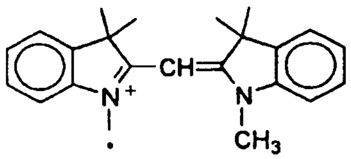

GD-1

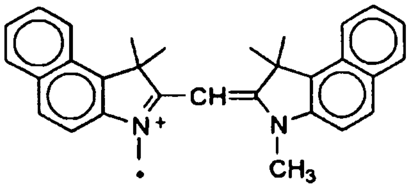

GD-2

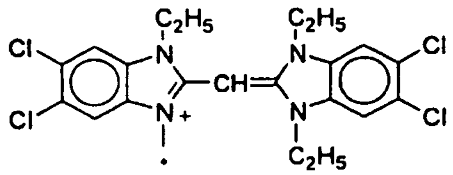

GD-3

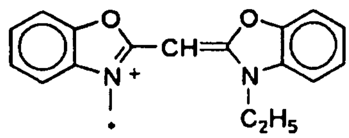

GD-4

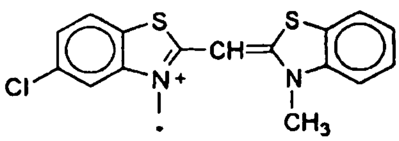

GD-5

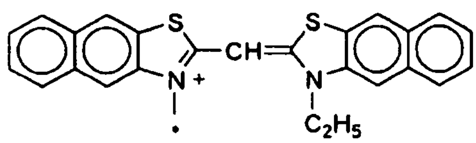

GD-6

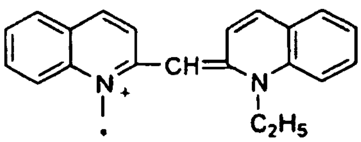

GD-7

The discolorable dye of the invention is commercially available or can be synthesized by any known method.

In accordance with the hologram recording material of the invention, there is provided a discoloring agent precursor other than the discolorable dye and the sensitizing dye and when subjected to hologram exposure, the sensitizing dye or the discolorable dye generates excited state in which it then undergoes energy transfer or electron transfer

with the discoloring agent precursor to cause the discoloring agent precursor to generate a discoloring agent which then discolors the discolorable dye, causing refractive index modulation by which an interference band is formed.

The discoloring agent is preferably any of radical, acid, base, nucleophilic agent, electrophilic agent and singlet oxygen, more preferably any of radical, acid and base. The discoloring agent precursor is preferably any of radical generator, acid generator, base generator, nucleophilic agent generator, electrophilic agent generator and triplet oxygen, more preferably any of radical generator, acid generator and base generator.

The discoloring agent precursor can irreversibly receive electron from or give electron to excited state of sensitizing dye to generate a sensitizing dye radical cation or radical anion, making it possible to efficiently photodecompose the sensitizing dye/discolorable dye, even if no acid, base or radical is generated.

In any mechanism of energy transfer from excited state of sensitizing dye to discoloring agent precursor, Foerster model mechanism involving the energy transfer from singlet excited state of sensitizing dye or Dexter model mechanism involving the energy transfer from triplet excited state of sensitizing dye may be employed.

In this case, it is preferred that the excitation energy of the sensitizing dye be greater than that of the dye precursor to cause efficient energy transfer.

On the other hand, in the mechanism of electron transfer from the excited state of sensitizing dye to the discoloring agent precursor, either a mechanism involving the electron transfer from singlet excited state of sensitizing dye or a mechanism involving the electron transfer from triplet excited state of sensitizing dye may be employed.

Further, the excited state of sensitizing dye may give electron to or receive electron from the discoloring agent precursor. In the case where the excited state of sensitizing dye gives electron, it is preferred that the energy of the orbit having excited electron present thereon (LUMO) in excited state of sensitizing dye be higher than the energy of LUMO orbit of discoloring agent precursor to cause efficient electron transfer.

In the case where the excited state of sensitizing dye receives electron, it is preferred that the energy of the orbit having hole present thereon (HOMO) in excited state of sensitizing dye be lower than the energy of HOMO orbit of discoloring agent precursor to cause efficient electron transfer.

Firstly, acid generator and radical generator as discoloring agent precursor will be further described. The radical generator or acid generator of the invention is any of radical generator which generates only radical, acid generator which generates only acid rather than radical and radical/acid generator which generates both radical and acid.

Preferred examples of the acid generator, radical generator and radical/acid generator of the invention include the following 14 systems. These acid generators, radical generators and radical/acid generators may be used in admixture of two or more thereof having an arbitrary proportion as necessary.

1) Ketone-based radical generator
2) Organic peroxide-based radical generator
3) Bisimidazole-based radical generator
4) Trihalomethyl-substituted triazine-based radical /acid generator
5) Diazonium salt-based radical/acid generator
6) Diaryl iodonium salt-based radical/acid generator
7) Sulfonium salt-based radical/acid generator
8) Borate-based radical generator
9) Diaryl iodonium-organic boron complex-based radical generator
10) Sulfonium-organic boron complex-based radical generator
11) Cationic sensitizing dye-organic boron complex- based radical generator
12) Anionic sensitizing dye-onium salt complex-based radical generator
13) Metal-allene complex-based radical/acid generator
14) Sulfonic acid ester-based acid generator

The aforementioned preferred systems will be further described hereinafter. In the case where a specific portion is referred to as "group", it means that the portion may or may not be substituted by one or more (many as possible) substituents unless otherwise specified. For example, "alkyl group" means a substituted or unsubstituted alkyl group.

In the case where a specific portion is referred to as "ring" or "group" includes "ring", it means that the portion may be monocyclic or fused ring or may or may not be substituted.

For example, "aryl group" may be a phenyl group, naphthyl group or substituted phenyl group. 1) Ketone-based radical generator

Preferred examples of the ketone-based radical generator include aromatic ketone, and aromatic diketone.

Preferred examples of the aromatic ketone and aromatic diketone include benzophenone derivatives (e.g., benzophenone, Michler's ketone), benzoin derivatives (e.g., benzoin methyl ether, benzoin ethyl ether, α-methylbenzoin, α-allylbenzoin, α-phenyl benzoin), acetoin derivatives (e.g., acetoin, pivaloyl, 2-hydroxy-2-methylpropiophenone, 1-hydroxycyclohexyl phenylketone), acyloinether derivatives (e.g., diethoxy acetophenone), α-diketone derivatives (e.g.,

diacetyl, benzyl, 4,4'-dimethoxybenzyl, benyldimethyl ketal, 2,3-bornanedione(caphorquinone), 2,2,5,5-tetramethyl tetrahydro-3,4-furanic acid (imidazoletrion)), xanthone derivatives (e.g., xanthone), thioxanthone derivatives (e.g., thioxanthone, 2-chlorothioxanthone), and ketocoumarine derivatives.

Examples of commercially available ketone-based radical generators include Irgacure® 184, 651 and 907 represented by the following general formulae marketed by Ciba Geigy Inc.

Irgacure 907

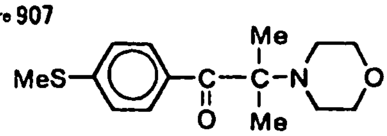

Irgacure 184

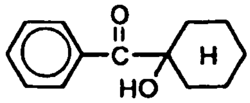

Irgacure 651

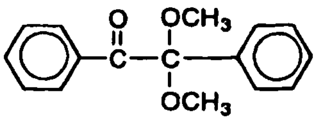

Further preferred examples of the ketone-based radical generator of the invention include quinone-based radical generators (e.g., 9,10-anthraquinone, 1-chloroanthraquinone, 2-chloroanthraquinone, 2- methylanthraquinone, 2-ethylanthraquinone, 2-t-butylanthraquinone, octamethylanthraquinone, 1,4- naphthoquinone, 9,10-phenanthrequinone, - 1,2- benzathraquinone, 2,3-benzanthraquinone, 2-methyl-1, 4-naphthoquinone, 2,3-dichloronaphthoquinone, 1,4- dimethylanthraquinone, 2,3-dimethylanthraquinone, 2-phenylanthraquinone, 2,3-dimethylanthraquinone, sodium salt of anthraquinone α-sulfonic acid, 3-chloro- 2-methylanthraquinone, retenequinone, 7,8,9,10-tetrahydronaphthacenequinone, and 1,2,3,4-tetrahydro benz(a)anthracene-7,12-dione). 2) Organic peroxide-based radical generator

Preferred examples of the organic peroxide-based radical generator include benzoyl peroxide, di-t-butyl peroxide, and 3,3',4,4'-tetra(t-butylperoxycarbonyl) benzophenone disclosed in JP-A-59-189340 and JP-A-60-76503. 3) Bisimidazole-based radical generator

The bisimidazole-based radical generator to be used herein is preferably a bis(2,4,5-triphenyl) imidazole derivative. Preferred examples of the bis(2,4,5-triphenyl)imidazole derivative include bis (2,4,5-triphenyl)imidazole, 2-(o-chlorophenyl)-4,5- bis(m-methoxyphenyl)-imidazole dimer (CDM-HABI), 1,1'-bimidazole, 2,2'-bis(o-chlorophenyl)-4,4', 5,5'-tetraphenyl(o-Cl-HABI), 1H-imidazole, and 2,5-bis(o-chlorophenyl)-4-[3,4-dimethoxyphenyl] dimer (TCTM-HABI).

The bisimidazole-based radical generator is preferably used in combination with a hydrogen donator. Examples of the hydrogen donator employable herein include 2-mercaptobenzoxazole, 2-mercapto benzothiazole, and 4-methyl-4H-1,2,4-triazole-3- thiol. 4) Trihalomethyl-substituted triazine-based radical/ acid generator

The trihalomethyl-substituted triazine-based radical/acid generator is preferably represented by the following general formula (11).

(11)

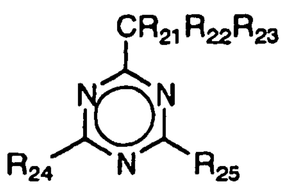

In the general formula (11), $R_{21}$, $R_{22}$ and $R_{23}$ each independently represent a halogen atom, preferably chlorine atom. $R_{24}$ and $R_{25}$ each independently represent a hydrogen atom, $-CR_{21}R_{22}R_{23}$ or substituent.

Preferred examples of the substituent include alkyl groups (preferably alkyl group having from 1 to 20 carbon atoms such as methyl, ethyl, n-propyl, isopropyl, n-butyl, n-pentyl, benzyl, 3-sulfopropyl, 4-sulfobutyl, carboxymethyl, 5-carboxypentyl), alkenyl groups (preferably alkenyl group having from 2 to 20 carbon atoms such as vinyl, allyl, 2-butenyl and 1,3-butadienyl), cycloalkyl groups (preferably cycloalkyl group having from 3 to 20 carbon atoms such as cyclopentyl and cyclohexyl), aryl groups (preferably aryl group having from 6 to 20 carbon atoms such as phenyl, 2-chlorophenyl, 4-methoxyphenyl, 3-methylphenyl and 1-naphthyl), heterocyclic groups (preferably heterocyclic group having from 1 to 20 carbon atoms such as pyridyl, chenyl, furyl, thiazolyl, imidazolyl, pyrazolyl, pyrrolidino, piperidino, morpholino), alkinyl groups (preferably having from 2 to 20 carbon atoms such as ethinyl, 2-propinyl, 1,3-butadinyl and 2-phenylethinyl), halogen atoms (e.g., F, Cl, Br, I), amino groups (preferably amino group having from 0 to 20 carbon atoms such as amino, dimethylamino, diethylamino, dibutylamino and anilino), cyano groups, nitro groups, hydroxyl groups, mercapto groups, carboxyl groups, sulfo groups, phosphonic acid groups, acyl groups (preferably acyl group having from 1 to 20 carbon atoms such as acetyl, benzoyl, salicyloyl and pivaloyl), alkoxy groups (preferably alkoxy group having from 1 to 20 carbon atoms such as methoxy, butoxy and cyclohexyloxy), aryloxy groups (preferably aryloxy group having from 6 to 26 carbon atoms such as phenoxy and 1-naphthoxy), alkylthio groups (preferably alkylthio group having from 1 to 20 carbon atoms such as methylthio and ethylthio), arylthio groups (preferably arylthio group having from 6 to 20 carbon atoms such as phenylthio and 4-chlorophenyl thio), alkylsulfonyl groups (preferably alkylsulfonyl group having from 1 to 20 carbon atoms such as methane sulfonyl and butanesulfonyl), arylsulfonyl groups (preferably arylsulfonyl group having from 6 to 20 carbon atoms such as benzenesulfonyl and paratoluenesulfonyl), sulfamoyl groups (preferably sulfamoyl group having from 0 to 20 carbon atoms such as sulfamoyl, N-methylsulfamoyl and N-phenylsulfamoyl), carbamoyl groups (preferably carbamoyl group having from 1 to 20 carbon atoms such as carbamoyl, N-methylcarbamoyl, N,N-dimethylcarbamoyl and N-phenylcarbamoyl), acylamino groups (preferably acylamino group having from 1 to 20 carbon atoms such as acetylamino and benzoylamino), imino groups (preferably imino group having from 2 to 20 carbon atoms such as phthalimino), acyloxy groups (preferably acryloxy group having from 1 to 20 carbon atoms such as acetyloxy and benzoyloxy), alkoxycarbonyl groups (preferably alkoxycarbonyl group having from 2 to 20 carbon atoms such as methoxycarbonyl and phenoxycarbonyl), and carbamoylamino groups (preferably carbamoylamino group having from 1 to 20 carbon atoms such as carbamoylamino, N-methylcarbamoylamino and N- phenylcarbamoylamino. More desirable among these substituents are alkyl groups, aryl groups, heterocyclic groups, halogen atoms, cyano groups, carboxyl groups, sulfo groups, alkoxy groups, sulfamoyl groups, carbamoyl groups, and alkoxycarbonyl groups.

$R_{24}$ preferably represents $-CR_{21}R_{22}R_{23}$, more preferably $-CCl_3$. $R_{25}$ preferably represents $-CR_{21}R_{22}R_{23}$, alkyl group, alkenyl group or aryl group.

Specific examples of the trihalomethyl- substituted triazine-based acid generator include 2- methyl-4,6-bis (trichloromethyl)-1,3,5-triazine, 2,4,6 -tris(trichloromethyl)-1,3,5-triazine, 2-phenyl-4,6- bis(trichloromethyl)-1,3,5-triazine, 2-(4'-methoxy phenyl)-4,6-bis(trichloromethyl)-1,3,5-triazine, 2-(4'-trifluoromethylphenyl)-4,6-bis(trichloromethyl)- 1,3,5-triazine, 2,4-bis(trichloromethyl)-6-(p-methoxyphenylvinyl)-1,3,5-triazine, and 2-(4'-methoxy -1'-naphthyl)-4,6-bis(trichloromethyl)-1,3,5- triazine. Preferred examples of the trihalomethyl- substituted triazine-based acid generator include compounds disclosed in British Patent 1,388,492 and JP-A -53-133428.

5) Diazonium salt-based radical/acid generator

The diazonium salt-based radical/acid generator is preferably represented by the following general formula (12).

(12)

$$(R_{27})_{a21}-R_{26}-\overset{+}{N}\equiv N \qquad X_{21}^{-}$$

$R_{26}$ represents an aryl group or heterocyclic group, preferably aryl group, more preferably phenyl group.

$R_{27}$ represents a substituent (the same as exemplified as substituents with reference to $R_{24}$). The suffix a21 represents an integer of from 0 to 5, preferably from 0 to 2. When a21 is 2 or more, the plurality of $R_{27}$'s may be the same or different and may be connected to each other to form a ring.

$X_{21}^-$ is an anion such that $HX_{21}$ is an acid having pKa of 4 or less, preferably 3 or less, more preferably 2 or less (at 25°C in water). Preferred examples of the anion include chloride, bromide, iodide, tetrafluoroborate, hexafluorobophosphate, hexafluoroarsenate, hexafluoroantimonate, perchlorate, trifluoromethanesulfonate, 9,10-dimethoxyanthracene-2 -sulfonate, methanesulfonate, benzenesulfonate, 4- trifluoromethylbenzenesulfonate, tosylate, and tetra (pentafluorophenyl)borate.

Specific examples of the diazonium salt-based radical/acid generator include salt of benzenediazonium, 4-methoxydiazonium and 4-methyldiazonium with the aforementioned $X_{21}^-$. 6) Diaryl iodonium salt-based radical/acid

generator

The diaryl iodonium salt-based radical/acid generator is preferably represented by the following general formula (13).

(13)

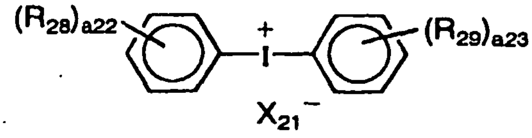

In the general formula (13), $X_{21}^-$ is as defined in the general formula (12). $R_{28}$ and $R_{29}$ each independently represent a substituent (preferably the same as exemplified with reference to $R_{24}$), preferably alkyl group, alkoxy group, halogen atom, cyano group or nitro group.

The suffixes a22 and a23 each independently represent an integer of from 0 to 5, preferably from 0 or 1. When a22 is 2 or more, the plurality of $R_{28}$'s and $R_{29}$'s may be the same or different and may be connected to each other to form a ring.

Specific examples of the diaryl iodonium salt- based radical/acid generator include chloride, bromide, iodide, tetrafluoroborate, hexafluorophosphate, hexafluoroarsenate, hexafluroantimonate, perchlorate, trifluoromethanesulfonate, 9,10-dimethoxyanthracene -2-sulfonate, methanesulfonate, benzenesulfonate, 4- trifluoromethylbenzenesulfonate, tosylate and tetra (pentafluorophenyl)borate of diphenyl iodonium, 4,4'-dichlorodiphenyl iodonium, 4,4'-dimethoxy diphenyl iodonium, 4,4'-dimethyl diphenyl iodonium, 4,4' -t-butyldiphenyl iodonium, 3,3'-dinitrodiphenyl iodonium, phenyl (p-methoxy phenyl)iodonium, phenyl (p-octyloxyphenyl)iodonium and bis(p-cyanophenyl) iodonium.

Further examples of the diaryl iodonium salt- based radical/acid generator include compounds disclosed in "Macromolecules", vol. 10, page 1307, 1977, and diaryl iodonium salts disclosed in JP-A-58-29803, JP-A-1-287105 and Japanese Patent Application No. 3-5569. 7) Sulfonium salt-based radical/acid generator

The sulfonium salt-based radical/acid generator is preferably represented by the following general formula (14).

(14)

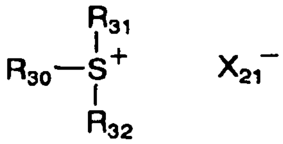

In the general formula (14), $X_{21}^-$ is as defined in the general formula (12). $B_{30}$, $B_{31}$ and $B_{32}$ each independently represent an alkyl group, aryl group or heterocyclic group (Preferred examples of these groups are the same as exemplified with reference to R24), preferably alkyl group, phenacyl group or aryl group.

Specific examples of the sulfonium salt-based radical/acid generator include chloride, bromide, iodide, tetrafluoroborate, hexafluorophosphate, hexafluoroarsenate, hexafluroantimonate, perchlorate, trifluoromethanesulfonate, 9,10-dimethoxyanthracene -2-sulfonate, methanesulfonate, benzenesulfonate, 4- trifluoromethylbenzenesulfonate, tosylate and tetra (pentafluorophenyl)borate of sulfonium salts such as triphenyl sulfonium, diphenylphenancyl sulfonium, dimethylphenancyl sulfonium, benzyl-4-hydroxyphenyl methyl sulfonium, 4-tertiarybutyltriphenyl sulfonium, tris(4-methylphenyl)sulfonium, tris(4-methoxyphenyl) sulfonium, 4-phenylthiotriphenyl sulfonium and bis-1-(4-(diphenylsulfonium)penyl) sulfide.

8) Borate-based radical generator

The borate-based radical generator is preferably represented by the following general formula (15).

(15)

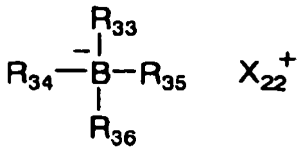

In the general formula (15), $R_{33}$, $R_{34}$, $R_{35}$ and $R_{36}$ each independently represent an alkyl group, alkenyl group, alkinyl group, cycloalkyl group or aryl group (Preferred examples of these groups are the same as exemplified with reference to $R_{24}$), preferably alkyl group or aryl group. However, $R_{33}$, $R_{34}$, $R_{35}$ and $R_{36}$ are not an aryl group at the same time. $X_{22}^+$ represents a cation.

More preferably, $R_{33}$, $R_{34}$ and $R_{35}$ each represent an aryl group and $R_{36}$ represents an alkyl group. Most preferably, $R_{33}$, $R_{34}$ and $R_{35}$ each represent a phenyl group and $R_{36}$ represents a n-butyl group.

Specific examples of the borate-based radical generator include tetrabutyl ammonium-n-butyl triphenyl borate, and tetramethyl ammonium-sec-butyl triphenyl borate. 9) Diaryl iodonium-organic boron complex-based radical generator

The diaryl iodonium-organic boron complex-based radical generator is preferably represented by the following general formula (16).

(16)

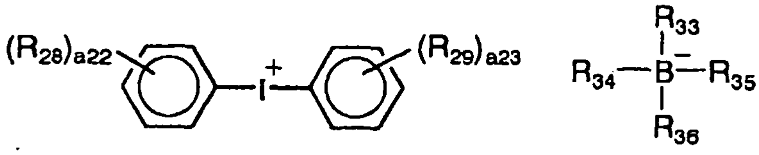

In the general formula (16), $R_{28}$, $R_{29}$, a22 and a23 are as defined in the general formula (13) and $R_{33}$, $R_{34}$, $R_{35}$ and $R_{36}$ are as defined in the general formula (15).

Specific examples of the diaryl iodonium-organic boron complex-based radical generator include the following compounds I-1 to I-3.

I-1

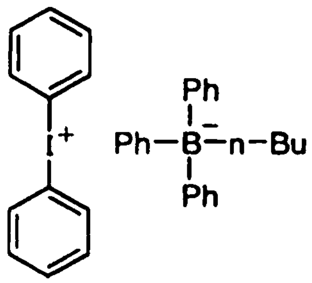

I-2

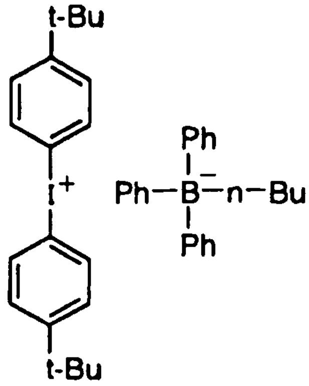

I-3

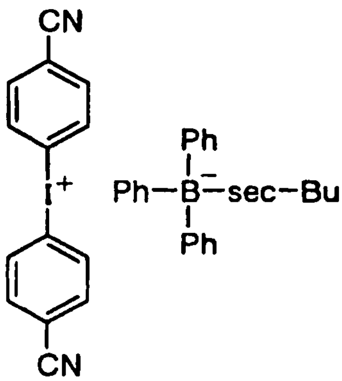

Iodonium-organic boron complexes such as diphenyl iodonium(n-butyl)triphenyl borate disclosed in JP-A-3-704 are also preferred. 10) Sulfonium-organic boron complex-based radical generator

The sulfonium-organic boron complex-based radical generator is preferably represented by the following general formula (17).

(17)

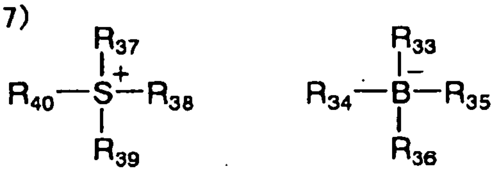

In the general formula (17), $R_{33}$, $R_{34}$, $R_{35}$ and $R_{36}$ are as defined in the general formula (15). $R_{37}$, $R_{38}$ and $R_{39}$ each independently represent an alkyl group, aryl group, alkenyl group, cycloalkyl group, alkoxy group, aryloxy group, alkylthio group, arylthio group or amino group (Preferred examples of these groups are the same as exemplified with reference to $R_{24}$), preferably alkyl group, phenacyl group, aryl group or alkenyl group. $R_{37}$, $R_{38}$ and $R_{39}$ may be connected to each other to form a ring. $R_{40}$ represents an oxygen atom or a lone pair of electrons.

Specific examples of the sulfonium-organic boron complex-based radical generator include the following compounds I-4 to I-10.

I-4

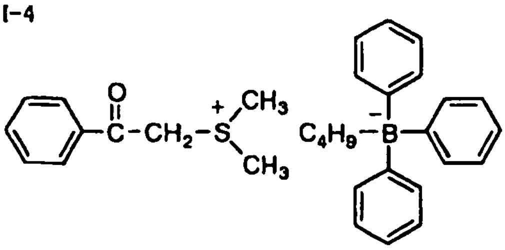

I-5

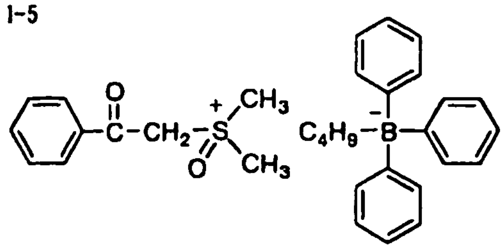

I-6

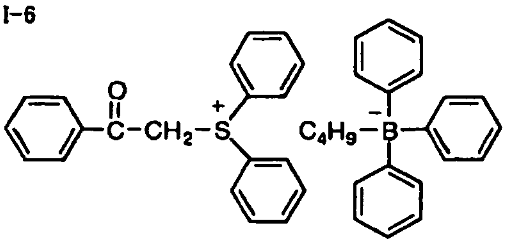

I-7

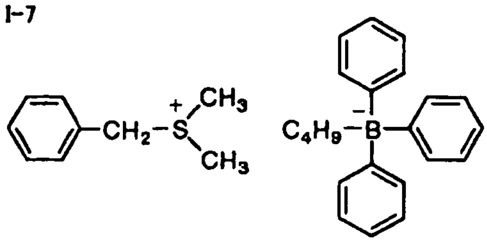

I-8

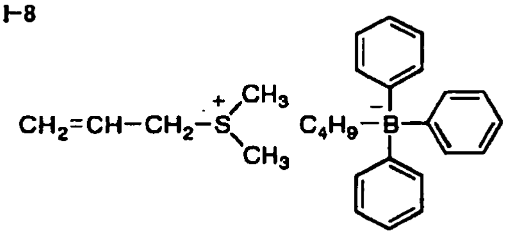

I-9

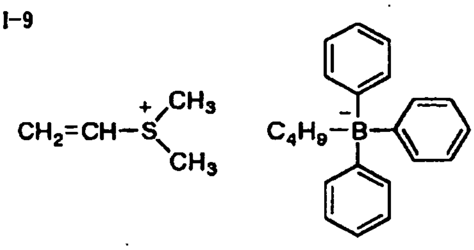

I-10

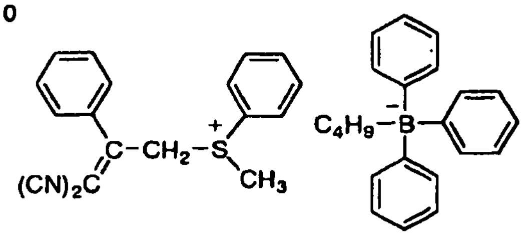

Sulfonium-organic boron complexes disclosed in JP- A-5-255347 and JP-A-5-213861 are also preferred. 11) Cationic sensitizing dye-organic boron complex- based radical generator

In the case where the radical generator of the invention is a cationic sensitizing dye-organic boron complex-based radical generator, the cationic sensitizing dye moiety may acts as sensitizing dye or discolorable dye of the invention.

The cationic sensitizing dye-organic boron complex-based radical generator is preferably represented by the following general formula (18).

(18)

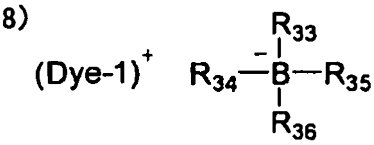

In the general formula (18), $(Dye-1)^+$ represents a cationic sensitizing dye. Preferred examples of the cationic sensitizing dye include the cationic sensitizing dye in the aforementioned sensitizing dyes. For example, cyanine dye and melocyanine dye are preferred. Even more desirable among these sensitizing dyes is cyanine dye. $R_{33}$, $R_{34}$, $R_{35}$ and $R_{36}$ are as defined in the general formula (15).

Specific examples of the cationic sensitizing dye- organic boron complex-based radical generator include the following compounds I-11, I-12, I-13 and I-14.

I-11

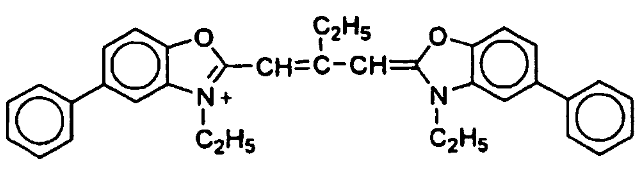

I-12

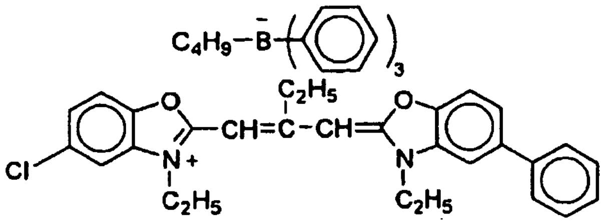

I-13

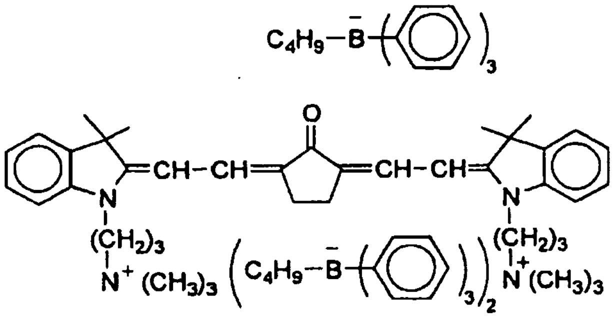

I-14

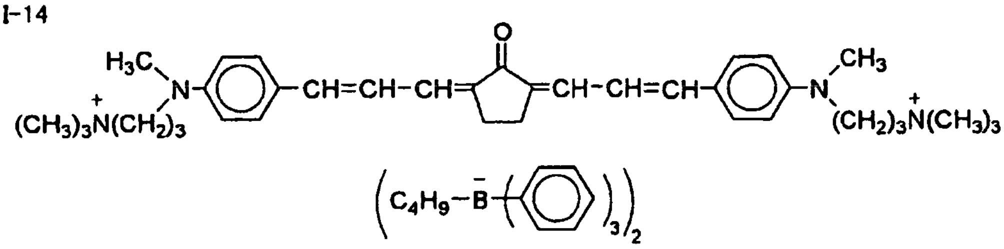

Other specific examples of the cationic sensitizing dye-organic boron complex-based radical generator include cationic dye-borate anion complexes disclosed in JP-A-62-143044 and JP-A-62-150242. 12) Anionic sensitizing dye-onium salt complex-based radical generator

In the case where the radical generator of the invention is an anionic sensitizing dye-onium salt complex-based radical generator, the anionic sensitizing dye moiety acts as a sensitizing dye or discolorable dye of the invention.

The anionic sensitizing dye-onium salt complex- based radical generator is preferably represented by the following general formula (19).

(19) $(Dye\text{-}2)^{-} X_{23}^{+}$

In the general formula (19), $(Dye\text{-}2)^{-}$ represents an anionic sensitizing dye. Preferred examples of the anionic sensitizing dye include the anionic sensitizing dye in the aforementioned sensitizing dyes. Preferred examples of the anionic sensitizing dye include cyanine dye, melocyanine dye, and oxonol dye. Even more desirable among these sensitizing dyes are cyanine dye and oxonol dye. $X_{23}^{+}$ represents the cation moiety in the diazonium salt of the general formula (12), the cation moiety in the diaryl iodonium salt of the general formula (13) or the cation moiety in the sulfonium salt of the general formula (14) (Preferred examples of these groups include those exemplified above), preferably the cation moiety in the diaryl iodonium salt of the general formula (13) or the cation moiety in the sulfonium salt of the general formula (14).

Specific examples of the anionic sensitizing dye-onium salt-based radical generator include the following compounds I-15 to 1-32.

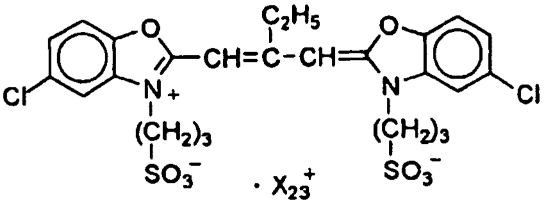

· $X_{23}^{+}$

| | $X_{23}^{+}$ | |
|---|---|---|
| I-15 | 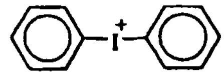 | (=C-1) |
| I-16 | 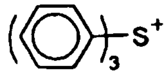 | (=C-2) |
| I-17 | 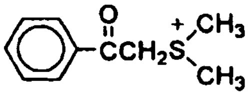 | (=C-3) |

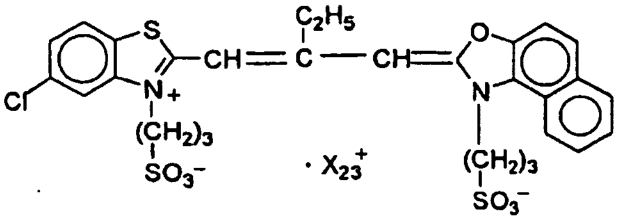

· $X_{23}^{+}$

| | $X_{23}^{+}$ |
|---|---|
| I-18 | C-1 |
| I-19 | C-2 |
| I-20 | C-3 |

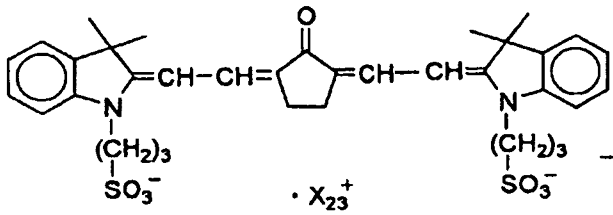

· $X_{23}^{+}$

| | $X_{23}^{+}$ |
|---|---|
| I-21 | C-1 |
| I-22 | C-2 |
| I-23 | C-3 |

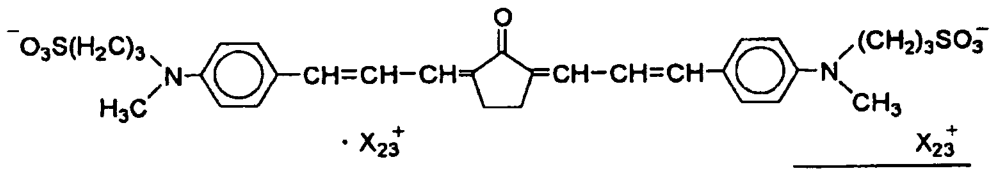

· $X_{23}^{+}$

| | $X_{23}^{+}$ |
|---|---|
| I-24 | C-1 |
| I-25 | C-2 |
| I-26 | C-3 |

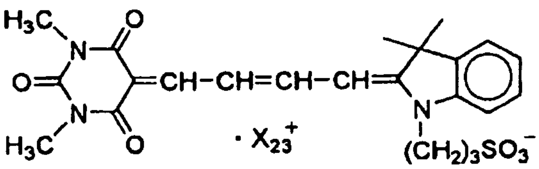

· $X_{23}^{+}$

| | $X_{23}^{+}$ |
|---|---|
| I-27 | C-1 |
| I-28 | C-2 |
| I-29 | C-3 |

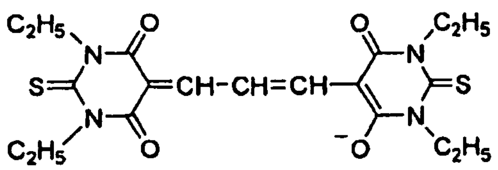

· $X_{23}^{+}$

| | $X_{23}^{+}$ |
|---|---|
| I-30 | C-1 |
| I-31 | C-2 |
| I-32 | C-3 |

13) Metal-allene complex-based radical/acid generator

The metal-allene complex-based radical/acid generator preferably comprises iron or titanium as metal.

Specific preferred examples of the metal-allene complex-based radical/acid generator include iron-allene complexes disclosed in JP-A-1-54440, EP109851, EP126712 and "Journal of Imaging Science (J. Imag. Sci.)", vol. 30, page 174, 1986, iron-allene- organic boron complexes disclosed in "Organometallics", vol. 8, page 2,737, 1989, iron-allene complex salts disclosed in "Prog. Polym. Sci.", vol. 21, pp. 7 to 8, 1996, and titacenones disclosed in J P-A-61-151197.
14) Sulfonic acid ester-based acid generator

Preferred examples of the sulfonic acid ester- based acid generator include sulfonic acid esters, sulfonic acid nitrobenzyl esters, and imide sulfonates.

Specific preferred examples of the sulfonic acid esters include benzoin tosylate, and pyrogallol trimesylate. Specific preferred examples of the sulfonic acid nitrobenzyl esters include o-nitrobenzyl tosylate, 2,6-dinitrobenzyl tosylate, 2',6'- dinitrobenzyl-4-nitrobenzene sulfonate, p-nitrobenzyl -9,10-diethoxyanthracene-2-sulfonate, and 2-nitrobenzyltrifluoromethylsulfonate. Specific preferred examples of the imide sulfonates include N- tosylphthalic acid imide, 9-fluolenylideneamino tosylate, and $\alpha$-cyanobenzylidene tosylate.

The radical or acid generators of the invention can be classified into the following categories:

a) Radical generator which generates radical;
b) Acid generator which generates only acid; and
c) Radical/acid generator which generates radical and acid at the same time Examples of the aforementioned compounds as a) radical generator which generates radical include the following compounds.

1) Ketone-based radical generator
2) Organic peroxide-based radical generator
3) isimidazole-based radical generator
4) Trihalomethyl-substituted triazine-based radical generator
5) Diazonium salt-based radical generator
6) Diaryl iodonium salt-based radical generator
7) Sulfonium salt-based radical generator
8) Borate-based radical generator
9) Diaryl iodonium-organic boron complex-based radical generator
10) Sulfonium-organic boron complex-based radical generator
11) Cationic sensitizing dye-organic boron complex- based radical generator
12) Anionic sensitizing dye-onium salt complex-based radical generator
13) Metal-allene complex-based radical generator

Preferred among these radical generators which generate radical are:

1) Ketone-based radical generator
3) Bisimidazole-based radical generator
4) Trihalomethyl-substituted triazine-based radical generator
6) Diaryl iodonium salt-based radical generator
7) Sulfonium salt-based radical generator
11) Cationic sensitizing dye-organic boron complex- based radical generator
12) Anionic sensitizing dye-onium salt complex-based radical generator

Even more desirable among these radical generators are:

3) Bisimidazole-based radical generator
6) Diaryl iodonium salt-based radical generator
7) Sulfonium salt-based radical generator
11) Cationic sensitizing dye-organic boron complex- based radical generator
12) Anionic sensitizing dye-onium salt complex-based radical generator

Examples of the aforementioned compounds as acid generator which generates only acid include the following compound. 14) Sulfonic acid ester-based acid generator

As acid generators there may be also used those disclosed in S. Peter Pappas, "UV CURING; SCIENCE AND TECHNOLOGY", A Technology Marketing Publication, p. 23 - 76, and B. Klingert, M. Riediker and A. Roloff, "Comments Inorg. Chem.", vol. 7, No. 3, p. 109 - 138, 1988.

Examples of the aforementioned compound as radical/acid generator which can generate radical and acid at the same time include the following compounds.

4) Trihalomethyl-substituted triazine-based radical /acid generator
5) Diazonium salt-based radical/acid generator
6) Diaryl iodonium salt-based radical/acid generator
7) Sulfonium salt-based radical/acid generator
13) Metal-allene complex-based radical/acid generator

Preferred among these radical/acid generators which can generate radical and acid at the same time are:

6) Diaryl iodonium salt-based radical/acid generator
7) Sulfonium salt-based radical/acid generator

The base general formula of the invention will be further described hereinafter. A base generator is a compound which can generate a base when subjected to energy transfer or electron transfer from excited state of sensitizing dye or discolorable dye. The base generator preferably stays stable in the dark. The base generator of the invention is preferably a compound which can generate a base when subjected to electron transfer from excited state of sensitizing dye or discolorable dye.

The base generator of the invention preferably generates a Bronsted base, more preferably an organic base, particularly an amine when irradiated with light.

The base generator of the invention is preferably represented by any of the general formulae (1-1) to (1-4) as defined above. These base generators may be used in admixture of two or more thereof having an arbitrary proportion as necessary.

In the general formula (1-1) or (1-2), $R_1$ and $R_2$ each independently represent a hydrogen atom, alkyl group (preferably alkyl group having from 1 to 20 carbon atoms such as methyl, ethyl, n-propyl, isoropyl, n-butyl, n- pentyl, n-octadecyl, benzyl, 3-sulfopropyl, 4-sulfobutyl, carboxylmethyl and 5-carboxypentyl), alkenyl group (preferably alkenyl group having from 2 to 20 carbon atoms such as vinyl, allyl, 2-butenyl and 1,3-butadienyl), cycloalkyl group (preferably cycloalkyl group having from 3 to 20 carbon atoms such as cyclopentyl and cyclohexyl), aryl group (preferably aryl group having from 6 to 20 carbon atoms such as phenyl, 2-chlorophenyl, 4-methoxyphenyl, 3-methylphenyl, 1-naphthyl and 2-naphthyl) or heterocyclic group (preferably heterocyclic group having from 1 to 20 carbon atoms such as pyridyl, chenyl, furyl, thiazolyl, imidazolyl, pyrazolyl, pyrrolidino, piperidino and morpholino), preferably hydrogen atom, alkyl group or cycloalkyl group, more preferably hydrogen atom, methyl group, ethyl group, cyclohexyl group or cyclopentyl group.

$R_1$ and $R_2$ may be connected to each other to form a ring. Preferred examples of the heterocyclic ring thus formed include piperidine ring, pyrrolidine ring, piperazine ring, morpholine ring, pyridine ring, quinoline ring, and imidazole ring. Even more desirable among thee heterocyclic rings are piperidine ring, pyrrolidine ring, and imidazole ring. Most desirable among these heterocyclic rings is piperidine ring.

Referring to preferred combinations of $R_1$ and $R_2$, $R_1$ is a cyclohexyl group which may be substituted and $R_2$ is a hydrogen, $R_1$ is an alkyl group which may be substituted and $R_2$ is a hydrogen atom, or $R_1$ and $R_2$ are connected to each other to form a piperidine ring or imidazole ring.

In the general formula (1-1) or (1-2), n1 is 0 or 1, preferably 1.

In the general formula (1-1), $R_3$'s each independently represent a substituent. Preferred examples of the substituent include alkyl groups (preferably alkyl group having from 1 to 20 carbon atoms such as methyl, ethyl, n-propyl, isopropyl, n-butyl, n-pentyl, benzyl, 3-sulfopropyl, 4-sulfobutyl, carboxymethyl, 5-carboxypentyl), alkenyl groups (preferably alkenyl group having from 2 to 20 carbon atoms such as vinyl, allyl, 2-butenyl and 1,3-butadienyl), cycloalkyl groups (preferably cycloalkyl group having from 3 to 20 carbon atoms such as cyclopentyl and cyclohexyl), aryl groups (preferably aryl group having from 6 to 20 carbon atoms such as phenyl, 2-chlorophenyl, 4-methoxyphenyl, 3-methylphenyl and 1-naphthyl), heterocyclic groups (preferably heterocyclic group having from 1 to 20 carbon atoms such as pyridyl, chenyl, furyl, thiazolyl, imidazolyl, pyrazolyl, pyrrolidino, piperidino, morpholino), alkinyl groups (preferably having from 2 to 20 carbon atoms such as ethinyl, 2-propinyl, 1,3-butadinyl and 2-phenylethinyl), halogen atoms (e.g., F, Cl, Br, I), amino groups (preferably amino group having from 0 to 20 carbon atoms such as amino, dimethylamino, diethylamino, dibutylamino and anilino), cyano groups, nitro groups, hydroxyl groups, mercapto groups, carboxyl groups, sulfo groups, phosphonic acid groups, acyl groups (preferably acyl group having from 1 to 20 carbon atoms such as acetyl, benzoyl, salicyloyl and pivaloyl), alkoxy groups (preferably alkoxy group having from 1 to 20 carbon atoms such as methoxy, butoxy and cyclohexyloxy), aryloxy groups (preferably aryloxy group having from 6 to 26 carbon atoms such as phenylthio and 4-chlorophenyl thio), alkylsulfonyl groups (preferably alkylsulfonyl group having from 1 to 20 carbon atoms such as methane sulfonyl and butanesulfonyl), arylsulfonyl groups (preferably arylsulfonyl group having from 6 to 20 carbon atoms such as benzenesulfonyl and paratoluenesulfonyl), sulfamoyl groups (preferably sulfamoyl group having from 0 to 20 carbon atoms such as sulfamoyl, N-methylsulfamoyl and N-phenylsulfamoyl), carbamoyl groups (preferably carbamoyl group having from 1 to 20 carbon atoms such as carbamoyl, N-methylcarbamoyl, N,N-dimethylcarbamoyl and N-phenylcarbamoyl), acylamino groups (preferably acylamino group having from 1 to 20 carbon atoms such as acetylamino and benzoylamino), imino groups (preferably imino group having from 2 to 20 carbon atoms such as phthalimino), acyloxy groups (preferably acryloxy group having from 1 to 20 carbon atoms such as acetyloxy and benzoyloxy), alkoxycarbonyl groups (preferably alkoxycarbonyl group having from 2 to 20 carbon atoms such as methoxycarbonyl and phenoxycarbonyl), and carbamoylamino groups (preferably carbamoylamino group having from 1 to 20 carbon atoms such as carbamoylamino, N-methylcarbamoylamino and N- phenylcarbamoylamino. More desirable among these substituents are alkyl groups, aryl groups, heterocyclic groups, halogen atoms, cyano groups, carboxyl groups, sulfo groups, alkoxy groups, sulfamoyl groups, carbamoyl groups, and alkoxycarbonyl groups.

In the general formula (1-1), $R_3$ is preferably a nitro group or alkoxy group, more preferably a nitro group or methoxy group, most preferably nitro group.

In the general formula (1-1), n2 is an integer of from 0 to 5, preferably from 0 to 3, more preferably from 1 or 2. When n2 is 2 or more, the plurality of $R_3$'s may be the same or different and may be connected to each other to form a ring. Preferred examples of the ring thus formed include benzene ring, and naphthalene ring.

In the general formula (1-1), when $R_3$ is a nitro group, it preferably substitutes on the 2- or 2,6-position. When $R_3$ is an alkoxy group, it preferably substitutes on the 3,5-position.

In the general formula (1-1), $R_4$ and $R_5$ each independently represent a hydrogen atom or substituent (Preferred examples of the substituent are the same as exemplified with reference to $R_3$), preferably hydrogen atom, alkyl group or aryl group, more preferably hydrogen atom, methyl group or 2-nitrophenyl group.

Referring to preferred combinations of $R_4$ and $R_5$, $R_4$ and $R_5$ each are a hydrogen atom, $R_4$ is a methyl group and $R_5$ is a hydrogen atom, $R_4$ and $R_5$ each are a methyl group, or $R_4$ is 2-nitrophenyl group and $R_5$ is a hydrogen atom. More preferably, $R_4$ and $R_5$ each are a hydrogen atom.

In the general formula (1-2), $R_6$ and $R_7$ each represent a substituent (Preferred examples of the substituent are the same as exemplified with reference to $R_3$), preferably alkoxy group, alkylthio group, nitro group or alkyl group, more preferably methoxy group.

In the general formula (1-2), n3 and n4 each independently represent an integer of from 0 to 5, preferably from 0 to 2. When n3 and n4 each are 2 or more, the plurality of $R_6$ and $R_7$ may be the same or different and may be connected to each other to form a ring. Preferred examples of the ring thus formed include benzene ring, and naphthalene ring.

In the general formula (1-2), $R_6$ is more preferably an alkoxy group which substitutes on the 3,5-position, even more preferably methoxy group which substitutes on the 3,5-position.

In the general formula (1-2), $R_8$ represents a hydrogen atom or substituent (Preferred examples of the substituent are the same as exemplified with reference to $R_3$), preferably hydrogen atom or aryl group, more preferably hydrogen atom.

In the general formula (1-3), $R_9$ represents a substituent (Preferred examples of the substituent are the same as exemplified with reference to $R_3$), preferably alkyl group, aryl group, benzyl group or amino group, more preferably alkyl group which may be substituted,, t-butyl group, phenyl group, benzyl group, anilino group which may be substituted or cyclohexylamino group.

The compound represented by the general formula (1-3) may be a compound connected to a polymer chain via $R_9$.

In the general formula (1-3), $R_{10}$ and $R_{11}$ each independently represent a hydrogen atom or substituent (Preferred examples of the substituent are the same as exemplified with reference to $R_3$), preferably alkyl group or aryl group, more preferably methyl group, phenyl group or 2-naphthyl group.

$R_{10}$ and $R_{11}$ may be connected to each other to form a ring. Preferred examples of the ring thus formed include fluorene ring.

In the general formula (1-4), $R_{12}$ represents an aryl group or heterocyclic group, more preferably the following aryl group or heterocyclic group.

$R_{12}$: 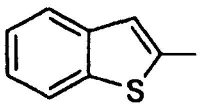 , 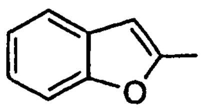 , 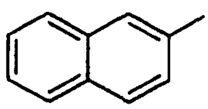

In the general formula (1-4), $R_{13}$, $R_{14}$ and $R_{15}$ each independently represent a hydrogen atom, alkyl group, alkenyl group, cycloalkyl group, aryl group or heterocyclic group (Preferred examples of these groups are the same as exemplified with reference to $R_1$ and $R_2$), preferably alkyl group, more preferably butyl group. $R_{13}$, $R_{14}$ and $R_{15}$ may be connected to each other to form a ring. Examples of the heterocyclic group thus formed include piperidine ring, pyrrolidine ring, piperazine ring, morpholine ring, pyridine ring, quinoline ring, and imidazole ring. Even more desirable among thee heterocyclic rings are piperidine ring, pyrrolidine ring, and imidazole ring.

In the general formula (1-4), $R_{16}$, $R_{17}$, $R_{18}$ and $R_{19}$ each independently represent an alkyl group or aryl group. More preferably, $R_{16}$, $R_{17}$ and $R_{18}$ each are a phenyl group and $R_{19}$ is a n-butyl group or phenyl group.

The base generator of the invention is preferably represented by the general formula (1-1) or (1-3), more preferably (1-1).

Specific preferred examples of the base generator of the invention will be given below, but the invention is not limited thereto.

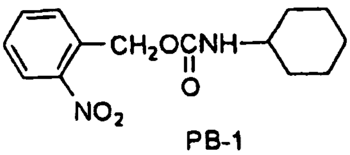

PB-1

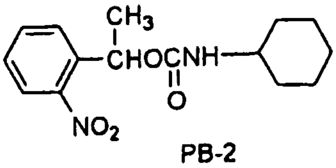

PB-2

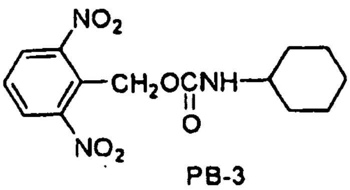

PB-3

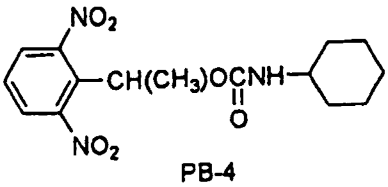

PB-4

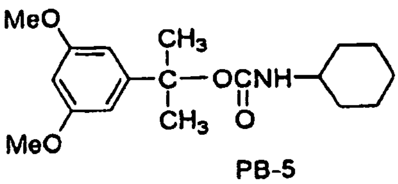

PB-5

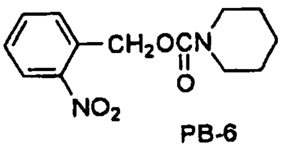

PB-6

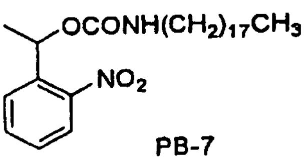

PB-7

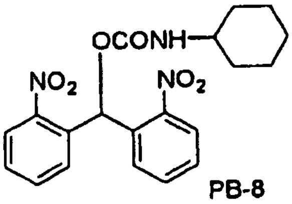

PB-8

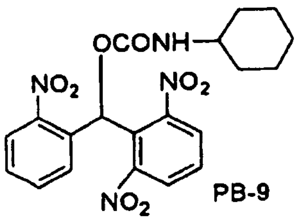

PB-9

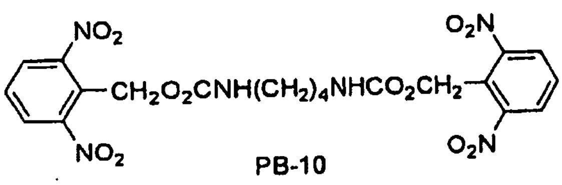

PB-10

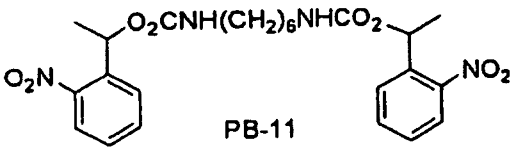

PB-11

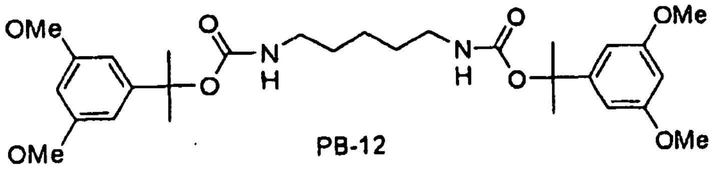

PB-12

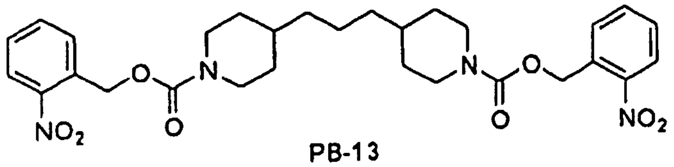

PB-13

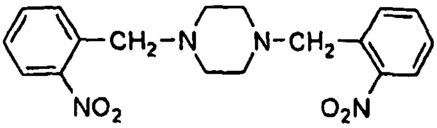

PB-14

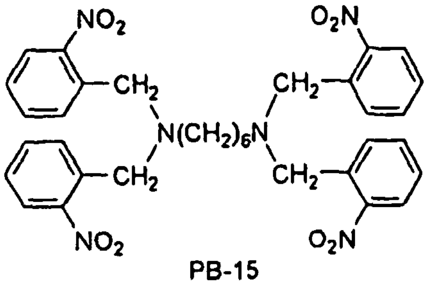

PB-15

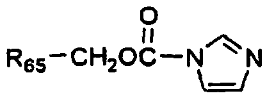

| | R65 | | |
|---|---|---|---|
| PB-16 | 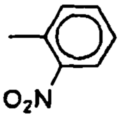 | PB-18 | 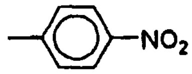 |
| PB-17 | 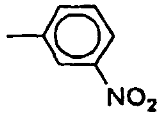 | PB-19 | 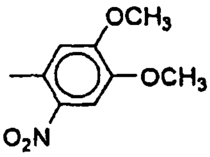 |

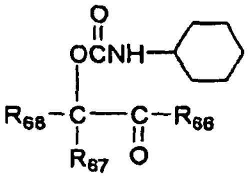

| | R66 | R67 | R68 |
|---|---|---|---|
| PB-20 | 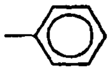 | 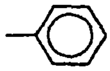 | −H |
| PB-21 | 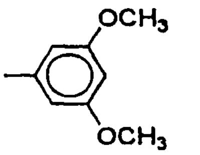 | 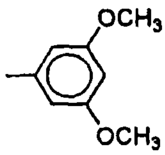 | " |
| PB-22 | 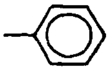 | " | " |
| PB-23 | 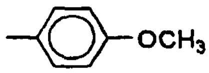 | " | " |
| PB-24 | 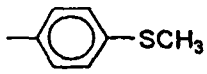 | " | " |
| PB-25 | 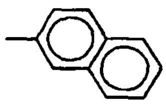 | " | " |
| PB-26 | 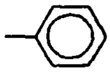 | " | 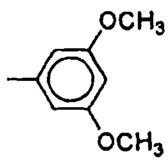 |

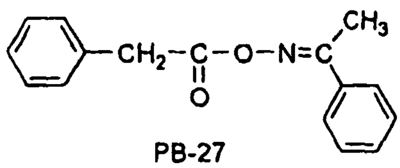

PB-27

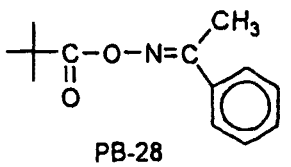

PB-28

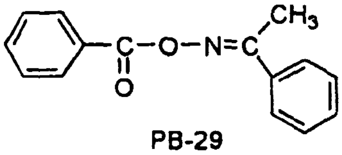

PB-29

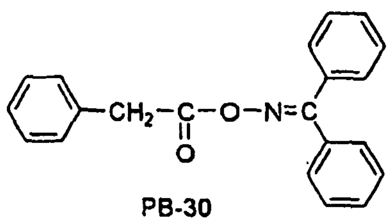

PB-30

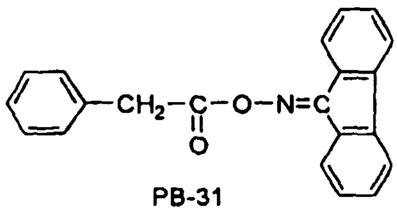

PB-31

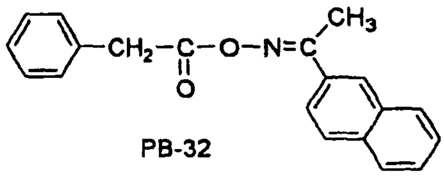

PB-32

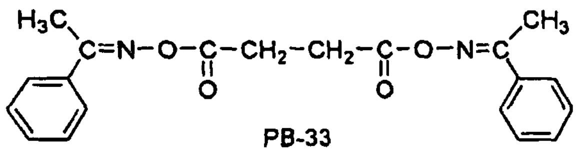

PB-33

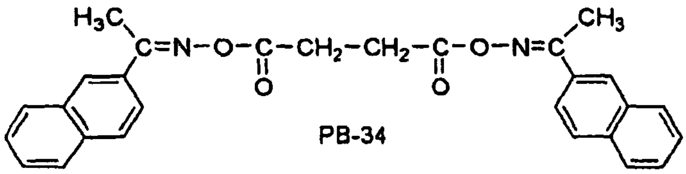

PB-34

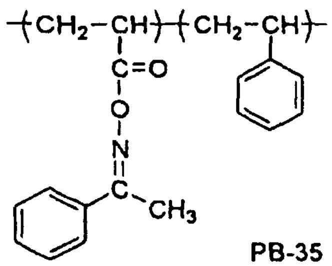

PB-35

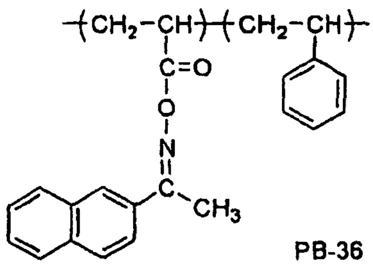

PB-36

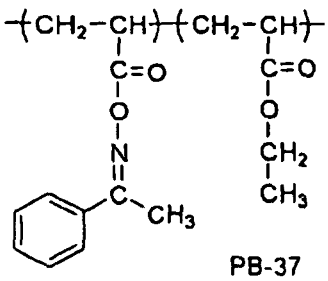

PB-37

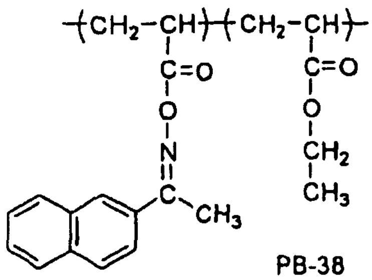

PB-38

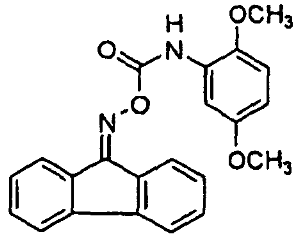

PB-39

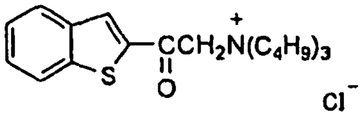

| | $Cl^-$ |
|---|---|
| PB-40 | 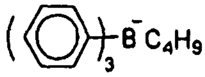 |
| PB-41 | 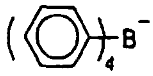 |
| PB-42 | $^-BF_4$ |

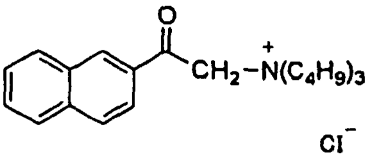

| | $Cl^-$ |
|---|---|
| PB-43 | 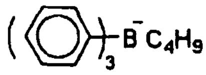 |
| PB-44 | 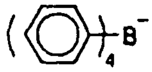 |

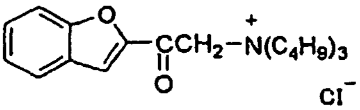

| | $Cl^-$ |
|---|---|
| PB-45 | 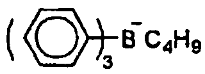 |
| PB-46 | 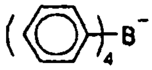 |

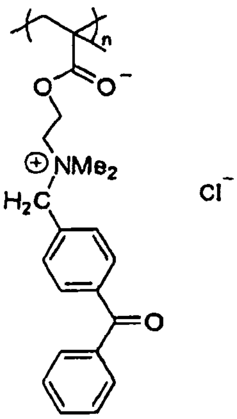

| | $Cl^-$ |
|---|---|
| PB-47 | 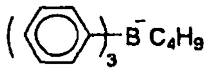 |
| PB-48 | 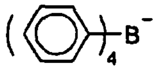 |

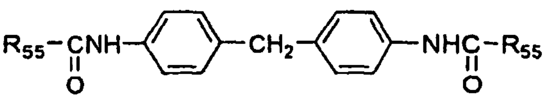

| | $R_{55}$ |
|---|---|
| PB-49 | $-H$ |
| PB-50 | $-CH_3$ |
| PB-51 | 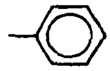 |

$[Co(III)(NH_3)_5Br](ClO_4)_2$ PB-52

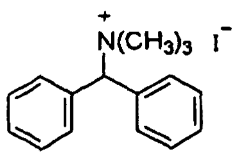

PB-53

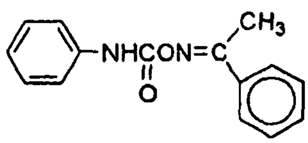

PB-54

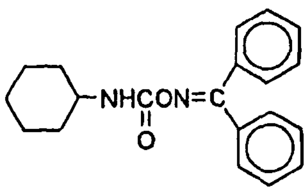

PB-55

The nucleophilic agent generator of the invention will be further described hereinafter. The term "nucleophilic agent generator" as used herein is meant to indicate a compound which can release a nucleating agent when energy

transfer or electron transfer from excited state of sensitizing dye or discolorable dye causes the severance of the bond or the like. The nucleophilic agent generator preferably stays stable in the dark. The nucleophilic agent generator of the invention is preferably a compound which can generate a nucleophilic agent upon the transfer of electron from excited state of sensitizing dye or discolorable dye.

Preferred examples of the nucleophilic agent thus generated include carbon anion, oxygen anion, sulfur anion, nitrogen, and halogen atom (chlorine, bromine, iodine).

Specific preferred examples of the nucleophilic agent generator of the invention will be given below, but the invention is not limited thereto.

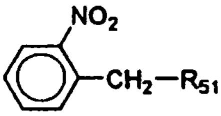

| | $R_{51}$ |
|---|---|
| N-1 | $-SCH_2COOC_2H_5$ |
| N-2 | 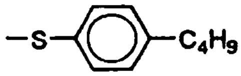 |
| N-3 | 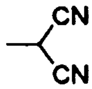 |
| N-4 | $-OC_4H_9$ |
| N-5 | $-I$ |
| N-6 | 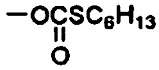 |
| N-7 | 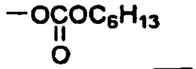 |
| N-8 | 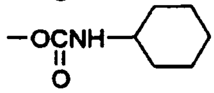 |
| N-9 | 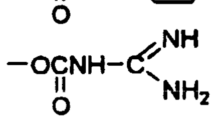 |

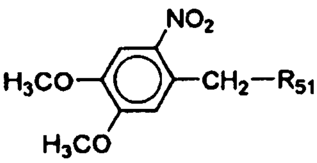

| | $R_{51}$ |
|---|---|
| N-10 | $-SCH_2COOC_4H_9$ |
| N-11 | 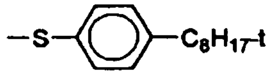 |
| N-12 | 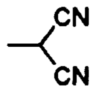 |
| N-13 | $-I$ |

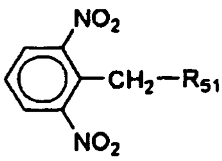

| | $R_{51}$ |
|---|---|
| N-14 | $-SC_6H_{13}$ |
| N-15 | 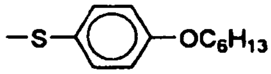 |
| N-16 | 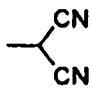 |
| N-17 | $-I$ |
| N-18 | 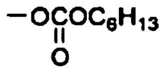 |
| N-19 | 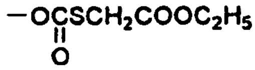 |

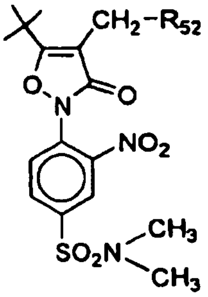

| | $R_{52}$ |
|---|---|
| N-20 | $-SCH_2COOC_2H_5$ |
| N-21 | 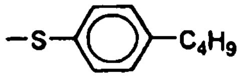 |
| N-22 | 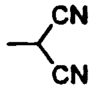 |
| N-23 | $-OC_4H_9$ |
| N-24 | $-I$ |
| N-25 | 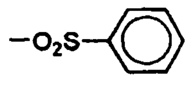 |
| N-26 | 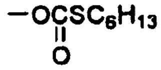 |
| N-27 | 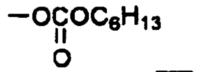 |
| N-28 | 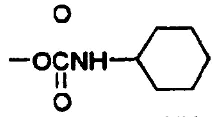 |
| N-29 | 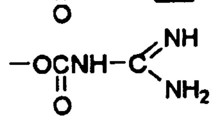 |

The electrophilic agent generator of the invention will be further described hereinafter. The term " electrophilic agent generator" as used herein is meant to indicate a compound which can generate an electrophilic agent upon the energy transfer or electron transfer from excited state of sensitizing dye or discolorable dye. The electrophilic agent generator preferably stays stable in the dark. The electrophilic agent generator of the invention is preferably a compound which can generate an electrophilic agent upon the electron transfer from excited state of sensitizing dye or discolorable dye. Preferred examples of the electrophilic agent thus generated include alkyl cation, and aryl cation.

Preferred examples of the electrophilic agent generator of the invention include diaryl iodonium salts, sulfonium salts and diazonium salts exemplified above as acid generator capable of generating phenyl cation, etc.

The hologram recording material of the invention is preferably subjected to a hologram recording method, which comprises a first step at which the sensitizing dye having absorption at hologram exposure wavelength absorbs light during hologram exposure to generate excited state in which the discolorable dye having a molar absorptivity of 1,000 or less, preferably 100 or less, most preferably 0 is discolored whereby the discolorable dye left undiscolored forms a latent image and a second step at which the latent image of discolorable dye left undiscolored is irradiated with light having a wavelength different from that used for hologram exposure to cause polymerization by which an interference band is recorded as refractive index modulation (referred to as "remaining discolorable dye latent image-latent image-sensitized polymerization process"), to advantage from the standpoint of high speed recording, adapatability to multiplexed recording, storage properties after recording, etc.

The term "latent image" as used herein is meant to indicate that the refractive index difference formed after the second step is preferably one second or less (that is, magnification or 2 or more is preferably effected at the second step), more preferably one fifth or less, even more preferably one tenth or less, most preferably one thirtieth or less (that is, magnification of 5 or more, more preferably 10 or more, most preferably 30 or more is effected at the second step).

The "remaining discolorable dye latent image- latent image-sensitized polymerization process" hologram recording method preferably comprises a first step at which the sensitizing dye having absorption at hologram exposure wavelength absorbs light during hologram exposure to generate excited state in which it then undergoes energy transfer or electron transfer with the discoloring agent precursor to cause the discoloring agent precursor to generate a discoloring agent which then discolors the discolorable dye whereby the discolorable dye left undiscolored forms a latent image and a second step at which the latent image of discolorable dye left undiscolored is irradiated with light having a wavelength different from that used for hologram exposure to cause energy transfer or electron transfer by which a polymerization initiator is activated to cause polymerization by which an interference band is recorded as refractive index modulation.

The second step preferably involves either or both of the irradiation with light and the application of heat, more

preferably the irradiation with light. The irradiation with light preferably involves entire exposure (so-called solid exposure, blanket exposure or non-imagewise exposure).

Preferred examples of the light source to be used herein include visible light laser, ultraviolet laser, infrared laser, carbon arc, high voltage mercury vapor lamp, xenon lamp, metal halide lamp, fluorescent lamp, tungsten lamp, LED, and organic EL. In order to irradiate the hologram recording material with light having a specific wavelength, a sharp cut filter, band pass filter, diffraction grating or the like is preferably used as necessary.

The light beam emitted at the second step preferably has a wavelength range different from hologram exposure wavelength at which the sensitizing dye exhibits a molar absorptivity of 5,000 or less, more preferably 1,000 or less, even more preferably 500 or less.

Further, the light beam emitted at the second step preferably has a wavelength range different from hologram exposure wavelength at which the discolorable dye exhibits a molar absorptivity of 1,000 or more.

Moreover, the discolorable dye preferably has absorption maxima in the range of from hologram reproducing light wavelength to wavelength of 200 nm less than hologram reproducing light wavelength.

Further, the compound group for hologram recording material allowing the aforementioned hologram recording method preferably contains at least the following compounds.

1) A sensitizing dye which absorbs light during hologram exposure at the first step to generate excited state;
2) A discolorable dye having a molar absorptivity of 1,000 or less capable of performing direct electron transfer or energy transfer to the discoloring agent precursor from excited state of sensitizing dye to undergo discoloration at the first step (preferably including a discoloring agent precursor capable of performing electron transfer or energy transfer from excited state of sensitizing dye to generate a discoloring agent precursor at the first step in the case where electron or energy moves to the discoloring agent precursor; The discolorable dye optionally also act as polymerization initiator (3));
3) A polymerization initiator capable of performing electron transfer or energy transfer from excited state of remaining discolorable dye to initiate the polymerization of a polymerizable compound at the second step;
4) A polymerizable compound; and
5) A binder.

Preferred examples of the sensitizing dye and the discolorable dye are as exemplified above.

Referring to the polymerizable compound and the binder, the binder preferably has a refractive index different from that of the polymerizable compound. In order to enhance the refractive index modulation, it is preferred that the refractive index difference between the polymerizable compound and the binder in bulky form be great, more preferably 0.01 or more, even more preferably 0.05 or more, particularly 0.1 or more.

To this end, it is preferred that one of the polymerizable compound or the binder contain at least one aryl group, aromatic heterocyclic group, chlorine atom, bromine atom, iodine atom and sulfur atom and the other be free of these groups or atoms. Either the polymerizable compound or the binder may have a greater refractive index than the other.

The term "polymerizable compound" as used herein is meant to indicate a compound which can undergo addition polymerization with a radical, acid (Bronsted acid or Lewis acid) or base (Bronsted base or Lewis base) generated when the sensitizing dye (or coloring material) or polymerization initiator with light to form an oligomer or polymer.

The polymerizable compound of the invention may be monofunctional or polyfunctional, may be of one-component system or multi-component system or may be a monomer, prepolymer (e.g., dimer, oligomer) or mixture thereof, preferably monomer.

The polymerizable compound may stay liquid or solid at room temperature but is preferably a liquid having a boiling point of 100°C or more or a mixture of a liquid monomer having a boiling point of 100°C or more and a solid monomer.

The polymerizable compound of the invention can be roughly divided into radical-polymerizable compound and cationically- or anioniocally-polymerizable compound.

Preferred examples of the radical-polymerizable compound and the cationically- or anioniocally- polymerizable compound will be described hereinafter in connection with the two groups: A) case where the refractive index of polymerizable compound is greater than that of binder and B) case where the refractive index of binder is greater than that of polymerizable compound.

A) Preferred examples of radical-polymerizable compound having a greater refractive index than binder

In this case, the radical-polymerizable compound preferably has a high refractive index. The high refractive index radical-polymerizable compound of the invention is preferably a compound having at least one ethylenically-unsaturated double bond per molecule and at least one aryl group, aromatic heterocyclic group, chlorine atom, bromine atom, iodine atom or sulfur atom per molecule, more preferably a liquid having a boiling point of 100°C or more.

Specific examples of the radical-polymerizable compound include the following monomers and prepolymers

(dimer, oligomer) comprising these polymerizable monomers.

Preferred examples of the high refractive index radical-polymerizable monomer include styrene, 2-chlorostyrene, 2-bromostyrene, methoxystyrene, phenyl acrylate, p-chlorophenyl acrylate, 2-phenylethyl acrylate, 2-phenoxyethyl acrylate, 2-phenoxyethyl methacrylate, 2-(p-chlorophenoxy)ethyl acrylate, benzyl acrylate, 2-(1-naphthyloxy)ethyl acrylate, 2,2-di(p-hydroxyphenyl)propane diacrylate, 2,2-di(p-hydroxyphenyl)propane dimethacrylate, di(2- methacryloxyethyl)ether of bisphenol A, di(2-acryloxy ethyl)ether of bisphenol A, di(2-methacryloxy)ether of tetrachloro-bisphenol A, di(2-methacryloxy)ether of tetrabromo-bisphenol A, 1,4-benzenediol dimethacrylate, and 1,4-diisopropenylbenzene. Even more desirable among these compounds are 2-phenoxyethyl acrylate, 2-phenoxyethyl methacrylate, 2-(p-chlorophenoxy)ethyl acrylate, p-chlorophenyl acrylate, phenyl acrylate, 2-phenylethyl acrylate, di(2-acryloxyethyl)ether of bisphenol A, and 2-(1-naphthyloxy)ethyl acrylate.

The preferred polymerizable compound is a liquid but may be used in admixture with a second solid polymerizable compound such as N-vinylcarbazole, 2- naphthyl acrylate, pentachlorophenyl acryate, 2,4,6- tribromophenyl acrylate, disphenol A diacrylate, 2-(2-naphthyloxy)ethyl and N-phenylmaleimide.

B) Preferred examples of radical-polymerizable compound having a smaller refractive index than binder

In this case, the radical-polymerizable compound preferably has a low refractive index. The low refractive index radical-polymerizable compound of the invention preferably has at least one ethylenically-unsaturated double bond per molecule but is free of aryl group, aromatic heterocyclic group, chlorine atom, bromine atom, iodine atom and sulfur atom.

The radical-polymerizable compound of the invention is preferably a liquid having a boiling point of 100°C or more.

Specific examples of the radical-polymerizable compound of the invention include the following polymerizable monomers and prepolymers (dimer, oligomer, etc.) comprising these polymerizable monomers.

Preferred examples of the low refractive index radical-polymerizable compound employable herein include t-butyl acrylate, cyclohexyl acrylate, isobornyl acrylate, 1,5-pentanediol diacrylate, ethylene glycol diacrylate, 1,4-butanediol diacrylate, diethylene glycol diacrylate, hexamethylene glycol diacrylate, 1,3-propanediol diacrylate, decamethylene glycol diacrylate, 1,4-cyclohexyldiol diacrylate, 2,2-dimethylolpropane diacrylate, glycerol diacrylate, trimethylolpropane diacrylate, pentaerythritol triacrylate, pentaerythritol tetraacrylate, triethylene glycol diacrylate, triethylene glycol dimethacrylate, ethylene glycol dimethacrylate, 1,3- propanediol dimethacrylate, 1,2,4-butanetriol trimethacrylate, 2,2,4-trimethyl-1,3-propanediol dimethacrylate, pentaerythritol trimethacrylate, pentaerythritol tetramethacrylate, trimethylolpropane trimethacrylate, 1,5-pentanediol dimethacrylate, diallyl fumarate, 1H,1H-perflurooctyl acrylate, 1H,1H, 2H,2H-perfluorooctyl methacrylate, 1H,1H, 2H,2H-perfluorooctyl acrylate, and 1-vinyl-2- pyrrolidone. More desirable among these low refractive index radical-polymerizable compounds are decanediol diacrylate, isobornyl acrylate, triethylene glycol diacrylate, diethylene glycol diacrylate, triethylene glycol diemethacrylate, ethoxyethoxy acrylate, triacrylate ester of ethoxylated trimethylopropane, and 1-vinyl-2-pyrrolidine. Even more desirable among these low refractive index radical-polymerizable compounds are decanediol diacrylate, isobornyl acrylate, triethylene glycol diacrylate, diethylene glycol diacrylate, triethylene glycol diemethacrylate, ethoxyethoxy acrylate, 1H,1H-perflurooctyl acrylate, 1H,1H,2H,2H-perfluorooctyl methacrylate, 1H,1H, 2H,2H-perfluorooctyl acrylate, and 1-vinyl-2- pyrrolidone.

The preferred polymerizable compound is a liquid but may be used in admixture with a second solid polymerizable compound monomer such as N- vinylcaprolactam.

The term "cationically-polymerizable compound" as used herein is meant to indicate a compound which begins polymerization with an acid generated when the sensitizing dye and the cation polymerization initiator are irradiated with light. The term "anionically-polymerizable compound" as used herein is meant to indicate a compound which begins polymerization with a base generated when the sensitizing dye and the anion polymerization initiator are irradiated with light.

The cationically-polymerizable compound of the invention is preferably a compound having at least one oxirane ring, oxethanone ring, vinylether group or N- vinylcarbazole moiety, more preferably N- vinylcarbazole moiety per molecule.

The anionically-polymerizable compound of the invention is preferably a compound having at least one oxirane ring, oxethanone ring, vinylether group, N-vinyl carbazole moiety, ethylenic double bond moiety provided with an electrophilic substituent, lactone moiety, lactam moiety, cyclic urethane moiety, cyclic urea moiety or cyclic siloxane moiety per molecule, more preferably oxirane ring moiety.

A) Preferred examples of cationically- or anionically- polymerizable compound having a greater refractive index than binder

In this case, the cationically- or anionically- polymerizable compound preferably has a high refractive index. The high refractive index cationically- or anionically-polymerizable compound of the invention is preferably a compound

having at least one oxirane ring, oxethanone ring, vinylether group or N-vinylcarbazole moiety per molecule and at least aryl group, aromatic heterocyclic group, chlorine atom, bromine atom, iodine atom or sulfur atom per molecule, more preferably at least one aryl group. The cationically- or anionically-polymerizable compound of the invention is preferably a liquid having a boiling point of 100°C or more.

Specific examples of the cationically- or anionically-polymerizable compound of the invention include the following polymerizable monomers and prepolymers (dimer, oligomer, etc.) comprising these polymerizable monomers.

Preferred examples of the high refractive index cationically- or anionically-polymerizable monomers having oxirane ring include phenylglycidyl ether, phthalic acid diglycidyl ester, trimellitic acid triglycidyl ester, resorcine diglycidyl ether, dibromophenyl glycidyl ether, dibromoneopentyl glycol diglycidyl ether, 4,4'-bis(2,3-epoxypropoxyperfluoro isopropyl)diphenyl ether, p-bromostyrene oxide, bisphenol-A-diglycidyl ether, tetrabromobisphenol-A- diglycidyl ether, bisphenol-F-diglycidyl ether, and 1,3-bis(3',4'-epoxycyclohexyl)ethyl)-1,3,-diphenyl-1,3,-dimethyldisiloxane.

Specific examples of the high refractive index cation or anionically-polymerizable monomer having oxethanone ring include compounds obtained by replacing the oxirane ring in the specific examples of the high refractive index cation or anionically-polymerizable monomer having oxirane ring by oxethanone ring.

Specific examples of the high refractive index cationically- or anionically-polymerizable monomer having vinylether group moiety include vinyl-2-chloroethyl ether, 4-vinyletherstyrene, hydroquinone divinyl ether, phenylvinyl ether, bisphenol A divinyl ether, tetrabromobisphenol A divinyl ether, bisphenol F divinyl ether, phenoxyethylenevinyl ether, and p- bromophenoxyethylenevinyl ether.

Further preferred examples of the high refractive index cationically-polymerizable monomer include N- vinylcarbazole.

B) Preferred examples of cationically- or anionically- polymerizable compound having a smaller refractive index than binder

In this case, the cationically- or anionically- polymerizable compound preferably has a low refractive index. The low refractive index cationically- or anionically-polymerizable compound of the invention is preferably a compound having at least one oxirane ring, oxethanone ring, vinylether group or N-vinylcarbazole moiety per molecule but free of aryl group, aromatic heterocyclic group, chlorine atom, bromine atom, iodine atom and sulfur atom. The cationically- or anionically- polymerizable compound of the invention is preferably a liquid having a boiling point of 100°C or more.

Specific examples of the cationically- or anionically-polymerizable compound of the invention include the following polymerizable monomers and prepolymers (dimer, oligomer, etc.) comprising these polymerizable monomers.

Specific examples of the low refractive index cationically- or anionically-polymerizable monomer having oxirane ring include glyceroldiglycidyl ether, glyceroltriglycidyl ether, pentaerythritol polyglycidyl ether, trimethylolpropanetriglycidyl ether, 1,6-hexanediolglycidyl ether, ethylene glycol diglycidyl ether, ethylene glycol monoglycidyl ether, propylene glycol diglycidyl ether, neopentyl glycol diglycidyl ether, adipic acid diglycidyl ester, 1,2,7,8- diepoxyoctane, 1,6-dimethylolperfluorohexane diglycidyl ether, vinyl cyclohexene dioxide, 3,4- epoxycyclohexylmethyl-3',4'-epoxycyclohexane carboxylate, 3,4-epoxycyclohexyloxirane, bis(3,4- epoxycyclohexyl)adipate, 2,2-bis[4-(2,3-epoxypropoxy) cyclohexyl]hexafluoropropane, 2-(3,4-epoxycyclohexyl) -3',4'-epoxy-1,3-dioxane-5-spirocyclohexane, 1,2-ethylenedioxy-bis(3,4-epoxycyclohexylmethane), ethyleneglycol-bis(3,4-epoxycyclohexanecarboxylate), bis-(3,4-epoxycyclohexylmethyl)adipate, di-2,3- epoxycyclopentyl ether, vinyl glycidyl ether, allyl glycidyl ether, 2-ethylhexyl glycidyl ether, and 1,3-bis(3',4'-epoxycyclohexyl)ethyl)-1,1,3,3- tetramethyldisiloxane.

Specific examples of the low refractive index cationically- or anionically-polymerizable monomer having oxathanone ring include compounds obtained by replacing the oxirane ring in the aforementioned specific examples of low refractive index cationically- or anionically-polymerizable monomer having oxirane ring by oxethanone ring.

Specific examples of the low refractive index cationically- or anionically-polymerizable monomer having vinylether group moiety include vinyl-n-butylether, vinyl-t-butylether, ethylene glycol divinyl ether, ethylene glycol monovinyl ether, propylene glycol divinyl ether, neopentyl glycol divinyl glycol, glycerol divinyl ether, glycerol trivinyl ether, triethylene glycol divinyl ether, trimethylol propane monovinyl ether, trimethylol propane divinyl ether, trimethylol propane trivinyl ether, allyl vinyl ether, 2,2-bis(4-cyclohexanol)propanol divinyl ether, and 2,2- bis(4-cyclohexanol)trifluoropropane divinyl ether.

Specific preferred examples of the binder to be used in recording of interference band by polymerization reaction will be described hereinafter in connection with the two groups: A) case where the refractive index of polymerizable compound is greater than that of binder and B) case where the refractive index of binder is greater than that of polymerizable compound. A) Preferred examples of binder having a smaller refractive index than polymerizable compound

In this case, the binder preferably has a low refractive index. The binder of the invention is preferably a binder free of aryl group, aromatic heterocyclic group, chlorine atom, bromine atom, iodine atom and sulfur atom.

Specific preferred examples of the low refractive index binder include acrylates, $\alpha$-alkyl acrylates, acidic polymers, interpolymers (e.g., polymethacrylic acid methyl, polymethacrylic acid ethyl, copolymer of methyl methacylate with

other (meth)acrylic acid akylesters), polyvinylesters (e.g., polyvinyl acetate, polyacetic acid/acrylic acid vinyl, polyacetic acid/ methacrylic acid vinyl, hydrolyzable polyvinyl acetate), ethylene/vinyl acetate copolymers, saturated and unsaturated polyurethanes, butadiene polymers and copolymers, isoprene polymers and copolymers, high molecular polyethylene oxides of polyglycol having an average molecular weight of from about 4,000 to 1,000,000, epoxy compounds (e.g., epoxylated compounds having acrylate or methacrylate), polyamides (e.g., N-methoxy methylpolyhexamethylene adipamide), cellulose esters (e.g., cellulose acetate, cellulose acetate succinate, cellulose acetate butyrate), cellulose ethers (e.g., methyl cellulose, ethyl cellulose, ethylbenzeyl cellulose), polycarbonates, polyvinyl acetals (e.g., polyvinyl butyral, polyvinyl formal), polyvinyl alcohols, and polyvinyl pyrrolidones.

Further preferred examples of the low refractive index binder include fluorine atom-containing polymers. A preferred example of the fluorine atom-containing polymers is an organic solvent-soluble polymer comprising a fluoroolefin as an essential component and one or more unsaturated monomers selected from the group consisting of alkylvinyl ether, alicyclic vinyl ether, hydroxyvinyl ether, olefin, haloolefin, unsaturated carboxylic acid, ester thereof and carboxylic acid vinyl ester as copolymerizable components. The fluorine atom-containing polymer preferably has a weight-average molecular weight of from 5,000 to 200,000 and a fluorine atom content of from 5 to 70% by weight.

Specific examples of the aforementioned fluorine atom-containing polymer include Lumiflon® Series (e.g., Lumiflon LF200; weight-average molecular weight: approx. 50,000, produced by Asahi Glass Co., Ltd.), which are organic solvent-soluble fluorine atom-containing polymers having hydroxyl group. Besides these products, organic solvent-soluble fluorine atom-containing polymers have been marketed by DAIKIN INDUSTRIES, LTD., Central Glass Co., Ltd., Penwalt Corp., etc. These products, too, can be used.

Further preferred examples of the fluorine atom- containing polymer include silicon compounds such as pioly (dimethylsiloxane) and silicon oil free of aromatic group.

Besides the aforementioned compounds, epoxy oligomer compounds free of aromatic groups can be used as low refractive index reactive binders. B) Preferred examples of binder having a greater refractive index than polymerizable compound

In this case, the binder preferably has a high refractive index. The binder of the invention is preferably a binder containing at least one aryl group, aromatic heterocyclic group, chlorine atom, bromine atom, iodine atom or sulfur atom, more preferably aryl group.

Specific preferred examples of the high refractive index binder include polystyrene polymers, acrylonitrile, maleic anhydride, acrylic acid, methacrylic acid, methacrylic acid ester copolymer, vinylidene chloride copolymer (e.g., vinylidene chloride/acrylonitrile copolymer, vinylidene chloride/ methacrylate copolymer, vinylidene/vinyl acetate copolymer), polyvinyl chloride copolymer (e.g., polyvinyl chloride/acetate, vinyl chloride/ acrylonitrile copolymer), polyvinyl benzal synthetic rubber (e.g., butadiene/acrylonitrile copolymer, acrylonitrile/butadiene/styrene copolymer, methacrylate/ acrylonitrile/butadiene/styrene copolymer, 2-chlorobutadiene-1,3-polymer, chlorinated rubber, styrene/butadiene/styrene, styrene/isoprene/ styrene block copolymer), polymethylene glycol of copolyester (represented, e.g., by the general formula $HO(CH_2)_nOH$ (in which n is an integer of from 2 to 10), those produced from the reaction product of (1) hexahydroterephthalic acid, sebacic acid and terephthalic acid, (2) terephthalic acid, isophthalic acid and sebacic acid, (3) terephthalic acid and sebacic acid, (4) terephthalic acid and isophthalic acid, (5) the glycol and mixture of copolyesters produced from (i) terephthalic acid, isophthalic acid and sebacic acid and (ii) terephthalic acid, isphthalic acid, sebacic acid and adipic acid, poly-N-vinylcarbazole, copolymer thereof, and polycarbonate made of carboxylic acid ester and bisphenol.

Further preferred examples of the high refractive index binder include silicon compounds such as poly (methylphenylsiloxane) and 1,3,5-trimethyl-1,1,3,5,5-pentaphenyltrisiloxane and silicon oil containing much aromatic groups.

Besides these compounds, epoxy oligomer compounds containing much aromatic groups can be used as high refractive index reactive binder.

Preferred examples of the polymerization initiator include ketone-based, organic peroxide-based, trihalomethyl-substituted triazine-based, diazonium salt-based, diaryl iodonium salt-based, sulfonium salt- based, borate-based, diaryl iodonium-organic boron complex-based, sulfonium-organic boron complex-based, cationic sensitizing dye-organic boron complex-based, anionic sensitizing dye-onium salt complex-based, metal -allene complex-based and sulfonic acid ester-based radical polymerization initiators (radical generators), cationic polymerization initiators (acid generators) and radical polymerization-cationic polymerization initiators. Preferred examples of these polymerization initiators include those exemplified as acid generators and radical generators with reference to discoloring agent precursor.

Specific preferred examples of polymerization initiators, polymerizable compounds and binders include those exemplified in Japanese Patent Application No. 2004-238932.

An acid proliferator is preferably used to enhance sensitivity. Preferred examples of the acid proliferator employable herein include those exemplified in Japanese Patent Application No. 2003-182849.

Further, an anionic polymerization initiator and a base generator (base generator) is preferably used.

Preferred examples of the anionic polymerization initiator and base generator employable herein include those exemplified as base generators with reference to discoloring agent precursor.

Moreover, in this case, a base proliferator is preferably used to enhance sensitivity. Specific preferred examples of the base proliferator include those exemplified in Japanese Patent Application No. 2003-178083.

In the case where a radical polymerization initiator is used, the polymerizable compound to be polymerized preferably has an ethylenically-unsaturated group such as acryloyl group, methacryloyl group, styryl group and vinyl group. In the case where a cationic polymerization initiator or base generator is used, the polymerizable compound to be polymerized preferably has an oxirane ring, oxethanone ring or vinylether group.

Specific preferred examples of the polymerization initiator of the invention will be given below, but the invention is not limited thereto.

<Radical polymerization initiator (radical generator), cationic polymerization initiator (acid generator)>

I-1

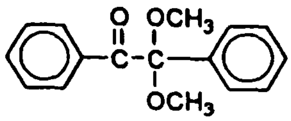

I-2

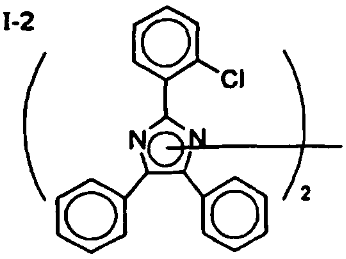

I-3

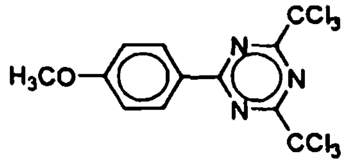

I-4

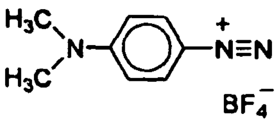

I-5

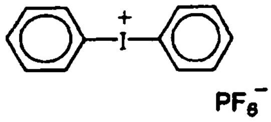

I-6

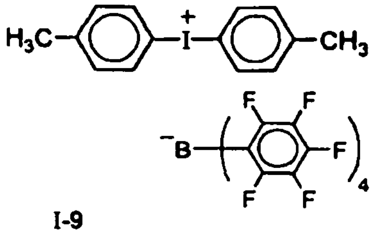

I-7

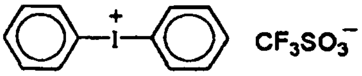

I-8

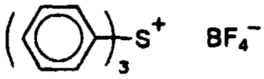

I-9

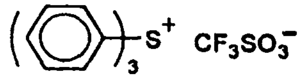

I-10

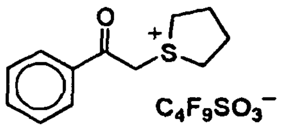

I-11

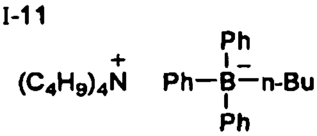

I-12

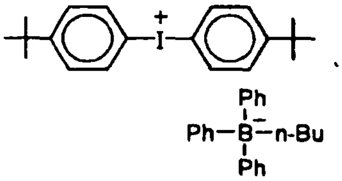

I-13

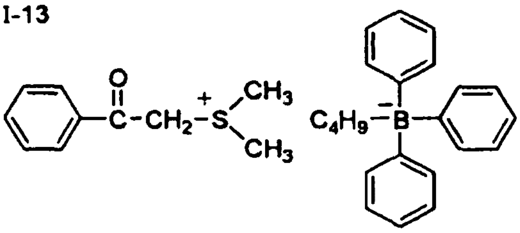

I-14

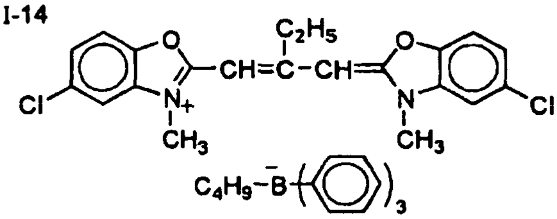

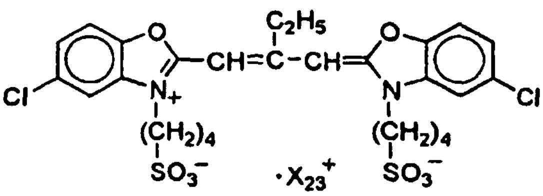

| | $X_{23}^{+}$ | |
|---|---|---|
| I-15 | 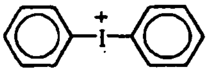 | (=C-1) |
| I-16 | 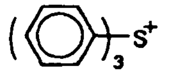 | (=C-2) |
| I-17 | 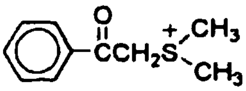 | (=C-3) |

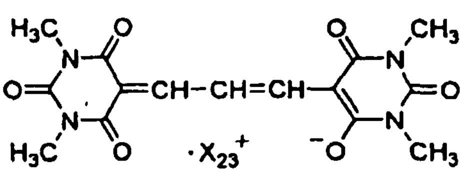

| | $X_{23}^{+}$ |
|---|---|
| I-18 | C-1 |
| I-19 | C-2 |
| I-20 | C-3 |

I-21

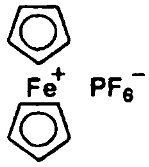

I-22

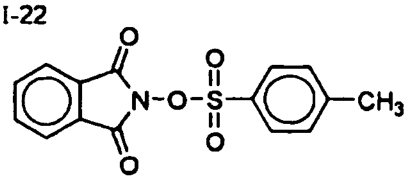

I-23

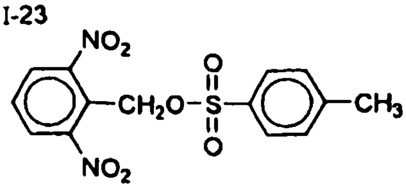

Anionic polymerization initiator (base generator)

PB-1

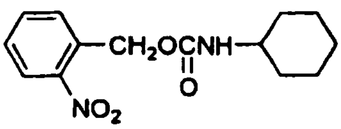

PB-2

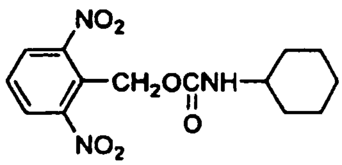

PB-3

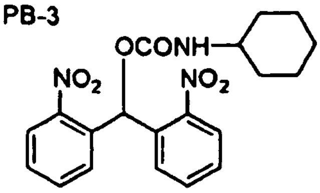

PB-4

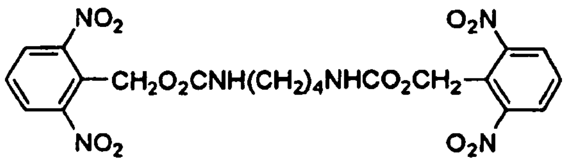

PB-5

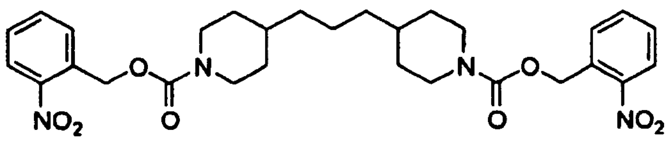

PB-6

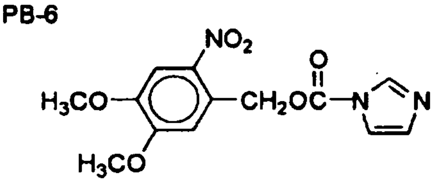

PB-7

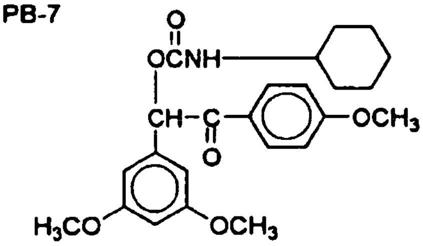

PB-8

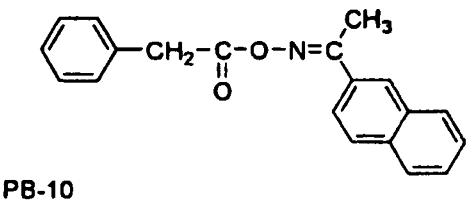

PB-9

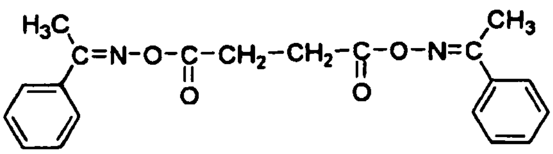

PB-10

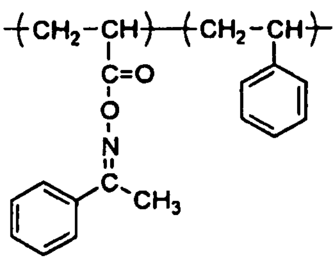

PB-11

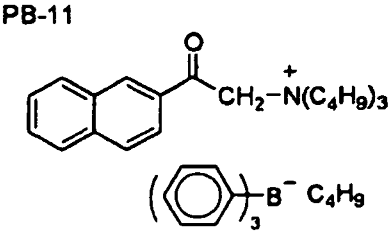

PB-12

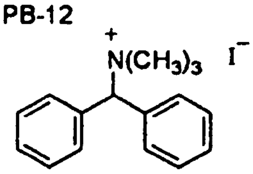

In the "remaining discolorable dye latent image- latent image sensitization process" of the invention, it is also

preferred that the discoloring agent precursor and the polymerization initiator partly or wholly act as each other.

In the case where a discolorable dye is added in addition to sensitizing dye, when the discoloring agent precursor and the polymerization initiator are different from each other (e.g., when the discoloring agent precursor is an acid generator or base general formula and the polymerization initiator is a radical polymerization initiator or when the discoloring agent precursor is a radical generator or nucleophilic agent generator and the polymerization initiator is an acid generator or base generator), it is preferred that the sensitizing dye can perform electron transfer sensitization only on the discoloring agent precursor and the polymerization initiator can perform electron transfer sensitization only by the discolorable dye.

In the hologram recording method of the invention and the hologram recording material allowing the recording method, it is preferred from the standpoint of storage properties and non-destructive reproducibility that the sensitizing dye be decomposed and fixed at the first step, the second step or the subsequent fixing step involving either or both of irradiation with light and application of heat. It is more desirable that the sensitizing dye be decomposed and fixed at the first step, the second step or the subsequent fixing step involving either or both of irradiation with light and application of heat and the remaining discolorable dye be decomposed and fixed at the second step or the subsequent fixing step involving either or both of irradiation with light and application of heat.

The concept of "remaining discolorable dye latent image-latent image sensitization process" will be described hereinafter.

For example, the hologram recording material is irradiated with YAG·SHG laser beam having a wavelength of 532 nm so that the laser beam is absorbed by the sensitizing dye to generate excited state. Energy or electron is then moved from the excited state of sensitizing dye to the discoloring agent precursor to generate a discoloring agent by which the discolorable dye is then discolored. As a result, a latent image can be formed by the remaining discolorable dye (first step). Subsequently, the hologram recording material is irradiated with light beam having a wavelength of from 360 nm to 420 nm so that the light beam is absorbed by the remaining discolorable dye. Then, electron or energy is moved to the polymerization initiator to activate the polymerization initiator to initiate polymerization. For example, when the polymerizable compound has a smaller refractive index than the binder, the polymerizable compound gathers at the polymerization area, causing the drop of refractive index (second step). At the area which has become a bright interference area at the first step, there is less remaining discolorable dye forming a latent image. Therefore, little polymerization occurs in the bright interference area at the second step. Thus, the proportion of binder is higher in the bright interference area. As a result, a great refractive index modulation can be performed between the bright interference area and the dark interference area. The refractive index modulation can be recorded as interference band. So far as the sensitizing dye and remaining discolorable dye can be decomposed and discolored at the first and second steps or the subsequent fixing step, a hologram recording material excellent in non-destructive reproduction and storage properties can be provided.

For example, when the hologram recording material having data, image, etc. recorded thereon is again irradiated with a laser beam having a wavelength of 532 nm, the data, image, etc. can be reproduced. Alternatively, the hologram recording material of the invention can act as a desired optical material.

The hologram recording material of the invention may further comprise additives such as electron-donating compound, electron-accepting compound, chain transfer agent, crosslinking agent, heat stabilizer, plasticizer and solvent incorporated therein besides the aforementioned sensitizing dye, discolorable dye, discoloring agent precursor, polymerization initiator, polymerizable compound, binder, etc. as necessary.

The electron-donating compound is capable of reducing the radical cation in the sensitizing dye. The electron-accepting compound is capable of oxidizing the radical anion in the sensitizing dye. Thus, both the electron-donating compound and the electron-accepting compound are capable of reproducing the sensitizing dye. Specific preferred examples of these compounds include those exemplified in Japanese Patent Application No. 2004-238077.

In particular, the electron-donating compound is useful for the enhancement of sensitivity because it can rapidly reproduce the sensitizing dye radical cation produced by the transfer of electron to the dye precursor group. As the electron-donating compound there is preferably used one having a more negative oxidation potential than sensitizing dye. Specific preferred examples of the electron-donating compound will be given below, but the invention is not limited thereto.

Examples of electron-donating compound for reproduction of sensitizing dye

A-1

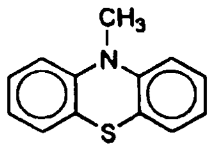

A-2

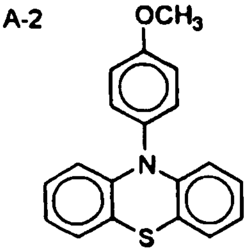

A-3

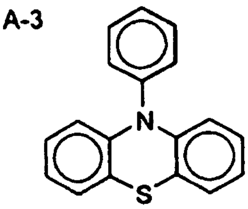

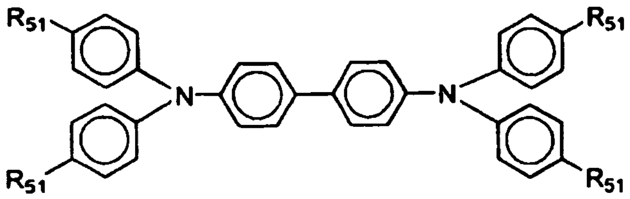

| | $R_{51}$ |
|---|---|
| A-4 | H |
| A-5 | $-OCH_3$ |

A-6

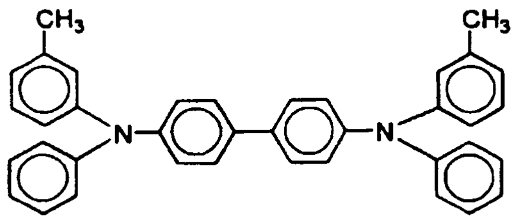

A-7

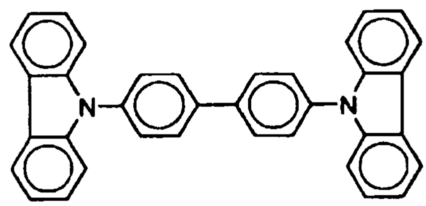

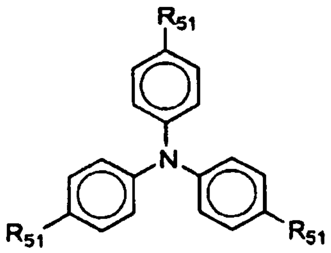

| | $R_{51}$ |
|---|---|
| A-8 | H |
| A-9 | $-CH_3$ |
| A-10 | $-OCH_3$ |

A-11

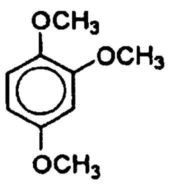

A-12

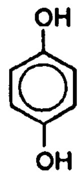

A-13

$(C_4H_9)_4\overset{+}{N}\ I^{-}$

A-14

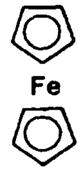

Particularly preferred examples of the electron- donating compound include phenothiazine-based compounds (e.g., 10-methylphenothiazine, 10-(4'-methoxyphenyl) phenothiazine), triphenylamine-based compounds (e.g., triphenylamine, tri(4'-methoxyphenyl)amine), and TPD- based compounds (e.g., TPD). Most desirable among these electron-donating compounds are phenothiazine-based compounds.

Specific preferred examples of chain transfer agent, crosslinking agent, heat stabilizer, plasticizer, solvent, etc. include those exemplified in Japanese Patent Application No. 2004-238392.

Preferred examples of the chain transfer agent include thiols. Examples of these thiols include 2- mercaptobenzoxazole, 2-mercaptobenzthiazole, 2- mercaptobenzimidazole, 4-methyl-4H-1,2,4-triazole-3- thiol, p-bromobenzenethiol, thiocyanuric acid, 1,4-bis(mercapto)benzene, and p-toluenethiol.

In particular, in the case where the polymerization initiator is a 2,4,5-triphenylimidazolyl dimer, a chain transfer agent is preferably used.

The hologram recording material of the invention may comprise a heat stabilizer incorporated therein to enhance

the storage properties thereof during storage.

Examples of useful heat stabilizers include hydroquinone, phenidone, p-methoxypheno, alkyl- substituted hydroquinone, alkyl-substituted quinone, aryl-substituted hydroquinone, aryl-substituted quinone, catechol, t-butylcatechol, pyrogallol, 2- naphthol, 2,6-di-t-butyl-p-cresol, phenothiazine, and chloranyl.

The plasticizer is used to change the adhesivity, flexibility, hardness and other mechanical properties of the hologram recording material. Examples of the plasticizer employable herein include triethylene glycol dicaprylate, triethylene glycol bis(2-ethylhexanoate), tetraethylene glycol diheptanoate, diethyl sebacate, dibutyl sberate, tris(2-ethylhexyl) phosphate, tricresyl phosphate, dibutyl phthalate, alcohols, and phenols.

The hologram recording material of the invention may be prepared by any ordinary method.

For the production of the film of the hologram recording material of the invention, the aforementioned binder and various components may be spread over the substrate in the form of solution in a solvent or the like using a spin coater, bar coater or the like.

Preferred examples of the solvent to be used herein include ketone-based solvents such as methyl ethyl ketone, methyl isobutyl ketone, acetone and cyclohexanone, ester-based solvents such as ethyl acetate, butyl acetate, ethylene glycol diacetate, ethyl lactate and cellosolve acetate, hydrocarbon-based solvents such as tetrahydrofurane, dioxane and diethyl ether, cellosolve-based solvents such as methyl cellosolve, ethyl cellosolve, butyl cellosolve and dimethyl cellosolve, alcohol-based solvents such as methanol, ethanol, n-propanol, 2-propanol, n-butanol and diacetone alcohol, fluorine-based solvents such as 2,2,3,3-tetrafluoropropanol, halogenated hydrocarbon- based solvents such as dichloromethane, chloroform and 1,2-dichloroethane, amide-based solvents such as N,N-dimethylformamide, and nitrile-based solvents such as acetonitrile and propionitrile.

The hologram recording material of the invention can be prepared by spreading the aforementioned coating solution directly over the substrate using a spin coater, roll coater, bar coater or the like or by casting the coating solution into a film which is then laminated on the substrate using an ordinary method.

The term "substrate" as used herein is meant to indicate an arbitrary natural or synthetic support, preferably one which can occur in the form of flexible or rigid film, sheet or plate.

Preferred examples of the substrate include polyethylene terephthalate, resin-undercoated polyethylne terephthalate, flame- or electrostatically discharged polyethylene terephthalate, cellulose acetate, polycarbonate, polymethyl methacrylate, polyester, polyvinyl alcohol, and glass.

The solvent used can be evaporated away during drying. The evaporation may be effected under heating or reduced pressure.

The film of the hologram recording material of the invention may be prepared by melting the binder comprising various components at a temperature of not lower than the glass transition temperature or melting point of the binder, and then melt-extruding or injection -molding the molten binder. During this procedure, a reactive crosslinkable binder may be used as the binder so that the binder thus extruded or molded can be crosslinked and cured to raise the strength of the film. In this case, the crosslinking reaction may involve radical polymerization reaction, cationic polymerization reaction, condensation polymerization reaction, addition polymerization reaction or the like. Alternatively, methods disclosed in JP-A-2000-250382, JP-A-2000-172154, etc. are preferably used.

Further, a method is preferably used which comprises dissolving various components in a monomer solution for forming a binder, and then subjecting the monomer to photopolymerization or photopolymerization to produce a polymer which is then used as a binder. Examples of the polymerization method employable herein include radical polymerization reaction, cationic polymerization reaction, condensation polymerization reaction, and addition polymerization reaction.

Moreover, a protective layer for blocking oxygen may be formed on the hologram recording material. The protective layer may be formed by laminating a film or sheet of a plastic such as polyolefin (e.g., polypropylene, polyethylene), polyvinyl chloride, polyvinylidene chloride, polyvinyl alcohol, polyethylene terephthalate and cellophane on the hologram recording material using an electrostatic contact method or an extrusion machine or by spreading the aforementioned polymer solution over the hologram recording material. Alternatively, a glass sheet may be laminated on the hologram recording material. Further, an adhesive or liquid material may be provided interposed between the protective layer and the photosensitive layer and/or between the substrate and the photosensitive layer to enhance airtightness.

In the case where the hologram recording material of the invention is used for holographic light memory, it is preferred from the standpoint of enhancement of S/N ratio during the reproduction of signal that the hologram recording material undergo no shrinkage after hologram recording.

To this end, it is preferred that the hologram recording material of the invention comprise an inflating agent disclosed in JP-A-2000-86914 incorporated therein or a shrinkage-resistant binder disclosed in JP-A-2000-250382, JP-A-2000-172154 and JP-A-11-344917 incorporated therein.

Further, it is preferred that the interference band gap be adjusted using a diffusion element disclosed in JP-A-3-46687, JP-A-5-204288, JP-T-9-506441, etc.

When a known ordinary photopolymer as disclosed in JP-A-6-43634, JP-A-2-3082, JP-A-3-50588, JP-A-5-107999, JP-A-8-16078, JP-T-2001-523842 and JP-T-11-512847 is subjected to multiplexed recording, the latter half of multiplexed recording is conducted on the area where polymerization has proceeded so much. Therefore, the latter half of multiplexed recording requires more exposure time to record the same signal than the former half of multiplexed recording (lower sensitivity). This has been a serious problem in system design. In other, it has been disadvantageous in that the range within which the refractive index modulation shows linear rise with respect to exposure is very narrow.

On the contrary, the "discoloration reaction process" recording method of the invention involves no polymerization during the recording of interference band. Even the "remaining discolorable dye latent image- latent image sensitization reaction process" recording method of the invention involves little polymerization reaction during hologram exposure (first step) and entire exposure causing block polymerization by which refractive index modulation is conducted at the second step.

Accordingly, much multiplexed recording can be conducted in both the processes. Further, any multiplexed recording can be conducted at a constant exposure, i.e., with a linear rise of refractive index modulation relative to exposure. Therefore, a broad dynamic range can be obtained. Thus, the discoloration process or latent image polymerization process recording method of the invention is very advantageous from the standpoint of the aforementioned adaptability to multiplexed recording.

This is advantageous from the standpoint of enhancement of capacity, simplification of recording system, enhancement of S/N ratio, etc.

As mentioned above, the hologram recording material of the invention gives drastic solution to the aforementioned problems. In particular, the hologram recording material of the invention allows quite a new recording method which attains high sensitivity, good storage properties, dry processing properties and multiplexed recording properties. The hologram recording material is particularly suited for optical recording medium (holographic optical memory).

The hologram recording material of the invention can be used as three-dimensional display hologram, holographic optical element (HOE, such as headup display (HUD) for automobile, pickup lens for optical disc, head mount display, color filter for liquid crystal, reflector for reflective liquid crystal, lens, diffraction grating, interference filter, connector for optical fiber, light polarizer for facsimile, window glass for building), cover paper for book, magazine, and display for POP, etc. The hologram recording material of the invention is preferably used for gift and credit card, paper money and packaging for the purpose of security against forgery.

[Example]

Specific examples of the invention will be described in connection with the results of experiments, but the invention is not limited thereto.

Under a red lamp, the sensitizing dye, electron- donating compound, discolorable dye, discoloring agent precursor, polymerization initiator, polymerizable compound and binder set forth in Table 1 were dissolved in methylene chloride (optionally with acetone, acetonitrile or methanol) in an amount of twice to five times the weight of these components to prepare hologram recording material compositions 401 to 404. The term "%" as used herein is meant to indicate % by weight.

Table 1

| Sample | Sensitizing dye Electrondonating compound | | Discolorable dye | | Discoloring agent precursor Polymerization initiator | | Polymerizable compound Binder |
|---|---|---|---|---|---|---|---|
| 401 | S-75 | 4% | G-37 | 4% | I-5 | 18% | M-2 37% Polymethylphenyl siloxane 37% |
| 402 | S-93 | 0.8% | G-41 | 4% | I-5 | 18% | TEGDA 33.2% |
| | A-1 | 10% | | | | | Poly(styrene-acrylonitrile) 75 : 25 34% |
| 403 | S-92 | 0.4% | G-72 | 4% | PB-2 | 18% | M-2 33.6% |
| | A-1 | 10% | ($X_{51}$ is $PF_6^-$) | | | | Polymethyl phenyl siloxane 34% |
| 404 | S-6 | 0.2% | G-91 | 13% | -- | | DDA 28% PFOA 7% |
| | A-1 | 10% | | | I-2 2.4% + MBO 1.6% | | Polystyrene 37% |

The hologram recording material compositions 401 and 404 were each spread (optionally in a multi-layer form) over a glass substrate to a thickness of about 80 μm using a blade to form a photosensitive layer which was then heated and dried at 40°C for 3 minutes to remove the solvent. The photosensitive layer was then covered by TAC layer to prepare hologram recording materials 401 to 404.

The hologram recording materials were each then exposed to YAG laser second harmonic (532 nm; output: 2W) as a light source in a two-flux optical system for transmission hologram recording shown in Fig. 1 to perform recording. The angle of the object light with respect to the reference light was 30 degrees. The light beam had a diameter of 0.6 cm and an intensity of 8 $mW/cm^2$. During exposure, the holographic exposure time was varied from 0.1 to 40 seconds (radiation energy ranging from 0.8 to 320 $mJ/cm^2$) (first step). During hologram exposure, He-Ne laser beam having a wavelength of 632 nm was passed through the center of exposed area at the Bragg angle. The ratio of diffracted light to transmitted light (relative diffraction efficiency) was then measured at real time (diffraction efficiency η after first step). These samples were each then entirely irradiated with light beam having a wavelength of from 370 nm to 410 nm (second step) to measure the diffraction efficiency (diffraction efficiency η after second step). By dividing the radiation dose required to give the maximum diffraction efficiency using only the first step rather than the second step by the radiation dose required at the first step if the second step is used, the "percent amplification" was determined. The results are set forth in Table 2.

Table 2

| Sample | Diffraction efficiency η after first step | Diffraction efficiency η after second step | % Amplification |
|---|---|---|---|
| 401 | 19% | 86% | 6.3 |
| 402 | 18 | 89 | 6.9 |
| 403 | 17 | 82 | 5.1 |
| 404 | 18 | 85 | 6.1 |

As can be seen in Table 2, when the hologram recording material of the invention is used, the radiation dose required at the first step can be reduced to one seventh to one fifth of that required when the second step is not employed. It is also made obvious that the second step allows block exposure and hence polymerization with the discolorable dye left undiscolored at the first step as a latent image, resulting in amplification of refractive index modulation that allows the reduction of the first step, i.e., enhancement of sensitivity. It goes without saying that the known hologram recording material disclosed in JP-A-6-43634 cannot undergo such amplification that allows enhancement of sensitivity.

Further, the hologram recording material of the invention shows a substantially linear rise of Δn (refractive index modulation in interference band, calculated from diffraction efficiency and layer thickness by Kugelnick's equation) with exposure ($mJ/cm^2$) both after the first and second steps and thus is favorable for multiplexed recording.

Multiplexed hologram recording was actually made on the same area of a hologram recording material of the invention 10 times at a dose corresponding to one tenth of the exposure giving the aforementioned maximum diffraction efficiency and a reference light angle varying by 2 degrees every recording job (first step). Thereafter, the hologram recording material was entirely irradiated with light beam having a wavelength of from 370 nm to 410 nm to perform recording amplification by polymerization (second step). As a result, it was confirmed that these object light beams can be reproduced by irradiating the hologram recording material with a reproducing light at an angle varying by 2 degrees. It can be thus made obvious that the hologram recording material of the invention can be subjected to multiplexed recording at the same exposure and thus is adapted for multiplexed recording. Thus, the hologram recording material of the invention allows many multiplexed recording jobs and hence high density (capacity) recording.

On the contrary, the known photopolymer process hologram recording material as disclosed in JP-A-6- 43634 was found to require more radiation dose in the latter stage of multiplexed recording than in the initial stage of multiplexed recording to perform the same recording because the polymerization of photopolymer has proceeded such that the rate of movement of monomer required for recording is reduced. Thus, the known photopolymer process hologram recording material leaves something to be desired in the enhancement of multiplexity, i.e., recording density.

On the other hand, the hologram recording method of the invention employs discoloration reaction as a means of forming a latent image rather than polymerization during hologram recording (first step) and thus is not subject to the aforementioned disadvantages. Therefore, the hologram recording method of the invention is superior to the known photopolymer process.

Even when the sensitizing dye to be used in Examples 401 to 404 were changed to S-1, S-4, S-8, S-10, S-11, S-19, S-23, S-31, S-33, S-34, S-43, S-45, S-46, S-50, S-58, S-67, S-71, S-73, S-74, S-77, S-80, S-81, S-87, S-91, S-94, S-95 or S-96, similar effects were obtained.

Further, even when the discoloring agent precursor (acid generator, optionally acid or radical polymerization initiator) to be used in Samples 401 and 402 were changed to I-3, I-4, I-6, I-7, I-8, I-9, I-10, tris(4-methylphenyl)sulfonium

tetra(pentafluorophenyl)borate, triphenylsulfonium perfluoropentanoate, bis(1-(4-diphenylsulfonium) phenylsulfide ditrifurate, dimethylphenasyl sulfonium perfluorobutane sulfonate, benzoyl tosylate, I-22 or I-23 or when the acid-discolorable dye to be used in Samples 401 and 402 were changed to G-31, G-33, G-35, G-36, G-38, G-39, G-40, G-42, G-45, G-50, G-51, G-62, G-66 or G-70, similar effects were obtained.

Further, eve when the discoloring agent precursor to be used in Sample 403 was changed to PB-3, PB-4, PB-5, PB-6, PB-7, PB-8 or PB-9 or when the base-discolorable dye to be used in Sample 403 was changed to G-71, G-82, G-84, G-86, G-87, G-88 or G-89, similar effects were obtained.

Further, even when the radical polymerization initiator to be used in Sample 404 was changed to I-1 or I-11 to I-20 or when the discolorable dye to be used in Sample 404 was changed to G-92, G-93, G-95 or G-96, similar effects were obtained.

The light beams with which the hologram recording material was entirely irradiated during the aforementioned procedure had an optimum wavelength in the respective system.

It was found that the use of the discoloring process hologram recording material and method of the invention and the remaining dye latent image-latent image sensitizing polymerization process hologram recording material and method of the invention makes it possible to perform hologram recording at a high sensitivity and a high diffraction efficiency with a linear rise of diffraction efficiency relative to exposure. Thus, the invention can be applied to holographic memory, etc. to advantage from the standpoint of transfer rate, multiplexed recording properties, etc.

## Claims

**1.** A hologram recording method using at least one discolorable dye having a molar absorptivity of 1,000 or less at hologram reproducing light wavelength, a sensitizing dye and a discoloring agent precursor in which, when subjected to hologram exposure, at least one of the sensitizing dye and the discolorable dye generates an excited state which then undergoes energy or electron transfer with the discoloring agent precursor to cause the discoloring agent precursor to generate a discoloring agent which discolors the discolorable dye, thereby forming an interference band due to refractive index modulation,

**characterised in that** in a first step, the sensitizing dye absorbs light during hologram exposure to generate an excited state which then undergoes energy transfer or electron transfer with the discoloring agent precursor to cause the discoloring agent precursor to generate a discoloring agent which discolors the discolorable dye, whereby the discolored dye and the discolorable dye left undiscolored form a latent image, and in a second step, the discolorable dye left undiscolored is irradiated with light having a wavelength different from that used for hologram exposure to cause energy transfer or electron transfer by which a polymerization initiator is activated to cause a polymerization by which the interference band is recorded as a refractive index modulation.

**2.** A hologram recording material for use in the hologram recording method as defined in claim 1.

**3.** A hologram recording material as defined in claim 2, which comprises:

1) a sensitizing dye which absorbs light during hologram exposure in the first step to generate an excited state;
2) a discoloring agent precursor capable of performing electron transfer or energy transfer with the excited state of the sensitizing dye to generate a discoloring agent;
3) a discolorable dye having a molar absorptivity of 1,000 or less capable of undergoing discoloration by the discoloring agent;
4) a polymerization initiator capable of performing electron transfer or energy transfer with an excited state of the remaining discolorable dye to initiate the polymerization of a polymerizable compound in the second step;
5) a polymerizable compound; and
6) a binder.

**4.** The hologram recording material as defined in claim 3, wherein the polymerizable compound and the binder have different refractive indexes and the photopolymerization makes the composition ratio of polymerizable compound and its polymerization product to binder different between bright interference areas and dark interference areas, allowing recording of the interference band by the refractive index modulation.

**5.** The hologram recording material as defined in claim 2, wherein any multiplexed recording can be effected always at a constant exposure.

**6.** An optical recording medium comprising a hologram recording material as defined in claim 2.

7. An optical recording medium as defined in claim 6 stored in a light-screening cartridge during storage.

8. A three-dimensional display hologram comprising a hologram recording material as defined in claim 2.

9. A holographic optical element comprising a hologram recording material as defined in claim 2.

## Patentansprüche

1. Hologrammaufzeichnungsverfahren unter Verwendung wenigstens eines entfärbbaren Farbstoffes mit einem molaren Absorptionsvermögen von 1.000 oder weniger bei der das Hologramm erzeugenden Lichtwellenlänge, eines Sensibilisierungsfarbstoff und eines Entfärbungsmittelvorläufers, bei welchen, wenn sie einer Hologrammbelichtung unterworfen werden, wenigstens eines des Sensibilisierungsfarbstofles und des entfärbbaren Farbstoffes einen angeregten Zustand erzeugt, welcher dann einer Energie-oder Elektronenübertragung mit dem Entfärbungsmittelvorläufer unterworfen wird, um zu bewirken, dass der Entfärbungsmittelvorläufer ein Entfärbungsmittel erzeugt, welches den entfärbbaren Farbstoff entfärbt, wodurch ein Interferenzband aufgrund einer Brechungsindexmodulation gebildet wird,
**dadurch gekennzeichnet, dass** in einem ersten Schritt der Sensibilisierungsfarbstoff während der Belichtung des Hologramms Licht absorbiert, um einen angeregten Zustand zu erzeugen, welcher dann eine Energieübertragung oder Elektronenübertragung mit dem Entfärbungsmittelvorläufer durchmacht, um zu bewirken, dass der Entfärbungsmittelvorläufer ein Entfärbungsmittel erzeugt, welches den entfärbbaren Farbstoff entfärbt, wodurch der entfärbt Farbstoff und der entfärbbare Farbstoff, welcher nicht entfärbt zurückgeblieben ist, ein Latentbild bilden, und in einem zweiten Schritt, der entfärbbare Farbstoff, welcher nicht entfärbt wurde, mit Licht mit einer anderen Wellenlänge, als die, welche zur Belichtung des Hologramms verwendet wird, um eine Energieübertragung oder Elektronenübertragung zu bewirken, bestrahlt wird, wodurch ein Polymerisationsinitiator aktiviert wird, um eine Polymerisation zu bewirken, durch welchen das Interferenzband als eine Brechungsindexmodulation aufgezeichnet wird.

2. Hologrammaufzeichnungsmaterial zur Verwendung bei dem Hologrammaufzeichnungsverfahren nach Anspruch 1.

3. Hologrammaufzeichnungsverfahren wie in Anspruch 2 definiert, umfassend:

    1) einen Sensibilisierungsfarbstoff, welcher Licht während der Belichtung des Hologramms in dem ersten Schritt absorbiert, um einen angeregten Zustand zu erzeugen;
    2) einen Entfärbungsmittelvorläufer, welcher in der Lage ist, eine Elektronenübertragung oder Energieübertragung mit dem angeregten Zustand des Sensibilisierungsfarbstoffes durchzuführen, um ein Entfärbungsmittel zu erzeugen;
    3) einen entfärbbaren Farbstoff mit einem molaren Absorptionsvermögen von 1.000 oder weniger, welcher geeignet ist, durch das Entfärbungsmittel entfärbt zu werden;
    4) einen Polymerisationsinitiator, geeignet eine Elektronenübertragung oder Energieübertragung mit einem angeregten Zustand des übrigbleibenden entfärbbaren Farbstoffes durchzuführen, um in dem zweiten Schritt die Polymerisation einer polymerisierbaren Verbindung zu initiieren;
    5) eine polymerisierbare Verbindung, und
    6) ein Bindemittel.

4. Hologrammaufzeichnungsmaterial nach Anspruch 3, wobei die polymerisierbare Verbindung und das Bindemittel unterschiedliche Brennungsindizes aufweisen, und durch die Photopolymerisation das Zusammensetzungsverhältnis der polymerisierbaren Verbindung und deren Polymerisationsprodukt zu dem Bindemittel zwischen hellen Interferenzbereichen und dunklen Interferenzbereichen unterschiedlich ist, wodurch das Interferenzband durch Brechungsindexmodulation aufzeichenbar ist.

5. Hologrammaufzeichnungsmaterial nach Anspruch 2, wobei jede Multiplexaufzeichnung immer mit einer konstanten Belichtung bewirkbar ist.

6. Optisches Aufzeichnungsmaterial umfassend ein Hologrammaufzeichnungsmaterial nach Anspruch 2.

7. Optisches Aufzeichnungsmaterial wie in Anspruch 6 definiert, gelagert in einem Licht abschirmbaren Behälter während der Lagerung.

**8.** Dreidimensionales Displayhologramm umfassend ein Hologrammaufzeichnungsmaterial nach Anspruch 2.

**9.** Holographisches optisches Element umfassend ein Hologrammaufzeichnungsmaterial nach Anspruch 2.

## Revendications

**1.** Procédé d'enregistrement d'hologramme utilisant au moins un colorant décolorable présentant une capacité d'absorption molaire de 1 000 ou inférieure à une longueur d'onde de lumière de reproduction d'hologramme, un colorant sensibilisant et un précurseur d'agent décolorant dans lequel, lorsqu'il est soumis à une exposition d'hologramme, au moins un parmi le colorant sensibilisant et le colorant décolorable génère un état excité qui est ensuite soumis à un transfert d'énergie ou d'électrons avec le précurseur d'agent décolorant pour occasionner le fait que le précurseur d'agent décolorant génère un agent décolorant qui décolore le colorant décolorable, formant par là une bande d'interférence due à la modulation de l'indice de réfraction,
**caractérisé en ce que** dans une première étape, le colorant sensibilisant absorbe de la lumière pendant l'exposition d'hologramme pour générer un état excité qui est ensuite soumis à un transfert d'énergie ou à un transfert d'électrons avec le précurseur d'agent décolorant pour occasionner le fait que le précurseur d'agent décolorant génère un agent décolorant qui décolore le colorant décolorable, le colorant décoloré et le colorant décolorable laissé non décoloré forment par là une image latente, et dans une seconde étape, le colorant décolorable laissé non décoloré est irradié avec de la lumière présentant une longueur d'onde différente de celle utilisée pour une exposition d'hologramme pour occasionner un transfert d'énergie ou un transfert d'électrons par lequel un initiateur de polymérisation est activé pour occasionner une polymérisation par laquelle la bande d'interférence est enregistrée comme une modulation de l'indice de réfraction.

**2.** Matériau d'enregistrement d'hologramme pour une utilisation dans le procédé d'enregistrement d'hologramme selon la revendication 1.

**3.** Matériau d'enregistrement d'hologramme selon la revendication 2, lequel comprend :

1) un colorant sensibilisant qui absorbe de la lumière pendant l'exposition d'hologramme dans la première étape pour générer un état excité ;
2) un précurseur d'agent décolorant capable de réaliser un transfert d'électrons ou un transfert d'énergie avec l'état excité du colorant sensibilisant pour générer un agent décolorant ;
3) un colorant décolorable présentant une capacité d'absorption molaire de 1 000 ou inférieure capable d'être soumis à une décoloration par l'agent décolorant ;
4) un initiateur de polymérisation capable de réaliser un transfert d'électrons ou un transfert d'énergie avec un état excité du colorant décolorable restant pour initier la polymérisation d'un composé polymérisable dans la seconde étape ;
5) un composé polymérisable ; et
6) un liant.

**4.** Matériau d'enregistrement d'hologramme selon la revendication 3, dans lequel le composé polymérisable et le liant présentent des indices de réfraction différents et la photopolymérisation rend le rapport de composition du composé polymérisable et de son produit de polymérisation par rapport au liant différent entre des zones d'interférence brillantes et des zones d'interférence sombres, permettant l'enregistrement de la bande d'interférence par la modulation de l'indice de réfraction.

**5.** Matériau d'enregistrement d'hologramme selon la revendication 2, dans lequel tout enregistrement multiplex peut toujours être réalisé à une exposition constante.

**6.** Support d'enregistrement optique comprenant un matériau d'enregistrement d'hologramme selon la revendication 2.

**7.** Support d'enregistrement optique selon la revendication 6 stocké dans une cartouche faisant écran à la lumière pendant le stockage.

**8.** Hologramme d'affichage tridimensionnel comprenant un matériau d'enregistrement d'hologramme selon la revendication 2.

**9.** Elément optique holographique comprenant un matériau d'enregistrement d'hologramme selon la revendication 2.

FIG. 1

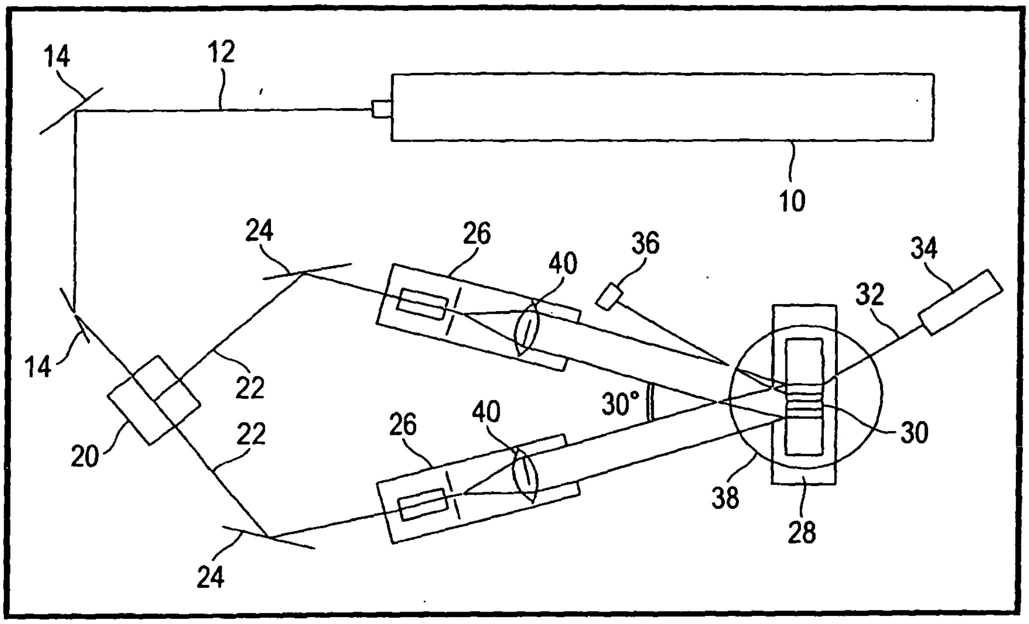

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 6043634 A
- JP 2003082 A
- JP 3050588 A
- WO 9744365 A1
- JP 5107999 A
- JP 8016078 A
- JP 2001523842 T
- JP 11512847 T
- JP 2003300059 A
- JP 59189340 A
- JP 60076503 A
- GB 1388492 A
- JP 53133428 A
- JP 58029803 A
- JP 1287105 A
- JP 3005569 A
- JP 5255347 A
- JP 5213861 A
- JP 62143044 A
- JP 62150242 A
- JP 1054440 A
- EP 109851 A
- EP 126712 A
- JP 61151197 A
- JP 2004238932 A
- JP 2003182849 A
- JP 2003178083 A
- JP 2004238077 A
- JP 2004238392 A
- JP 2000250382 A
- JP 2000172154 A
- JP 2000086914 A
- JP 11344917 A
- JP 3046687 A
- JP 5204288 A
- JP 9506441 T


### Non-patent literature cited in the description


- **Junpei Tsujiuchi.** Holographic Display. Sangyo Tosho
- **Sinya Ogawara.** Shikiso Handobukku. Kodansha, 1986
- **Shinya Ogawara.** Kinosei Shikiso no Kagaku. CMC, 1981
- **Tadasaburo Ikemori.** Tokushu Kino Zairyo. CMC, 1986
- *Macromolecules,* 1977, vol. 10, 1307
- *Journal of Imaging Science,* 1986, vol. 30, 174
- *Organometallics,* 1989, vol. 8, 2, 737
- *Prog. Polym. Sci.,* 1996, vol. 21, 7-8
- **S. Peter Pappas.** UV CURING; SCIENCE AND TECHNOLOGY. A Technology Marketing Publication, 23-76
- **B. Klingert ; M. Riediker ; A. Roloff.** *Comments Inorg. Chem.,* 1988, vol. 7 (3), 109-138